# EUROPEAN PATENT SPECIFICATION

(11) **EP 4 503 900 B1**
(45) Date of publication and mention of the grant of the patent: **19.11.2025**
(21) Application number: 23189891.7
(22) Date of filing: 04.08.2023
(51) Int. Cl.: H10K 85/30, H10K 101/10, H10K 101/30, H10K 101/40, H10K 50/11

(54) **ELECTROLUMINESCENT DEVICE COMPRISING EUROPIUM-ORGANIC COORDINATION COMPOUND AND METHOD FOR PRODUCING THE SAME**
ELEKTROLUMINESZENTE VORRICHTUNG MIT EUROPIUM-ORGANISCHER KOORDINATIONSVERBINDUNG UND HERSTELLUNGSVERFAHREN DAFÜR
DISPOSITIF ÉLECTROLUMINESCENT COMPRENANT UN COMPOSÉ DE COORDINATION ORGANIQUE À L'EUROPIUM ET SON PROCÉDÉ DE PRODUCTION

(43) Date of publication of application: 05.02.2025
(73) Proprietor: beeOLED GmbH, 01217 Dresden (DE)
(72) Inventor: Imbrasas, Paulius, 01097 Dresden (DE); Bärschneider, Toni, 01069 Dresden (DE); Mewes, Jan-Michael, 53129 Bonn (DE); Rothe, Carsten, 01099 Dresden (DE)
(74) Representative: Altmann, Andreas

(56) References cited:
- EP-A1- 4 161 941
- WO-A1-2021/244801
- WO-A1-2022/218562
- CN-A- 113 801 148
- XU TING ET AL: "P-170: Organic Light-Emitting Diodes Incorporating a Novel Exciplex-Forming Host: A Synergistic Strategy to Design Highly Simplified OLEDs for Application", SID SYMPOSIUM DIGEST OF TECHNICAL PAPERS, vol. 48, no. 1, 1 May 2017 (2017-05-01), US, pages 1915 - 1918, XP093117912, ISSN: 0097-966X, Retrieved from the Internet <URL:https://api.wiley.com/onlinelibrary/tdm/v1/articles/10.1002%2Fsdtp.12004> DOI: 10.1002/sdtp.12004

## Description

### Technical Field

The invention concerns an organic electroluminescent device using a metal-organic coordination compound for light emission, with the coordination compound comprising one divalent europium cation coordinated by a macrocyclic organic ligand, as well as a method for forming the electroluminescent device.

### Background

Electroluminescent devices that make use of organic light emitting diodes (OLEDs) are state-of-the-art for flat panel display applications used in everyday consumer electronics. For OLEDs, special organic materials, so-called emitters, are employed for the purpose of converting electrical excitation into light emission. For consumer display applications red, green, and blue emitters are needed. However, the development is most exclusively focused on blue emitter materials. The reason is twofold: First, while existing red and green emitter materials do offer high efficiency combined with saturated colors and good chemical stability, todays blue emitting materials that do offer reasonable chemical stability exhibit poor light generation efficiency. Secondly, advanced consumer display layouts use color conversion to generate the red and green spectral portions from the short wavelength blue emission as this provides certain advantages in manufacturing. Therefore, only blue emitting electroluminescent OLED devices are needed in future display designs. Thus, there is an urgent need for a color-saturated deep blue emitter with high efficiency and with high good chemical stability.

Here, coordination compounds based on the intrametallic transition of divalent Europium offer very promising properties: The ground state configuration features a half-filled 4d-shell (with L=0), resulting in a single narrow Gaussian peak in the emission spectrum. At the same time, the emitting state is the lowest excited state of the materials; no undesired longer-lived states are possible. Moreover, as a heavy metal, Europium readily interconverts singlet and triplet excitons formed upon charge-recombination on organic host materials, such that all excitons can be harvested for light generation with Eu-based emitters, leading to high electroluminescence efficiency. Chemical engineering of the organic ligand allows to tune the emission color through the whole visible spectrum. Especially using electronically hard ligands with N and O as donor atoms, deep-blue and color-pure emission, i.e., with desirable narrow spectral band width and high quantum-yield, can be achieved. All of those features that are ideally-suited for display applications have readily been disclosed in prior art WO2021/244801A1.

Further, the transition responsible for light emission from Eu(II) complexes is preferably intrametallic and thus strongly confined on the Eu atom. Thus, electronically exciting the complex does not weaken any chemical bonds, offering the potential of exceptional chemical stability. Yet, during electroluminescent device operation, hole-trapping on Eu frequently occurs, which corresponds to an oxidation of Eu(II) to Eu(III). Consequently, another mandatory requirement for stable OLED operation is a reversible oxidation/reduction, requiring a stabilization of Eu(II) over Eu(III). This creates a certain challenge, since the most stable oxidation state of Eu is typically the trivalent one. In other words, a stabilization of trivalent europium after it has captured a positive charge must be avoided. This can be accomplished by using rigid coordination environments and chemically soft anions.

Sufficient electronic stabilization may be achieved by using soft cyclopentadienyl type ligands as for example disclosed in Kelly, Rory P., et al. Organometallics 34.23 (2015): 5624-5636. Given their symmetrical, low dipole structure, those materials are even sufficiently volatile for sublimation. However, the original deep blue emission of divalent Europium is shifted into the far-red spectral region, not desirable for display applications.

US 6,492,526 discloses a metal-organic complex comprising divalent Europium and charged pyrazolyl borate ligands. In this case, the desired stabilization of the divalent oxidation state is achieved by application of the strong electron-donating chelating ligand. Yet, such a strong electron-donating ligand leads to red shifted emission compared to the desirable deep blue emission from the free Eu(II) cation. Using the same approach, green electroluminescent devices were exemplified by Guo, Ruoyao, et al. Molecules 27.22 (2022): 8053.

In another related art, a specific strategy to prevent oxidation is used by incorporating soft coordinating ligands, such as sulphur or aromatic aryl or heteroaryl rings into the coordination sphere of the central metal. Thereby, oxidation stability of the central metal may be observed, see Gamage, Nipuni-Dhanesha H., et al. Angewandte Chemie 122.47 (2010): 9107-9109. However, such soft coordinating atoms in an asymmetrical environment typically cause the originally deep blue and spectrally pure emission to red-shift substantially to the green and red spectral region and to broaden, which renders those metal-organic coordination compounds undesirable for use in opto-electronic devices.

Blue emitting Eu(II) complexes with substituted triethylenetetramine ligands were reported by Qi, Zhong et al, J. Mater. Chem. C, 11 (2023): 4136-4142. However, those materials decompose upon attempting to sublime, therefore, only solution processed OLEDs were practiced, which are mostly irrelevant for OLED display mass production and additionally exhibited poor efficiencies only.

Thus, using sufficient electronic stabilization of the divalent Europium causes a significant and undesired red shift of the originally deep blue intrametallic transition.

Alternatively or additionally, geometric stabilization of Eu(II) over Eu(III) may be achieved using cyclic polyethers i.e. macrocyclic and polymacrocyclic ligands, that - depending on exact cavity diameter - may be well-suited to provide the necessary rigid chemical environment. Here, as the ionic radius of Eu(III) is significantly smaller than that of Eu(II), adapting the cavity size of the macrocyclic ligand specifically to Eu(II), stabilizes the divalent over the trivalent oxidation state, see for example the review by Jiang, Jianzhuang, et al. in Coordination chemistry reviews 170.1 (1998): 1-29. Besides aliphatic cyclic polyethers, cyclic ligands incorporating heteroaryl rings are also reported in the art. For instance, synthesis and optical properties of bis(perchlorato)(bis-pyridino-18-crown) europium(II) were disclosed by Christoffers, Starynowicz, Polyhedron 27 (2008): 268. The inclusion of coordinating pyridine rings into the ligand structure led to a significant quenching of the emission, as well as red shifting and broadening the luminescence spectrum.

In most of reported Eu (II) coordination compounds having crown ether ligands, the mandatory charge neutrality is achieved by incorporation of ClO₄, Cl⁻ or Br⁻ counterions. In contrast, there are only few examples reported with iodide being part of the Eu (II) crown ether-based coordination compound. Among them are Eu(II)I₂ coordinated by 18-crown-6 compound, see Merzlyakova, Silke, et al., J. Am. Chem. Soc. 143 (2021): 798; and benzo-18-crown-6, see Poe, Molinari, et. al. Cryst. Growth Des. 22.1 (2022): 842-852. Smaller crowns, particularly, 12-crown-4 and 15-crown-5, where also used to form coordination compounds with Eu(II)I₂, which however, possess a larger than 1:1 Eu:ligand stoichiometry, see Okaue, Tomita, et al., Nippon Kagaku Kaishi. 5 (1993): 439-444. Among hetero-crown ethers, diaza-crown substituted with benzyl groups, i.e., 1,10-dibenzyl-1,10-diaza-18-crown-6, was only utilized to make coordination compound with EuI₂, which emits the blue light, see Poe, Gaiser et al, Cryst. Growth Des. 22.4 (2022): 2670-2678.

In all those cases, the central metal ion has mainly been coordinated to electron rich hard donor atoms, such as oxygen and nitrogen. Consequently, there is little electronic stabilization achieved here. The coordination compounds, albeit still blue emitting, remain air sensitive.

In a related prior art, CN 113 801 148 A discloses Eu (II) complexes with an aza-crown-4 with 1:2 Eu:ligand stoichiometry. Although these complexes exhibit blue luminescence, they are insoluble and do not sublime, which renders them non practical for OLED.

Instead of simple macrocyclic organic ligands, polymacrocyclic ligands may offer a better shielding towards the environment. In a related art, a symmetrical polymacrocyclic aza-ligand has been used to coordinate divalent Europium resulting in a yellow-green (Li, J., Wang, L., Zhao, Z. et al. Highly efficient and air-stable Eu(II)-containing aza-cryptates ready for organic light-emitting diodes. Nat Commun 11, 5218 (2020)) and blue (WO2021/244801 A1) emitting coordination compounds which have been used to demonstrate electroluminescent devices.

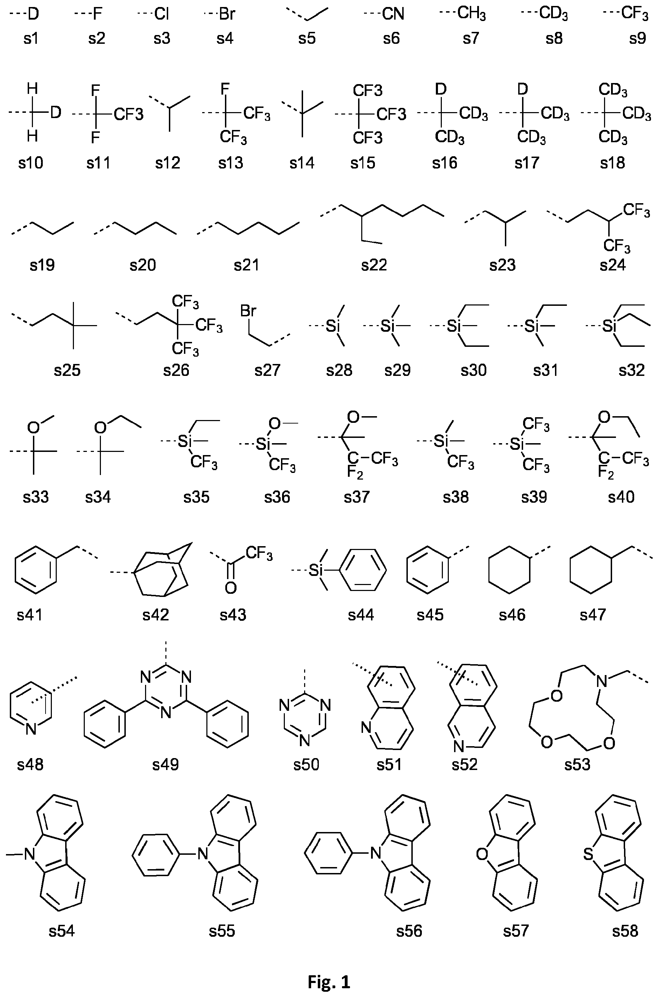

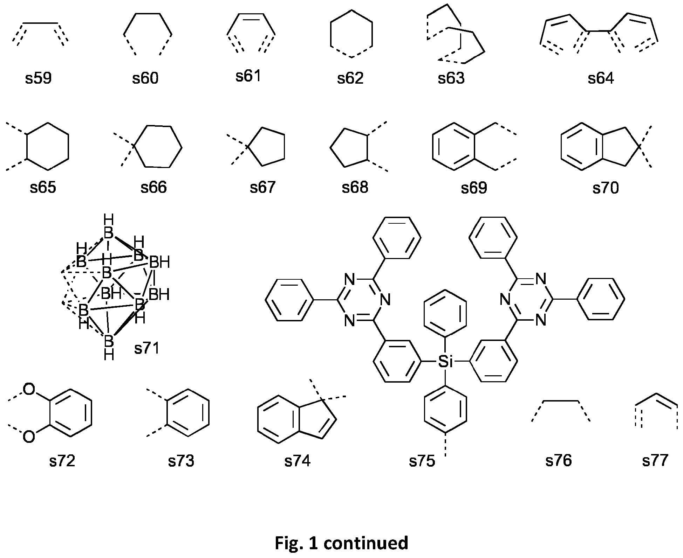

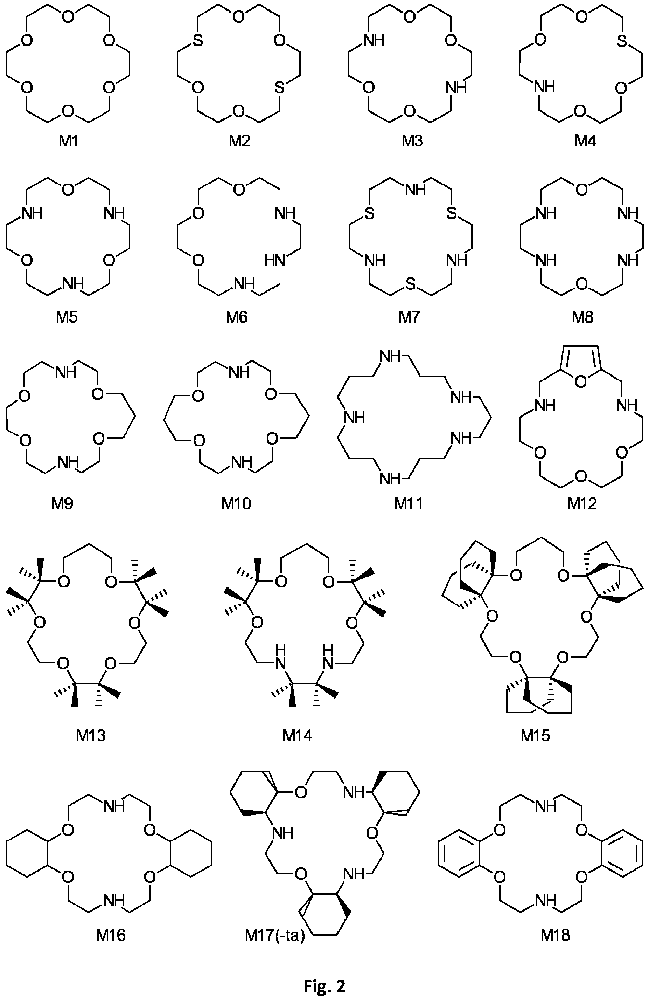

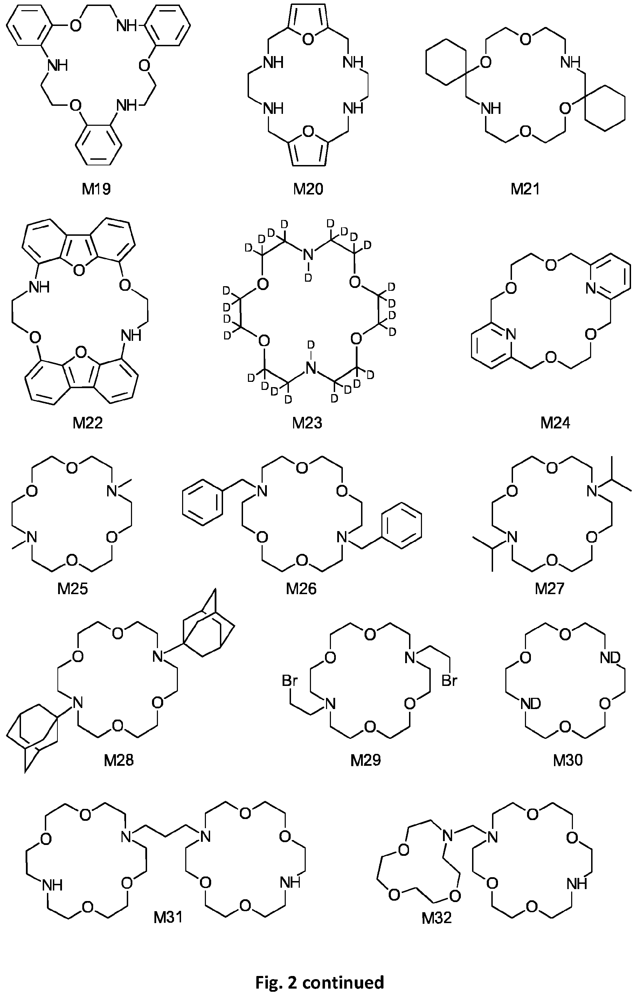

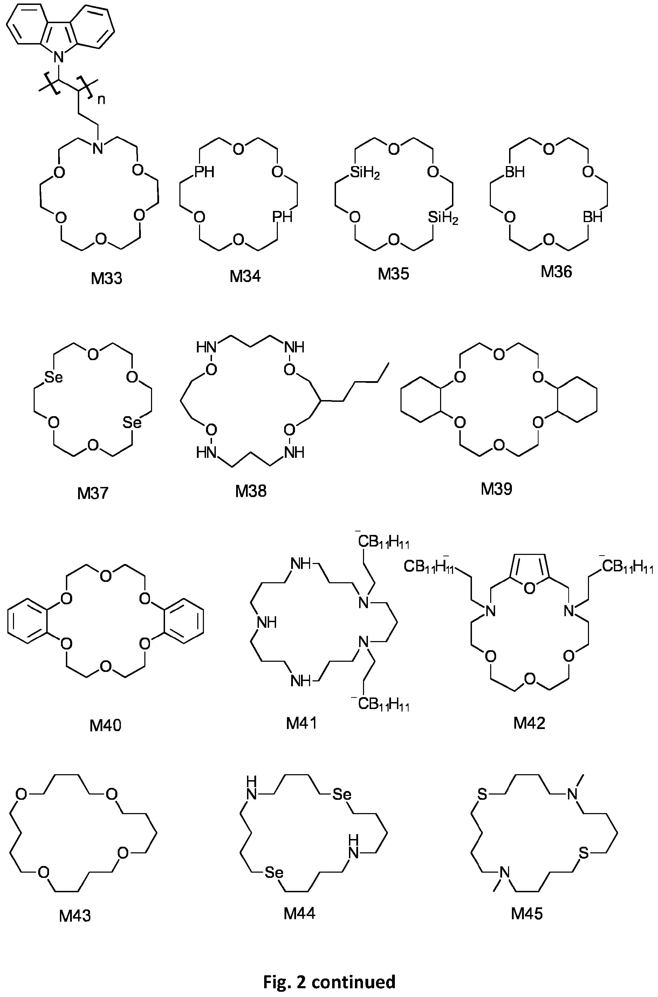

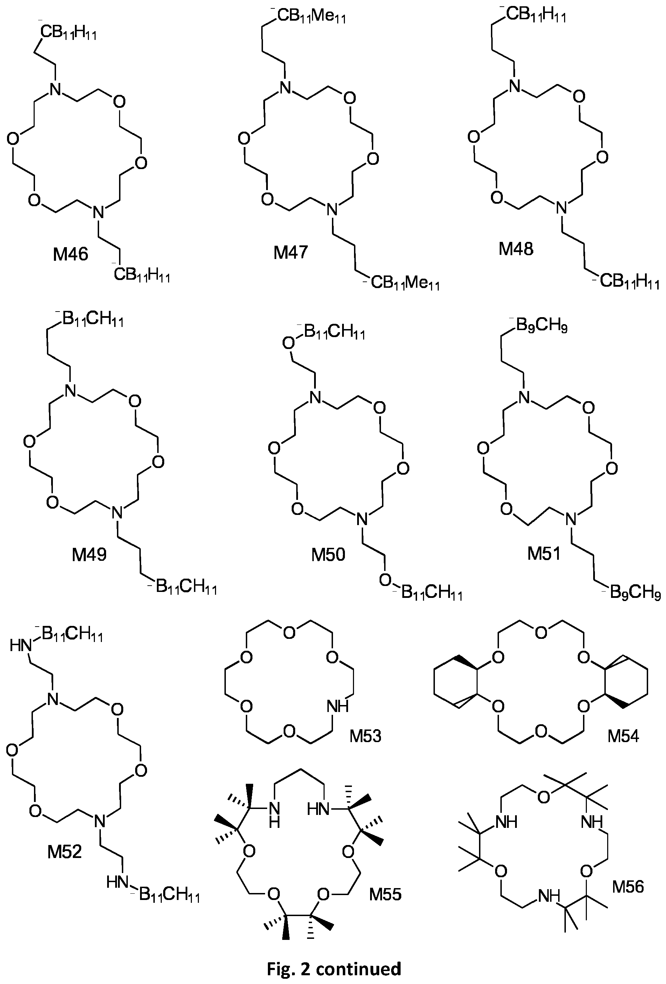

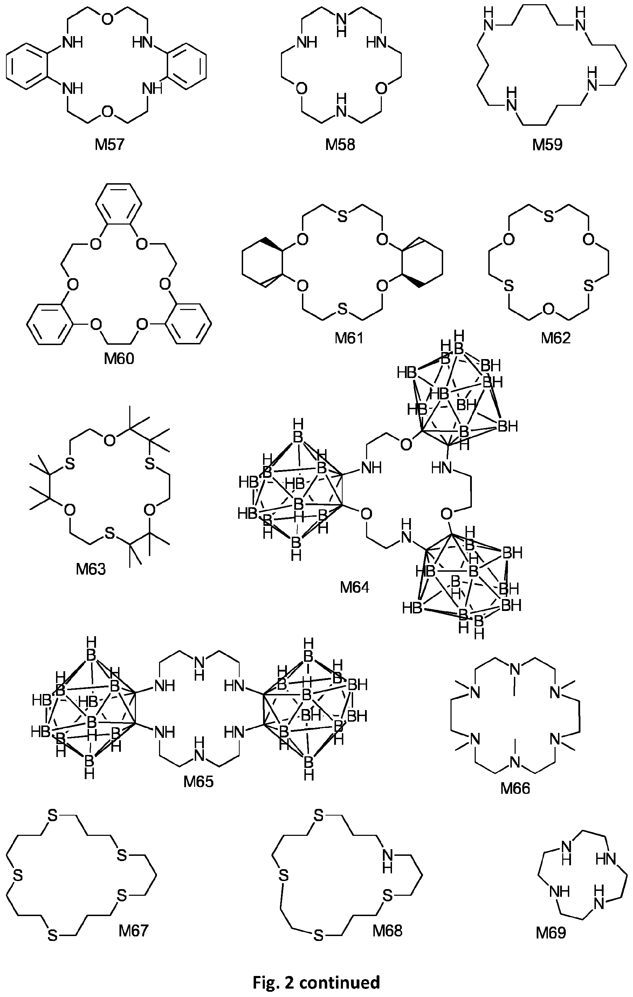

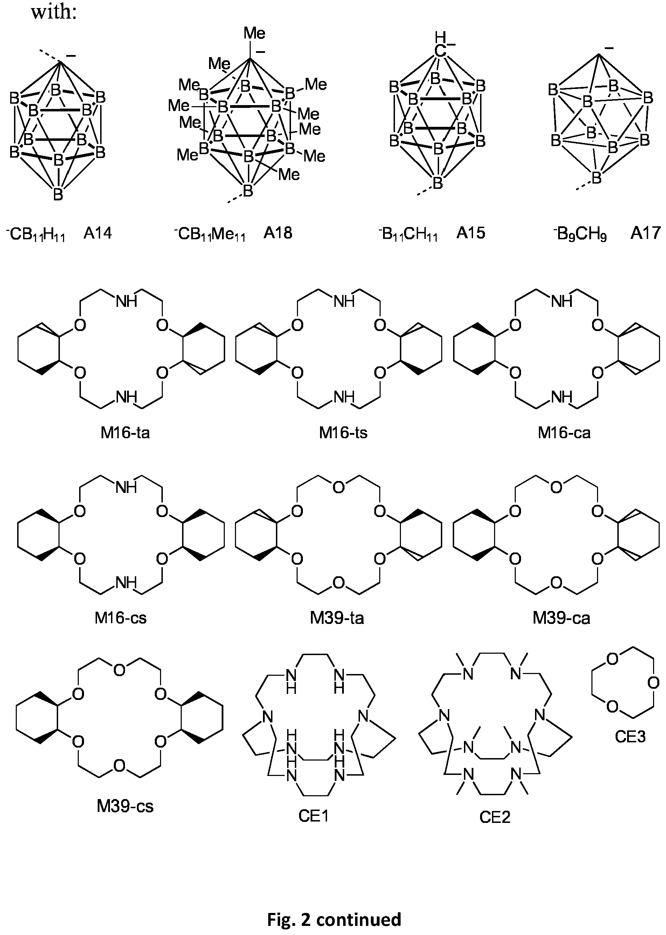

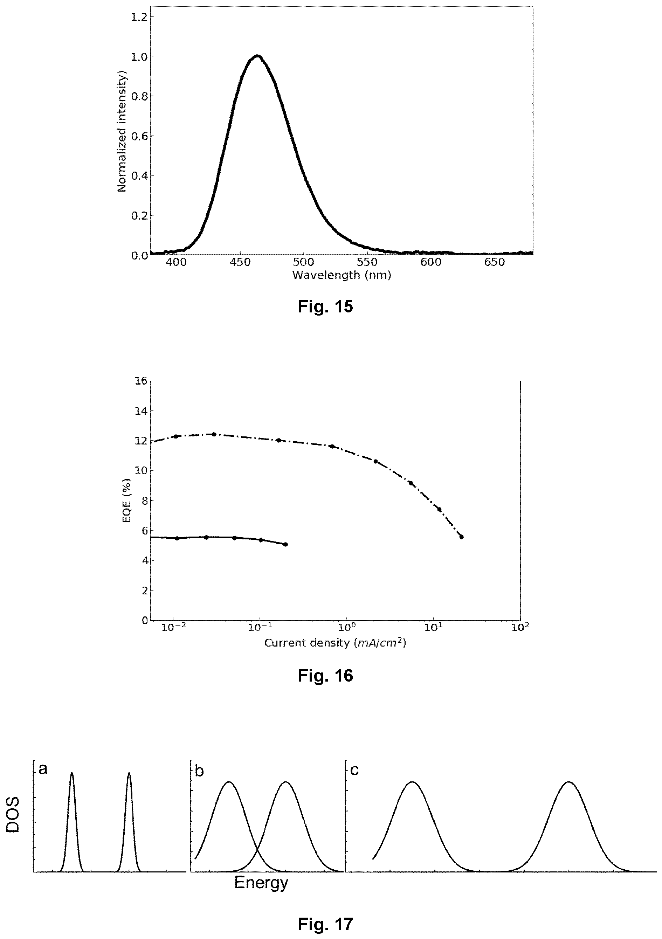

WO 2022/218562 A1 discloses metal-organic coordination compounds in which the (two) counter ions are covalently linked with the macrocyclic ring structure. Monocyclic ligand-based coordination compounds are shown in formula (1-1), formula (3-1), figures 1B, 2A and 2B, where an 18-membered ring is shown as structure 25. Figure 2B showing crown ether structures does not depict any anions. Figure 15 also shows crown ether structures on page 183 of the figures, but again no anions. It is stated that inter alia figure 2 illustrates formulas of coordination compounds to which two monoanionic groups need to be covalently linked to form coordination compounds of the invention.

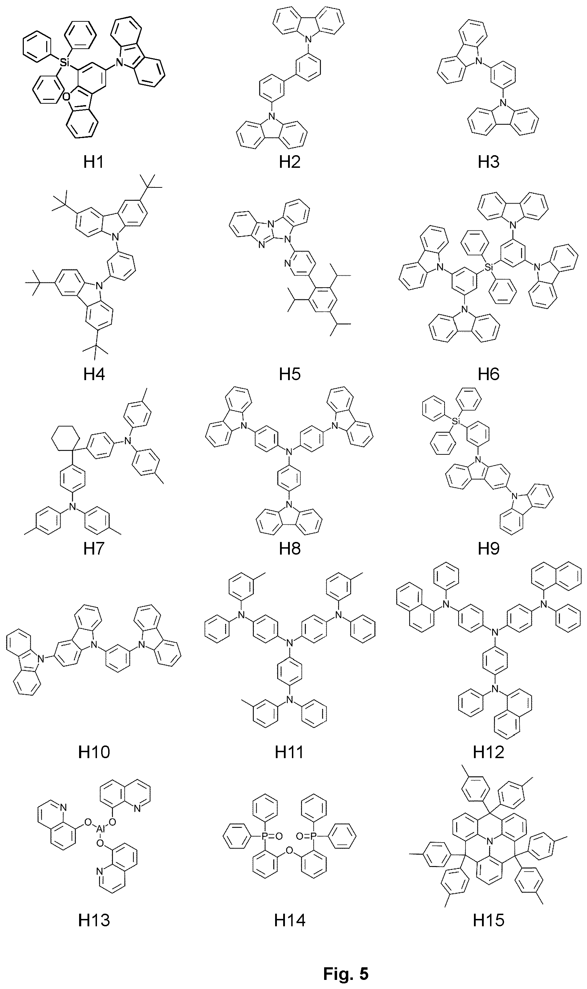

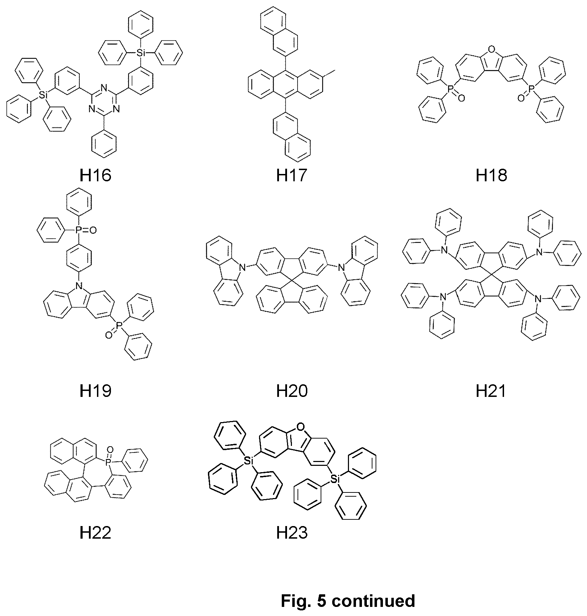

WO 2021/244801 A1 and corresponding EP 4 161 941 A1 disclose metal-organic coordinatior compounds having europium as central metal ion. Monocyclic ligands are shown in figure 1A, figure 1B, figure 2 A and B. Figures 1B and 2B, as well as figure 17 on page 23/24 of the figures again show crown ethers, but without anions. Dodecaborate anions are shown in figures 2K and 5. According to embodiment 5 the coordination compound comprises at least one negatively charged anion, which is not covalently bound to the organic ligand. The examples concern the bicyclic ligands ce3 and c15 as shown in figure 16.

The compounds disclosed in CN 113 801 148 A, because of the small number of ring atoms,form sandwich-like complexes with a less preferable Eu:ligand:anion ratio of 1:2:2. CN 113 801 148 A demonstrates that too small macrocycles which do not encompass the Eu(II) cation leads to a ligand to Eu(II) ration different from 1:1, and, in turn, a much larger dipole moment and lower volatility

Although OLEDs have been demonstrated with Eu(II) emitters based on such symmetric polycyclic ligands, those particular emitters mostly cannot be employed for the mass production of consumer displays. The vast majority of all consumer OLED displays are produced using thermal evaporation or sublimation, which is mostly not possible using the deep-blue-emitting materials based on symmetrical ligand designs disclosed in WO2021/244801A1. In fact, the green-emitting devices disclosed in Li, J., Wang, L., Zhao, Z. et al. Nat Commun 11, 5218 (2020) were processed using thermal sublimation. However, the sublimation yield was only about 10%. Additionally, significant thermal decomposition has been observed during the sublimation process, which renders this material not suitable for OLED mass production using sublimation. WO 2022/218562 A1 discloses, twofold negatively charged polymacrocyclic ligands for Eu(II) for improved thermal vacuum sublimation. The concept is based on the same basic symmetrical cryptand design as Li, J., Wang, L., Zhao, Z. et al. Nat Commun 11, 5218 (2020) and WO 2021244801A1. However, again only green-emitting (and thus electronically stabilized) Eu(II) compounds are practiced and, once more, the sublimation yield is mostly well below 100%.

Thus, as of today, no deep-blue-emitting Eu(II) coordination compound employing a size-discriminating polymacrocyclic ligand that can be processed by thermal evaporation or sublimation with high yield and without significant decomposition is known. The underlying problem is a fundamental one: As long as a pseudo-C3 symmetrical cryptand ligand design is used (consisting of three equally-sized macrocyclic rings) in combination with twofold positively charged Europium, an intrinsically unfavorable chemical structure of the metal-organic complex is obtained in most cases. This is because the asymmetrical arrangement of two anions or anionic groups (which may as well be covalently attached to the ligand) around the C3 symmetric cage typically leads to high dipole moments, resulting in low volatility of the complexes.

The situation with respect to low dipole may be much more favorable, by using macrocyclic organic ligands with 12 to 48 macrocyclic atoms, where the divalent Europium cation can be coordinated in the centre of a single macrocyclic organic ligand. Here, the single macrocyclic coordinating ligand may form an equatorial plane together with the Europium, while the two singly electrically charged anions that are necessary for charge neutrality might arrange on an axis perpendicular through this plane, with the Europium in the centre. Because of symmetry, this arrangement might lead to a very small dipole moment for the overall complex, thereby significantly improving its volatility.

Yet, those comparably simple coordination compounds, i.e based on a divalent Europium coordinated by a single macrocyclic organic ligand, have not been used to practice electroluminescent devices. Either macrocyclic organic ligands with too small diameter have been attempted to use for OLED manufacturing, which do form undesired complexes off 1:2 molar ratio of metal to ligand and are not volatile (see CN 113801 148 A), or many complexes with 1:1 molar ratio of metal to organic ligand have been done but their high volatility and suitability for sublimation processing has been overlooked. Today, no electroluminescent device employing a divalent Europium coordinated by macrocyclic ligand has been practiced.

In OLEDs, emitter molecules are usually embedded into charge transport matrices, called hosts. Here, the yellow-green-emitting material based on symmetrical ligand design and disclosed in [Li, J., Wang, L., Zhao, Z. et al. Nat Commun 11, 5218 (2020)] only showed bright emission in a surprisingly small selection of host materials. In most of the disclosed materials, the emission was fully or partially quenched. Qualitatively, this observation is consistent with our own findings regarding highly volatile divalent Europium complexes using macrocyclic organic ligands: While mostly highly luminescent in solution, the emission of the complexes is significantly quenched in the vast majority of solid host materials. Only after screening a wide range of emitter - host combinations we uncovered a peculiar set of conditions that helps to maintain the excellent photophysical properties of divalent Europium emitters in solid mixtures.

It is an objective of this invention to provide electroluminescent devices based on emitting metal-organic Eu(II) complexes comprising macrocyclic organic ligands that are sufficiently chemically stable and emit deep blue light with high efficiency after both, optical and electrical, excitation. It is a further objective to elucidate on how to combine charge transporting host materials with the coordination compounds intended for use in OLED such as to maintain the high emission quantum efficiency of the coordination compound in the mixed layer. Furthermore, the electroluminescent devices shall in particular be (highly efficient) multilayer OLED devices that are manufactured by means of gas transfer processes such as by sublimation or evaporation or carrier gas processes. It is thus a general objective of this invention to enable the excellent photophysical properties of divalent Europium metal organic complexes for mass production of consumer electronics, especially consumer (OLED) displays and especially using sublimation or evaporation techniques.

The objective is achieved according to the present invention by an organic electroluminescent device comprising:
a first electrode (104),
a second electrode (108), and
an organic layer (106) disposed between the first electrode (104) and the second electrode (108), the organic layer (106) comprising at least one charge-neutral metal-organic coordination compound (a) comprising a divalent Europium coordinated by a macrocyclic organic ligand,
wherein the macrocyclic organic ligand is formed of 12 to 48, preferably 15 to 24, and most preferably 18 to 20 macrocyclic ring atoms which are part of a single cyclic ring, the macrocycle, wherein only those carbon or heteroatoms are counted as macrocyclic atoms that do form the cyclic closed ring system around the Eu(II),
wherein the organic layer (106) comprises a second organic compound (b) that is a charge-neutral host material, wherein the triplet energy of the second charge-neutral organic compound (b) is higher than the emission energy of the coordination compound (a),
wherein the second charge-neutral organic compound (b) has an electron affinity that is lower than the electron binding energy of the coordination compound (a) in its lowest electronically excited state,
wherein emission energies of the neutral coordination compound (a) are calculated by optimizing the lowest electronically excited state of the lowest conformer from 2D with time-dependent DFT/ωB97X-D3 in the Tamm-Dancoff approximation using the def2-TZVP basis set and def2-ECPs 28-electron pseudopotential for Eu, the def2-SVP basis set, and if necessary def2-ECPs, for all other atoms, the geometrical Counter Poise correction for basis set incompleteness error, and the SMD solvation model with parameters for anisole,
wherein electron binding energies of the neutral coordination compound are calculated as the difference between the electronic energy of the fully relaxed complex with ground-state Eu(II) and the energy of the fully relaxed complex with Eu(III) which is singly positively charged with time-dependent DFT/ωB97X-D3 in the Tamm-Dancoff approximation using the def2-TZVP basis set and def2-ECPs 28-electron pseudopotential for Eu, the def2-SVP basis set, and if necessary def2-ECPs, for all other atoms, the geometrical Counter Poise correction for basis set incompleteness error, and the SMD solvation model with parameters for anisole,
wherein electron binding energy of Eu(II) in the neutral coordination compound (a) in the lowest electronically excited state is calculated as the electronic energy difference between the geometry-optimized complex with Eu(II) in its first excited state and the corresponding geometry-optimized complex with Eu(III) which is singly positively charged with time-dependent DFT/ωB97X-D3 in the Tamm-Dancoff approximation using the def2-TZVP basis set and def2-ECPs 28-electron pseudopotential for Eu, the def2-SVP basis set, and if necessary def2-ECPs, for all other atoms, the geometrical Counter Poise correction for basis set incompleteness error, and the SMD solvation model with parameters for anisole, and wherein HOMO and LUMO energies correspond to electron binding energy and electron affinity, respectively,
wherein the triplet energy of the second charge-neutral organic compound (b) is probed by suitable quantum mechanical calculations or by detecting the onset of the phosphorescence spectrum using gated spectroscopy, or is taken from the websites of material vendors or from the scientific literature by searching for the material using its name or synonym,
and wherein HOMO and LUMO of the second charge-neutral organic compound (b) are taken from the websites of material vendors or from the scientific literature by searching for the material using its name or synonym.

The organic layer comprises a second organic compound (b) that is a charge-neutral host material, wherein the triplet energy of the second charge-neutral organic compound (b) is higher than the emission energy of the coordination compound (a), preferably wherein the second organic compound (b) has a triplet energy higher than 2.6 eV, more preferably higher than 2.7 eV, and most preferably higher than 2.8 eV, wherein preferably the second charge-neutral organic compound (b) has an electron affinity that is lower than the electron binding energy of the coordination compound (a) in its lowest electronically excited state, preferably
the second organic compound having an electron affinity higher than 2.3 eV, more preferably higher than 2.5 eV, and most preferably higher than 2.7 eV.

In various embodiments, the second organic material (b) may serve as charge transporting host to enable electrical excitation of the coordination compound (a) present in the mixture according to the invention. To achieve this desired functionality without severely compromising the triplet energy level, the second charge-neutral compound in preferred embodiments comprises (hetero)arene fragments derived from benzene, pyridine, pyrrole, furan, carbazole, dibenzofuran, triazine, triazole, or benzofuran by removing one or two hydrogen atoms.

In various alternative embodiments the second charge-neutral compound (b) has a molecular weight Mₙ above 1000 g/mol, and the coordination compound (a) and the second charge-neutral compound (b) are chemically linked with each other, for example by a covalent or coordinative chemical bond. Here the mixture is a polymeric compound, which might have benefits in terms of very high glass transition temperatures, or it may ease the processing of the mixtures using wet solution techniques.

The electroluminescent device preferably comprises additionally a third charge-neutral organic material (c), wherein the third charge-neutral organic material (c) is in physical contact with the organic layer comprising coordination compound (a) and second organic compound (b), with the energy difference between the HOMO of the second charge-neutral organic compound (b), and the LUMO of the third charge-neutral compound (c), and/or the energy difference between the HOMO of the third charge-neutral organic compound (c) and the LUMO of the second charge-neutral compound (b) are higher compared to the emission energy of the coordination compound (a) in its lowest electronically excited state, preferably wherein said energy difference is higher than 2.6 eV, more preferably higher than 2.7 eV, and most preferably higher than 2.8 eV, wherein preferably the third charge-neutral organic material (c) is a hole transporting material, while the second charge-neutral organic material (b) is either ambipolar or electron transporting.

The second charge-neutral organic compound (b) has a higher electron-binding-energy than the charge-neutral metal-organic coordination compound (a), preferably wherein the second charge-neutral organic compound (b) has an electron binding energy higher than 4.5 eV, more preferably higher than 5.1 eV, and most preferably higher than 5.7 eV.

The coordination compound (a) is, preferably substantially homogeneously, imbedded into the at least one second charge-neutral organic compound (b) at 0.1 - 99.0 vol%, preferably at 1 - 90 vol%, and most preferably at 3 - 30 vol%, based on the organic layer which is 100 vol%.

The volume ratio of the coordination compound (a) to the at least one second charge-neutral organic compound (b) is, preferably substantially, non-uniform throughout the organic layer, preferably non-uniform along an axis perpendicular to the layer plane, thereby preferably forming two or more sublayers within the organic layer, one sublayer being primarily or totally composed of the coordination compound (a) and one sublayer being primarily or totally composed of the second charge-neutral organic compound (b), preferably wherein the partial layer thickness of the one or more sublayers comprising, preferably substantially, the metal organic coordination compound is 0.1 - 99.0 %, more preferably 1 - 90 %, and most preferably 3 - 30 %, based on the overall thickness of the organic layer, which is 100%.

The coordination compound (a) preferably comprises at least one negatively charged anion that is not covalently linked to the macrocyclic organic ligand, and/or wherein the macrocyclic organic ligand, excluding the Europium cation, is at least singly, preferably twofold, negatively charged.

The at least one negatively charged anion is preferably selected from a1 to a4 and/or wherein the ligand contains at least one, preferably two, covalently attached closocarborane fragments according to one of formulae (a5) to (a9) wherein
- the dashed line indicates the covalent linkage to the remainder of the organic macrocyclic ligand, and
- **R_{b}** present in a2 to a9 independently in each occurrence represents either hydrogen, deuterium, halogene, preferably chlorine, or an alkyl chain, preferably C₁₋₃- alkyl, more preferably methyl.

The second charge-neutral compound (b) and/or third charge-neutral compound (c) preferably comprises heteroarene fragments selected from benzene, pyridine, pyrrole, furan, carbazole, indolocarbazole, dibenzofuran, triazine, triazole, or benzofuran in its chemical structure.

The second charge-neutral compound (b) and/or third charge-neutral compound (c) preferably is a host material capable of transporting electrons, holes or electrons and holes.

The macrocyclic organic ligand has the formula (1-1) with
- **n** being 4 to 8, preferably 4 to 6; and
- **L** being independently in each occurrence a divalent organic group formed by removing two hydrogen atoms from an organic molecule having at least two hydrogens, with
- the shortest sequence of atoms in each L, linking each L with the remainder of the macrocyclic ligand, being 3 to 5, preferably 3 atoms, and with
- one of those 3 to 5, preferably 3 atoms independently for each L being selected from N, P, S, Se, or O, preferably N, S, Se, or O.
   **L** preferably is independently in each occurrence selected from one of structures (2-1) to (2-5) with
- **R** and **Rₙ** being H, D, or any monovalent organic group formed by removing a hydrogen atom from an organic molecule having at least one hydrogen, and
- **k** is independently in each occurrence 1 or 2 or 3, and
- two to four instances of **R** present on neighboring carbon atoms or carbon atoms separated by a heteroatom independently in each occurrence may fuse, and
- the dashed lines indicating the covalent linkage to the remainder of the macrocyclic ligand according to formula (1-1).

The macrocyclic organic ligand preferably is one of generic formulae (3-1) to (3-3) with
- **X** being selected from N-Rₙ, P, S, Se, or O, preferably N-Rₙ, S, Se, or O
- **R** and **Rₙ** being H, D, halogen (preferably Cl, Br, I), or any monovalent organic group formed by removing a hydrogen atom from an organic molecule having at least one hydrogen, being identical or different in each occurrence, and
- two or more instances of **R** present on neighboring carbon atoms and/or carbon atoms separated by one instance of **X** independently in each occurrence may fuse.

The objective is furthermore achieved by a method for producing the electroluminescent device, wherein the organic layer (106) or at least one of compounds (a), (b) and material (c) is deposited from a gas phase, preferably using an evaporation and/or sublimation and/or carrier gas process, or is deposited by deposition from solution, and the organic layer (106) or at least one of compounds (a), (b) and material (c) is deposited between the first electrode (104) and the second electrode (108).

In particular, it was found that in the prior art coordination compounds, the cavity size of the tested macrocyclic organic ligands did not match well to the central cation, as it was often far too small, with the divalent Europium being substantially outside the cavity of a single macrocyclic ligand, thereby forming complexes of 1:2 or higher molar stoichiometry between metal and organic ligand. According to the present invention, the divalent Europium is centred inside the macrocyclic ligand. Many anions such as perchlorate, chloride, bromide, cyclopentadienyls, or borates have been investigated in the prior art. Most of them are indeed able to form complexes of low dipole moment and high mobility. Yet often they form chemically rather instable compounds, i.e. they cause Eu(II) to easily oxidize, or they lead to a red-shift of the emission of the complex in an OLED. It is an objective of this invention to elucidate anions that lead to particularly oxidation stable coordination compounds based on divalent Europium that are still emitting in the deep blue spectral region. This objective is generally achieved by complexes of a divalent Europium and macrocyclic organic ligands and two anions having a molar ratio of 1:1:2, whereby the anions are preferably selected from iodide or a range of borane cluster anions. Other anions may as well give very high volatility, yet those particular ones do maintain the transition energy, i.e., the emission of the coordination compound is still deep blue as desired for consumer display applications. At the same time, by using macrocyclic organic ligands with 12 to 48 macrocyclic atoms, in combination with iodide or closoborane type cluster anions, coordination compounds of very high volatility, suitable for sublimation or evaporation are obtained. Here, the single macrocyclic coordinating ligand may form an equatorial plane together with the Europium, while the two iodide anions are arranged on an axis perpendicular through this plane, with the Europium in the centre. Thus, the anions are integrated in a way that they simultaneously stabilize the central divalent Europium and, because of symmetry, lead to a small dipole moment for the overall complex, thereby significantly improving its volatility. Additionally, those particular iodide or closoborane type cluster anions, and in contrast to smaller anions such as smaller than iodide halogenides, have a sufficiently large size to prevent undesirable penetration of the anions into the inner sphere of the complex (as smaller chlorides and bromides do), which in turn, promotes decomposition of the complexes upon sublimation. Furthermore, we clearly demonstrate that the f and d energy levels, and thus the oxidation stability of the divalent Europium, is greatly lowered by using in particular iodide and closoborane cluster anions.

Furthermore, the invention features strict rules on how to choose the charge-transporting host materials such that the favorable emission characteristics of the divalent Europium complex are maintained. In this context, we surprisingly found that the organic host material must have a higher electron binding energy (approximately corresponding to the absolute value of the energy of highest occupied molecular orbital [HOMO] of the organic material) than the Europium coordination compound. Divalent Europium in the metal-organic complex cannot trap an electron as this is energetically extremely unfavorable. Instead, in electroluminescent device configuration the mandatory first step in the light generation process is to capture a hole, which corresponds to oxidizing the Eu(II) in the complex to Eu(III). Thus, the higher electron binding energy of the organic host material relative to the divalent neutral Europium compound (charge neutral metal-organic coordination compound) ensures that the hole is confined to the emitter molecule.

Thus, in a unique combination, highly chemically stable, and deep blue emitting divalent Europium coordination compounds and combinations with charge transporting host matrixes that maintain the excellent photophysical properties of the active coordination compounds are obtained. The individual components of the objective, i.e., the coordination compound as well as many organic host materials are sufficiently volatile and as such ideally suited for processing using sublimation or evaporation techniques, as used in the mass production of consumer displays today. The combination of the above-mentioned properties enables the straightforward design of very efficient deep-blue-emitting OLED devices with high operational stability. With this combination of ideal emission characteristics, good processing characteristics, and freedom of OLED design the mixtures according to the invention are ideally suited as active emitting materials in electroluminescent (consumer) electronics applications.

### Summary of the invention

In various aspects of this invention organic electroluminescent device using a metal-organic coordination compound for light emission, with the coordination compound comprising one divalent europium cation coordinated by a macrocyclic organic ligand, as well as methods for forming the coordination compound as well as the electroluminescent device are provided.

The objective is achieved by an electroluminescent device using an divalent Europium metal-organic coordination compound whereby the organic ligand of the coordination compound is formed of 12 to 48 macrocyclic atoms as described above and defined in claim 1. To make use of the potentially excellent emission properties of divalent Europium the luminescent active cation must be sufficiently chemically stabilized to avoid undesired irreversible oxidation of divalent to trivalent Europium. The key ingredient here is the macrocyclic ligand with 12 to 48 ring atoms, which allows the divalent Europium cation to take a central position within its coordinating ligand. The size and diameter of the macrocyclic ligand is well adapted to coordinate to Eu(II) but less suitable to coordinate to the smaller Eu(III). By this size discrimination the organic ligand provides a geometrical stabilization of the divalent over the trivalent oxidation stage of the central metal, thus leading to a high chemical stability of the complex. In this context, the perfect ring diameter to stabilize divalent Europium depends on the exact nature of the ring atoms (for example substituting a carbon atom with a silicon will generally increase the diameter) and as well by how stiff the ring is practiced for example by bulky side groups or fused substituents of macrocyclic atoms. Nevertheless, preference is given to organic ligands containing 15 to 24, and most preferably 18 to 20 macrocyclic (ring) atoms.

The active light emitting compound in electroluminescent devices is hardly ever isolated, but instead embedded into charge neutral host materials capable of transporting charges. Instead of such a bulk emitting device, in some embodiments, the device may be configured more like an interface device, in which case the charge transport matrixes may be present in adjacent layers with respect to the layer comprising the emitting coordination compound. In both cases, it is desirable that the excitation energy is confined on the emitting molecule as opposed to be located on the nearby matrix materials. Given that the lowest excited energy state of the vast majority of organic materials employed for charge transporting in OLED is the first excited triplet state, the triplet energy of the charge-neutral organic host material is higher than the emission energy of the emitting coordination compound. Most desirable are deep blue electroluminescent devices, based on the excellent saturated deep blue emission characteristics of many divalent Europium coordination compounds with macrocyclic ligands. Therefore, preferably the triplet energy of the surrounding host materials is higher than 2.6 eV, more preferably higher than 2.7 eV, and most preferably higher than 2.8 eV.

Besides energy confinement, electron confinement of the excited emitter is desirable too.

Undesired are energetic embodiments, where the emitter forms the charge transfer state with the surrounding host material by transferring an electron from the ⁵d orbital as this would most certainly lower the light generation efficiency. Therefore, the electroluminescent device is designed using charge transport materials that have a lower electron affinity than the electron binding energy of the coordination compound in its lowest electronically excited state. In less scientific language: the LUMO energy of the host has to be higher than the energy of the single occupied ⁵d orbital of the divalent Europium. While this relative order can be achieved at many absolute energy positions, generally preference is given to deeper energy levels, which for a given band gap (or emission energy), provides lower HOMO energies too, which correlated to higher ambient stability of the emitting compound. Therefore, preference is given to organic host materials having an electron affinity higher than 2.3 eV, more preferably higher than 2.5 eV, and most preferably higher than 2.7 eV.

As described above, if a charge neutral host material is in physical contact with the emitting coordination compound, it is desirable that the excitation energy is confined on the emitting molecules. Said charge neutral host material may be configured as a charge transport material capable of transporting either holes or electrons. In state-of-the-art electroluminescent devices, the function of transporting holes and electrons is often separated by using two different host materials, whereby the holes are transported on the host with the highest energy HOMO and the electrons on the other host configured to have a lowest energy LUMO. This highest energy HOMO and lowest energy LUMO, in combination, form an exciplex system with an absorption energy given by the offset between said HOMO and LUMO. In such a situation, it is still desirable that the excitation energy is confined on the emitting molecule instead of being transferred to either of the two hosts, or to the exciplex state formed between the two hosts. Therefore, it is desirable that said energy offset is higher compared to the energy of the coordination compound in its first excited state. And again, as it is most desirable that the divalent coordination compound emits in the deep blue spectral region it is thus preferable that said HOMO LUMO energy gap between the two host materials is higher than 2.6 eV, more preferably higher than 2.7 eV, and most preferably higher than 2.8 eV. With such two host materials with different energy levels present in or adjacent to the emitting molecules, it is desirable to config one of the hosts as predominantly hole- and the other as predominantly electron transporting material. To allow for efficient charge transport, the hosts present in the near vicinity of the coordination compound preferably comprises heteroarene fragments selected from benzene, pyridine, pyrrole, furan, carbazole, indolocarbazole, dibenzofuran, triazine, triazole, or benzofuran.

In the above, preferred energetic situations to confine the electron and the energy AFTER the excitation has been formed on the coordination compound are given. Generally, the coordination compound may be excited by energy transfer. Yet, in a preferred pathway, the coordination compound is first oxidized and subsequently captures an electron. To achieve this oxidation (into Eu(III)) or hole trapping efficiently, it is required that surrounding host material(s) have a higher electron-binding-energy than the charge-neutral metal-organic coordination compound. In less correct words: the HOMO of the hosts is preferably deeper compared to the energy of the ⁴f half full orbital of Eu(II). Once more, deeper energy levels generally correlate with higher ambient and chemical stability. Therefore, the absolute electron binding energy of the surrounding host materials is preferably higher than 4.5 eV, more preferably higher than 5.1 eV, and most preferably higher than 5.7 eV.

To achieve hole trapping with high efficiency, the coordination compound may be substantially homogeneously imbedded into the one or more host materials at 0.1 - 99.0 vol%, preferably at 1 - 90 vol%, and most preferably at 3 - 30 vol%, based on the mixture which is 100 vol%.

Alternatively, the charge trapping, i.e. the oxidation of the coordination compound may as well take place on an interface between a layer that is mostly configured to transport charges and a second layer mostly intended to emit light and that contains the coordination compound. In this case, an organic layer sequence with substantially non-uniform concentration profile of the coordination compound perpendicular throughout the organic layer stack may be preferable. The regions with different emitter concentrations may be considered as individual sublayers, wherein the partial layer thickness of the one or more sublayers comprising substantially the metal organic coordination compound is 0.1 - 99.0 %, preferably 1 - 90 %, and most preferably 3 - 30 %, based on an overall thickness of the organic layer, which is 100%. The sublayers themselves may also be configured to substantially containing only a particular host material or only the coordination compound.

The coordination compounds used in the electroluminescent devices according to invention and based on divalent Europium must contain two further negative charges for charge neutrality. In one embodiment, the macrocyclic organic ligand itself is charge neutral and one or two negatively charged anions are part of the final coordination compound. In this situation preferred are anions generated from formulae a1 to a4:

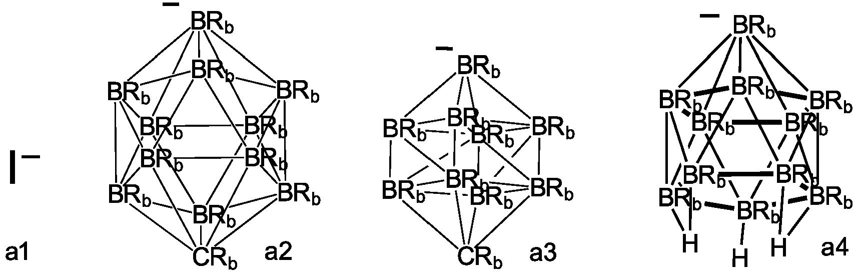

In another embodiment, the necessary negative charges are part of the coordinating macrocyclic ligand itself, for example by covalently linking one or two anionic groups. In this situation preferred are anions selected from anions constructed using the generic formulae a5 to a9 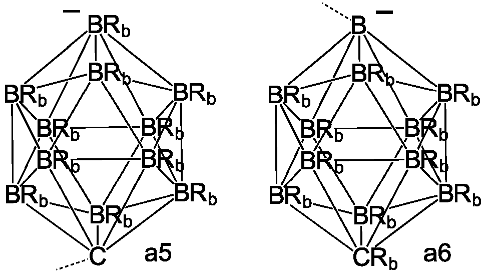 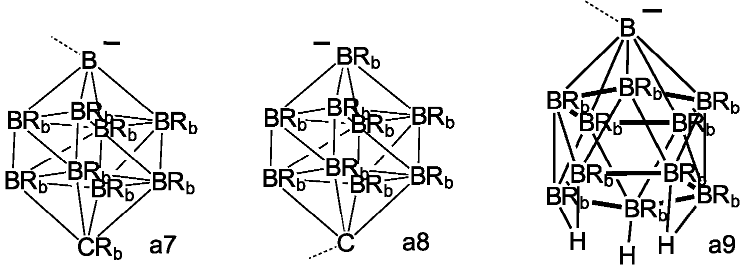 wherein the dashed lines indicate the covalent linkage to the remainder of the organic macrocyclic ligand, and **R_{b}** present in a2 to a9 independently in each occurrence represents either hydrogen, deuterium, halogene - preferably chlorine, or an alkyl chain - preferably C1-3- alkyl, more preferably methyl. While many anions present in coordination compounds with divalent Europium and macrocyclic ligands may give deep blue emitting materials - often with high volatility suitable for evaporation - we surprisingly found that those specific anions and anionic groups depicted in a1-a9 do significantly improve the oxidation stability of the coordination compound. Thus, the typically rather air sensitive divalent Europium compounds become highly ambient stable as such easing their application in OLED display mass production. Here, the desired high ambient stability is maintained whether the anion is covalently attached as in a5-a9 or not as in a1 to a4.

The macrocyclic ligand itself may preferably be chosen according to the generic formula (1-1): 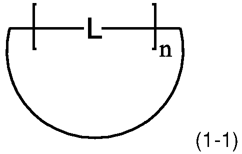 with **n** being 5-8, preferably 4-6; and **L** being independently in each occurrence a divalent organic group formed by removing two hydrogen atoms from an organic molecule having at least two hydrogens, and with the shortest sequence of atoms linking each L with the remainder of the macrocyclic ligand being 2 to 4, preferably 3 atoms, and with one of those 2 to 4, preferably 3 atoms independently for each L being selected from N, P, S, Se, or O, preferably N, S, Se, or O. Here, the macrocyclic organic ligand is constituted of n subunits, each containing at least one heteroatom. The heteroatoms ensure good coordination of Eu(II) by the macrocyclic organic ligand and are preferably selected from N, O, S, and Se. In addition to the coordinating heteroatom(s), one to three carbon atoms are present in the shortest sequence of atoms linking each subunit **L** to the remainder of the macrocycle, which helps to form chemically stable configurations. Preference is given to structures where the heteroatoms are non adjacent, more preferably where they are separated from each other by three, four, or five more preferably by three carbon atoms, i.e., for subunits each containing two carbon atoms and one heteroatom. Further, the number of coordination heteroatoms as part of the macrocycle in the organic macrocyclic ligand is 4-8, preferably 4-6. Considering 6 heteroatoms in combination with two additional carbon atoms for every heteroatom and arranged symmetrically around each heteroatom, one arrives at the chemically very robust and widely known 18-crown-6 motive, where 18 describes the number of macrocyclic atoms in the cyclic ligand and 6 denotes the number of heteroatoms thereof, typically O, known as crown ether. Such macrocyclic organic ligands perfectly stabilize the central divalent Europium over trivalent Europium if combined with the anions according to formulae (a-1) to (a-9) above.

Starting with formula (1-1) preferred are molecular fragments **L** where the one heteroatom is in a non-terminal position. With this consideration in mind, preferred instances of L are selected independently in each occurrence from formula (2-1) to (2-5): 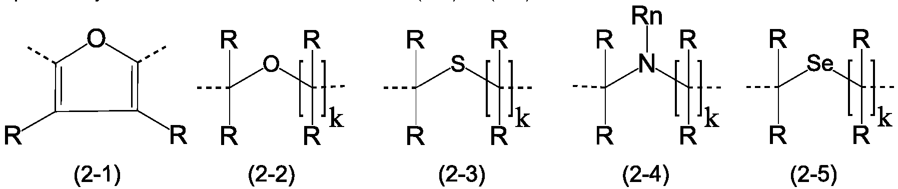 with **R** and **Rₙ** being H, D, or any monovalent organic group formed by removing a hydrogen atom from an organic molecule having at least one hydrogen, and **k** is independently in each occurrence 1 or 2 or 3, and two to four instances of R present on neighboring carbon atoms or carbon atoms separated by the heteroatom depicted in (2-2) to (2-5) independently in each occurrence may fuse, and the dashed lines indicating the covalent linkage to the remainder of the macrocyclic ligand according to formula (1-1). Those subunits (2-1) to (2-5) are chemically robust, well-coordinating, and each individually having a high triplet energy. Again, this selection shall ensure that the energy as well as the electron in the excited state of Eu(II) located in the ⁵d orbital is mostly confined on the central metal, thereby avoiding undesired charge transfer states or Dexter energy transfer. Highly stable coordination compounds with high photoluminescence quantum efficiencies thus result by constructing the macrocyclic organic ligand from the above given coordinating fragments.

Further preferred are rotation- or mirror symmetric organic ligands such as derived from the generic structures (3-1) to (3-3): 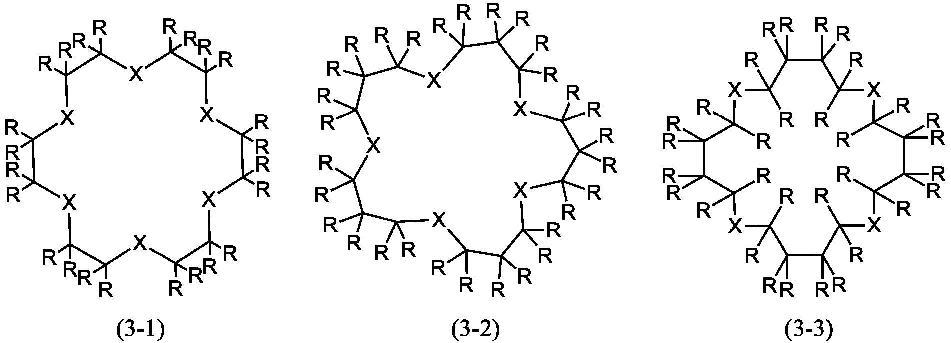 with **X** being selected from N-Rₙ, P, S, Se, or O, preferably N-Rₙ, S, Se, or O and with **R** and Rₙ being H, D, or any monovalent organic group formed by removing a hydrogen atom from an organic molecule having at least one hydrogen, being identical or different in each occurrence, and two or more instances of R present on neighbouring carbon atoms and/or carbon atoms separated by one instance of X independently in each occurrence may fuse.

This molecular design ensures favourable size of the macrocycle in the macrocyclic ring with 18 or 20 macrocyclic atoms. In various embodiments (3-1) to (3-3) are charge neutral, therefore two anions preferably selected from the generic formulae (a-1) to (a4) are present in the final coordination compounds according to the invention. In another embodiment (3-1) to (3-3) are twofold negatively charged preferably by means of two identical borate cluster fragments according to formula (a5) to (a9), which are covalently attached using any suitable spacer at any one or two positions R. If no anion is attached using a position R, then the substituents R might be any charge neutral, organyl group that is formed by removing one hydrogen from a chemically stable organic molecule. In various embodiments, substituents R, present on neighbouring carbon atoms in (3-1) to (3-3), may fuse to form aromatic or aliphatic cyclic groups. For example, 4 substituents R present on two neighbouring carbon atoms separated by an instance X being oxygen may fuse into a furanyl fragment, i.e., into formula (2-1) from above. The two R on each carbon atom together with the respective (macrocycle) ring carbon atom form a carbon-carbon double bond as in 1,3-butadien. Similarly, 4 Rs present on two neighbouring macrocyclic carbon atoms may form together with them 1,2-phenylene group. By adding further fused rings in the 3,4- or 4,5-position, a naphtylene or phenanthrene group can be formed.

In another embodiment, the electroluminescent device according to the invention or at least the layer comprising the Europium coordination compound is deposited from gas phase, in particular using evaporation and/or sublimation and/or carrier gas processes. Indeed, thermal sublimation and/or evaporation are the standard processes used in industrial consumer display production processes and the coordination compounds with macrocyclic ligands as disclosed in the present publication often feature very high volatility - ideally suitable for vacuum coating techniques.

### Brief Description of the Drawings

In the drawings, like reference characters generally refer to the same parts throughout the different views. The drawings are not necessarily to scale, emphasis is instead generally being placed upon illustrating the principles of the invention. In the following description, various aspects of the invention are described with reference to the following drawings, in which:
**FIG. 1** exemplifies side groups that might be part of the metal-organic compound comprised in the electroluminescent device according to the invention.
**FIG. 2** exemplifies macrocyclic ligands that might be part of the metal-organic compound comprised in the electroluminescent device according to the invention.
**FIG. 3** exemplifies anions and anionic side groups that might be present as part of the metal organic coordination compound being present in the electroluminescent device according to the invention.
**FIG. 4** exemplifies metal organic coordination compounds that might be present in the electroluminescent device according to the invention.
**FIG. 5** illustrates various organic materials which can be present in the electroluminescent device according to the invention.
**FIG. 6, FIG. 7,** and **FIG. 8** illustrate schematic cross sections of organic electronic devices according to various aspects.
**FIG. 9** depicts thermal gravimetric analysis (TGA) curves of various emitters potentially present in devices according to the invention.
**FIG. 10** depicts photoluminescence emission spectra of various coordination compounds potentially present in an electroluminescent device according to the invention.
**FIG. 11** (a) and **(b)** depict excited state decay curves of various coordination compounds imbedded into organic host materials, while **FIG: 11 (c)** shows the dependence of the excited state decays as a function of host energy levels.
**FIG. 12****,** and **FIG 15** depict electroluminescence spectra of various devices according to the invention.
**FIG. 13, FIG 14****,** and **FIG 16** depict electroluminescence device characteristics of various devices according to the invention.
**Fig. 17** depicts two Gaussian curves in DOS versus Energy diagrams.

### Detailed Description

The following detailed description refers to the accompanying drawings that show, by way of illustration, specific details and aspects in which the invention may be practiced.

The word "exemplary" is used herein to mean "serving as an example, instance, or illustration". Any aspect or design described herein as "exemplary" is not necessarily to be construed as preferred or advantageous over other aspects or designs.

Various embodiments relate to electroluminescent devices comprising a metal-organic coordination compound containing divalent Europium coordinated by a macrocyclic organic ligand and to methods on how to form said devices.

In this description, a coordination compound is taken to mean a compound where the central active metal, Europium, is coordinated without a direct metal carbon bond. The terms complex, (metal-organic) coordination compound, and emitter (molecule) will be used interchangeably.

The term macrocyclic shall refer to cyclic organic molecules whereby the cyclic chain comprises at least 12 atoms selected from Si, C, Se, B, N, P, O, and S whereby at least some of the bonds between those 12 atoms are aliphatic. Within this description, those - at least 12 - atoms will be referred to as the "macrocyclic atoms". They alone do not constitute the whole organic ligand, which typically comprises many more atoms, such as hydrogens or side groups substituting a certain hydrogen atom. 18-crown-6 is an example of an organic ligand with 6 macrocyclic heteroatoms, namely oxygens, and 12 macrocyclic carbon atoms, with overall 18 macrocyclic atoms. Yet, this particular organic ligand contains additional 24 hydrogen atoms and thus 42 atoms overall.

In this disclosure, the central divalent metal shall be coordinated by a single macrocyclic ligand as those often form complexes of high volatility. Accordingly, the molar ratio of the macrocyclic organic ligand and the central metal is 1:1. Outside of the scope of this invention are electroluminescent devices using divalent Europium coordination compounds with molar ratios of the macrocyclic organic ligands higher than 1:1, such as for example 2:1 or 3:1. A single macrocyclic ring should form the main organic coordination environment for the central metal. This as well excludes polymacrocyclic ligands where two given atoms are threefold linked by at least 5 atoms using partially aliphatic bonds. Such two macrocyclic atoms may be nitrogens resulting in molecules known as aza-cryptands. In particular, such cryptands are not within the scope of this invention.

The "aza" designation in the fragments described herein, i.e., aza-cryptate, etc., means that one or more carbon atom or (other) heteroatom of a parent compound is replaced by a nitrogen atom, without any limitation. For example, in a crown ether, -O- is replaced by -NH- to give the respective aza-crown ether. One of ordinary skill in the art can readily envision other nitrogen analogs of the aza-derivatives, and all such analogs are intended to be encompassed by the terms as set forth herein.

As used herein, "deuterium" refers to an isotope of hydrogen. Deuterated compounds can be readily prepared using methods known in the art.

It is to be understood that when a molecular fragment is described as being a substituent or otherwise attached to another moiety, its name may be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

The terms "halo," "halogen," and "halide" are used interchangeably and refer to fluorine, chlorine, bromine, and iodine.

In this description, the arylene is a divalent organic fragment that is derived from an aromatic or heteroaromatic hydrocarbon (arene or heteroarene) by removing two hydrogen atoms from the aromatic or heteroaromatic hydrocarbon, preferably from different carbon and/or hetero atoms. One example is a (hetero) aromatic hydrocarbon that has had hydrogen atoms removed from two, preferably adjacent, hydrogen-bearing atoms (in case of aromatic hydrocarbon two carbon atoms, in case of heteroaromatic hydrocarbons two atoms selected from carbon and heteroatoms). An aromatic hydrocarbon or arene (or sometimes aryl hydrocarbon) is a cyclic hydrocarbon comprising only sp²-hybridized carbon atoms, leading to a delocalized π-system. An alkylene is a divalent organic fragment that is derived from an alkyl group by removing one additional substituent.

The term "alkyl" refers to and includes both straight and branched alkyl chain radicals and can furthermore also include cycloalkyl radicals. Preferred alkyl groups are those containing from one to fifteen, preferably one to ten, more preferably one to five carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group is optionally substituted, e.g., by halogen, preferably fluorine, or cycloalkyls.

The term "cycloalkyl radical" refers to and includes monocyclic, polycyclic, and spiro alkyl radicals. Preferred cycloalkyl groups are those containing 3 to 12, preferably 3 to 8 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group is optionally substituted, e.g., by halogen, deuterium, alkyl or heteroalkyl.

The terms "heteroalkyl" or "heterocycloalkyl" refer to an alkyl or a cycloalkyl radical, respectively, having at least one carbon atom replaced by a heteroatom. Preferably, the at least one heteroatom is selected from O, S, N, P, B, and Si, more preferably O, or N. Preferably, 1 to 5, more preferably, 1 to 3, most preferably, 1 or 2 heteroatoms are present in the radical. The radical can be covalently linked with the remainder of the molecule via a carbon or heteroatom (e.g., N). Additionally, the heteroalkyl or heterocycloalkyl group is optionally substituted as indicated for alkyl and cycloalkyl.

The term "alkenyl" refers to and includes both, straight and branched chain alkene radicals. Alkenyl groups are essentially alkyl groups with more than one carbon atom that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one, preferably 1 to 5, more preferably 1 to 3, most preferably 1 or 2 carbon atoms replaced by a heteroatom. Preferably, the at least one heteroatom is selected from O, S, N, P, B, and Si, more preferably O, S, or N. Preferred alkenyl/cycloalkenyl/heteroalkenyl groups are those containing two/three/one to fifteen carbon atoms. Additionally, the alkenyl, cycloalkenyl, or heteroalkenyl group is optionally substituted, as indicated above.

The terms "aralkyl" or "arylalkyl" are used interchangeably and refer to an alkyl group that is substituted with an aryl group. Additionally, the aralkyl group is optionally substituted, as indicated for alkyl and aryl.

The term "heterocyclic group" refers to and includes aromatic and non-aromatic cyclic radicals containing at least one, preferably 1 to 5, more preferably 1 to 3 heteroatoms. Preferably at least one heteroatom is selected from O, S, N, P, B, and Si, more preferably O, S, or N. Hetero-aromatic cyclic radicals may be used interchangeably with heteroaryl. Preferred hetero-non-aromatic cyclic groups are those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted, e.g., by halogen, deuterium, alkyl or aryl. The heterocyclic group can be covalently linked with the remainder of the molecule via carbon and/or heteroatoms, preferably one carbon or nitrogen atom. The heterocyclic group can as well be linked to the remainder of the molecules with two carbon and/or heteroatoms. In such a case, the heterocyclic group can be part of the scaffolding of the macrocyclic ligand according.

The term "aryl" refers to and includes both, single-ring aromatic hydrocarbon groups and polycyclic aromatic ring systems. The polycyclic rings may have two or more rings in which two carbons are common to two adjoining rings (the rings are "fused"), or wherein one carbon is common to two adjoining rings (e.g., biphenyl), wherein at least one of the rings is an aromatic hydrocarbon group, e.g., the other rings can be cycloalkyls, cycloalkenyls, aryl, heterocycles, and/or heteroaryls. Preferred aryl groups are those containing three to eight aromatic carbon atoms. Especially preferred is an aryl group having six carbons. Suitable aryl groups include phenyl and radialene. Most preferred is phenyl that can be substituted by non-aromatic groups. Additionally, the aryl group is optionally substituted, e.g., by halogen, alkyl, heteroalkyl, or deuterium. The aryl group is connected to the remainder of the ligand via one or two carbon atoms.

The term "heteroaryl" refers to and includes both, single-ring aromatic groups and polycyclic aromatic ring systems that include at least one heteroatom. The heteroatoms include, but are not limited to and are preferably selected from O, S, N, P, B, and Si. In many instances, O, S, or N are the preferred heteroatoms. Heteroaromatic ring systems with a single heteroatom are preferably single rings with five or six ring atoms, and the ring can have from one to five or six, preferably one to three heteroatoms. The hetero-polycyclic ring systems can have two or more rings in which two atoms are common to two adjoining rings (the rings are "fused"), or wherein one carbon is common to two adjoining rings (e.g., bipyridine), wherein at least one of the rings is a heteroaryl, e.g., the other rings can be cycloalkyls, cycloalkenyls. The hetero-polycyclic aromatic ring systems can have from 1 to 5, preferably 1 to 3 heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyrrole, pyrazole, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably 1,3,4-Oxadiazole, furan, thiophene, 1,2,4-triazole, 1,2,3-triazole, and pyrazole groups, from which one hydrogen atom has been removed from a hydrogen-bearing carbon or heteroatom to form the covalent link to the remainder of the molecule. The heteroaryl group with two hydrogens removed can as well be linked with two carbon and/or heteroatoms with the remainder of the molecules, in which case the heteroaryl group can be part of a larger cyclic group. Additionally, the heteroaryl group is optionally substituted, e.g., by halogen, deuterium, alkyl or aryl. Such (hetero) aromatic units may as well improve the charge transport or charge capture properties of the metal organic coordination compounds. Yet, preference is given to (hetero) aromatic groups with sufficiently high triplet energy to confine the excitation to the central Europium atom and, again, preference is given to relatively strong electron-donating aromatic groups without heteroatoms or with only oxygen or nitrogen as heteroatoms. Each (hetero) aromatic group(s) preferably contain(s) 1 to 5, more preferably 1 to 4, most preferably 1, 2 or 3, preferably fused or annelated, ring structures, preferably (hetero) aromatic) ring structures that contain 0 or 1 non (hetero)aromatic ring, like in a benzofuran group.

Generally, aryl and heteroaryl groups with triplet level > 2.5 eV or more, preferably >2.6 eV, or most preferably > 2.7 eV such as the groups derived from benzene, furan, dibenzofuran, dibenzoselenophene, carbazole, imidazole, pyridine, pyrazine, pyrimidine, triazine, and the respective aza-analogs of each thereof are of particular interest. There are many possible ways to probe the triplet energy level of an organic molecule. A simple way is to use suitable quantum mechanical calculations. A more experimental way takes the onset of the phosphorescence spectrum, which is usually detected using gated spectroscopy, as pioneered by Romanovskii et al. "Phosphorescence of π-conjugated oligomers and polymers." Physical Review Letters 84.5 (2000): 1027. In combination with high triplet energy, generally preference is given to benzene or weakly polarizable, chemically hard heteroaryl groups, such as 1,3,4-Oxadiazole, furan, thiophene, 1,2,4-triazole, 1,2,3-triazole, and pyrazole carbazole, dibenzofuran, and benzofuran groups.

The alkyl, cycloalkyl, heteroalkyl, heterocycloalkyl, alkenyl, cycloalkenyl, heteroalkenyl, alkynyl, aralkyl, heterocyclic group, aryl, and heteroaryl groups or residues, as used herein, are independently unsubstituted, or independently substituted, with one or more (general) substituents, preferably the substituents mentioned below.

Any type of substituents can replace a hydrogen atom in an organic or heterorganic group for example as part of the macrocyclic ligands, for example R or Rₙ in (2-1) to (2-5) or (3-1) to (3-3), or as part as the anion, for example in R_{b} in A2 to A9, as long as it results in a chemical compound which is stable under conditions that occur in an OLED display device or organic electronic device and which does not chemically react with other compounds and components of the OLED display device or organic electronic device.

Preferably, the (general) substituents are selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof with the number of carbon atoms and heteroatoms as defined above for the respective term. Furthermore, one or two substituents can be selected from polymer chains which can be covalently linked with the remainder of the molecule by a suitable organic spacer. Therefore, the cyclic organic ligand can be covalently linked with a polymer chain or a polymer backbone.

In some instances, the preferred general substituents are selected from the group consisting of deuterium, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term.

In yet other instances, the more preferred general substituents are selected from the group consisting of deuterium, alkyl, cycloalkyl, aryl, heteroaryl, and combinations thereof with the number of carbon atoms and heteroatoms as defined above for the respective term.

The terms "substituted" and "substitution" refer to a substituent other than H that is bonded to the relevant position, e.g., a carbon or nitrogen. For example, when R represents mono-substitution, then one R must be other than H (i.e., a substitution). Similarly, when R represents di-substitution, then two of R must be other than H. Similarly, when R represents no substitution, R, for example, can be a hydrogen for available valencies of straight or branched chain or ring atoms, as in carbon atoms for benzene and the nitrogen atom in pyrrole, or simply represents nothing for ring atoms with fully filled valencies, e.g., the nitrogen atom in pyridine. The maximum number of substitutions possible in a straight or branched chain or ring structure will depend on the total number of available valencies in the ring atoms or number of hydrogen atoms that can be replaced. All residues and substituents are selected in a way that a chemically stable and accessible chemical group results.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include thirty to forty atoms that are not hydrogen or deuterium, or those that include up to 30 atoms that are not hydrogen or deuterium counted for all substituents of a given molecule, or for the respective molecule in total. In various embodiments, a combination of substituent groups will include up to twenty atoms that are not hydrogen or deuterium, counted for all substituents of a given molecule.

In some instances, a pair of adjacent residues can be optionally joined (i.e., covalently linked with each other) or fused into a ring. The preferred ring formed therewith is a five-, six-, or seven-membered carbocyclic or heterocyclic ring, including both instances where the portion of the ring formed by the pair of substituents is saturated and where the portion of the ring formed by the pair of substituents is unsaturated. As used herein, "adjacent" or "neighboring" means that the two substituents involved can be next to each other, or next to each other but separated by one macrocyclic heteroatom having the two closest available substitutable positions, such as 2, 2' positions in a biphenyl, or 1, 8 position in a naphthalene, or 2,3-positions in a phenyl, or 1,2-positions in a piperidine, as long as they can form a stable fused ring system. In some instances, a pair of non-adjacent substituents can be optionally joined usually by an, at least partial, alkane or heteroalkene chain of atoms, thereby forming another macrocyclic ring system as part of the coordinating macrocyclic ring present as part of the coordination compound. In some instances, a pair of substituents present on the same carbon atom can be optionally joined, i.e., into an aryl or heteroaryl group, thus, forming a spiro linkage at the given carbon atom.

In this description, the term organyl refers to any chemically stable organic arrangement of atoms where one or more hydrogen atom has been removed such as to use those free vacancies to covalently link the organic group with another molecular entity. Thus, the term organyl encompasses the majority of the above defined organic groups e.g., fluorine, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term. The term organyl shall especially as well encompass sufficiently chemically stable negatively charged species, such as anions, or anionic side groups for example a5 to a9.

Organic groups are derived or formed by removing one or more hydrogen atoms from organic molecules containing at least a corresponding number of hydrogen atoms. For example, benzene results in phenyl or phenylene groups by removing one or two hydrogen atoms, resulting in a monovalent or divalent organic group.

In this description, an electroluminescent coordination compound is any material that is able to emit light upon electrical excitation, resulting from recombination of electrons and holes. It shall be irrelevant in this context whether the recombination of the electrons and holes takes place directly on the electroluminescent compound or first an excitation is formed on a different compound and subsequently transferred to the electroluminescent compound. Further, it shall be irrelevant in this context whether the light emitted is visible for the human eye or not. Especially, compounds emitting infrared and near ultra-violet emission shall be explicitly included.

In the OLED community, the emission is usually classified as fluorescence if it originates from an optically allowed (spin-conserving) transition and decays within a few nanoseconds, such as the transition from the first excited singlet state to the singlet ground state, or as phosphorescence if the emission originates from a spin-forbidden transition and decays with a few micro-milliseconds, such as from the first excited triplet state to the singlet ground state. The emission from the first electronically excited divalent Europium results from an optically allowed spin-conserving d-f transition, which, due to small overlap between the 5d and 4f orbitals, has a rather long excited state lifetime of 1.2 µs (compared to typical fluorescence). Thus, it clearly is neither fluorescent, nor phosphorescent in the typical context used in OLED community. It should correctly be referred to as emission from an intrametallic transition.

In all metal-organic coordination compounds used in the electroluminescence devices according to the invention, there is one macrocyclic organic ligand present that coordinates one divalent Europium cation in a molar ratio of 1:1. Outside the present invention are coordination compounds, where one divalent Europium cation is coordinated by two or more macrocyclic organic ligands. The macrocyclic organic ligand excluding the metal might be charge neutral and the two positive charges of the Europium cation are charge compensated in the final coordination compound by suitable anions, alternatively the macrocyclic organic ligand excluding the metal is twofold negatively charged and forms a complex of zero electrically charge once combined with the Europium cation.

To qualify as a macrocyclic organic ligand according to the invention and the generally accepted definition, at least 12 macrocyclic atoms should be part of a single cyclic ring, the macrocycle. Clearly, the overall number of atoms being part of the macrocyclic organic ligand will be higher; note that only those carbon or heteroatoms are counted as macrocyclic atoms that do form the cyclic closed ring system around the Eu(II), i.e. the "macrocycle" according to the invention. For example, the classical dibenzo-18-crown-6 contains 18 macrocyclic atoms (12 carbon and 6 oxygen atoms, respectively, in the macrocycle), while overall 50 atoms are present. Within the scope of the invention are divalent Europium coordination compounds comprising organic macrocyclic ligands with 12 to 48 macrocyclic atoms as part of the cyclic ring, the macrocycle. Yet, for good coordination of the divalent Europium, the cavity formed by the macrocyclic ring should neither be too small nor too large. This cavity, however, depends somewhat on the exact nature of the heteroatoms present in the macrocycle. For example, if nitrogen is substituted by sulfur in a particular aza-crown ether, the number of macrocyclic atoms does obviously not change, yet the cavity size will tendentially increase. Therefore, it is not possible to give an exact number of macrocyclic atoms that would always perform best. However, general preference is given to macrocycles comprising 15 to 24, and most preferably 18 to 20 macrocyclic atoms, i.e. in the macrocycle.

The macrocyclic organic ligand may comprise any element with at least two valencies that is able to form chemically stable cyclic rings. Indeed, an overwhelmingly large number of macrocyclic rings is described in the literature, for example, crown ethers, calixarenes, porphyrins, and cyclodextrins, which beyond doubt are all within the scope of the invention as they form a cavity using 12 to 48 macrocyclic atoms. According to one embodiment, the macrocycle may only comprise non-coordinating atoms, such as Si, or C. However, preference is given to macrocycles with a plurality of heteroatoms being present that are able to coordinate divalent Europium. In such a situation, two macrocyclic heteroatoms might be direct neighbors within the macrocyclic organic ligand and this might give very chemically robust macrocycles, which are in the scope of the invention. However, preference is given to macrocycles with the coordinating heteroatoms being separated by at least one carbon atom, and more preference is given to arrangements, where each two macrocyclic coordinating heteroatoms are separated from each other by two, or three, or four carbon atoms.

The preferred macrocyclic organic ligand might be described by formula (1-1): 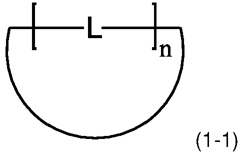 with n being 4 to 8, preferably 4 to 6; and L being independently in each occurrence a divalent organic group formed by removing two hydrogen atoms from an organic molecule containing at least two hydrogen atoms with the shortest sequence of atoms linking each L with the remainder of the macrocycle in the macrocyclic ligand being 3 to 5, preferably 3 atoms, and with one of those 3 to 5, preferably 3 atoms independently for each L being selected from the heteroatoms N, P, S, Se, or O, preferably N, S, Se, or O, the other atoms of those atoms being carbon, wherein preferably the heteroatoms in the macrocycle are non-neighboring. Formula (1-1) describes macrocyclic organic ligands with a minimum of 12 and a maximum of 40 macrocyclic atoms in the macrocycle. In each instance of L, there is at least one heteroatom present. Thus, there are 4 to 8 heteroatoms preferably selected from N, P, O, S, or Se present that are able to coordinate to the divalent Europium. The linker L represents any (divalent) organyl group, such as, but not limited to, a linear (divalent) heteroalkane, a (divalent) heteroaryl, or any other (divalent) heterocyclic group. All those groups may be further substituted, for example, instead of a simple linear (divalent) heteroalkene, a branched (divalent) heteroalkene chain might be present. For (divalent) cyclic organyl groups, always the shortest sequence of atoms linking the (divalent) organyl group to the remainder of the ligand according to formula (1-1) shall constitute the macrocyclic atoms, i.e., should be 3 to 5 preferably 3 atoms. For example, if L represents a (divalent) furanyl group covalently connected to the remainder of the molecule in the 2,5 positions, then the shortest sequence of atoms is 3 and one oxygen is present. Similarly, if L represents a (divalent) pyrazinyl group covalently connected to the remainder of the molecule in the 2,6 positions, then the shortest sequence of atoms is 3 and one nitrogen is present. There is also a longer sequence of 5 atoms, which also has one nitrogen present, which, however, is not the shortest sequence of atoms according to the definition. Finally, an (divalent) aniline group connected via the 2,6 positions is considered. Again, the shortest sequence of atoms is 3, yet none of those 3 atoms is a heteroatom such as N, S, or O. The nitrogen present in aniline is not part of the shortest sequence of atoms in this situation, and as such this group does not fulfil the requirements of (1-1) and thus is not falling under the generic formula (1-1).

Any further ring structures, in the amount of one or several, in addition to the macrocycle, forming part of the macrocyclic organic ligand in addition to the macrocycle are preferably covalently linked with one macrocycle atom, or form part of the macrocycle by 1,2-, 1,3- or 1,4-linkage of the further ring structure, with the remainder of the macrocycle, and are not additionally covalently linked with other atoms of the macrocycle. Examples can be furanyl inserted in the ring (see (2-1)).

With respect to the generic formula (1-1), preference is generally given to n = 6 combined with 3 atoms each being in the shortest sequence of L (18 macrocyclic atoms), and for n = 5 combined with 4 atoms each being in the shortest sequence of L (20 macrocyclic atoms), and for n = 4 combined with 5 atoms each being in the shortest sequence of L (20 macrocyclic atoms).

Further preference is given to heteroatoms N, S, Se or O, being present as part of L and the heteroatom is preferably in a non-terminal position within the macrocyclic fragment L. Without limiting the general scope of the invention, L might independently in each occurrence be selected from (2-1) to (2-5): 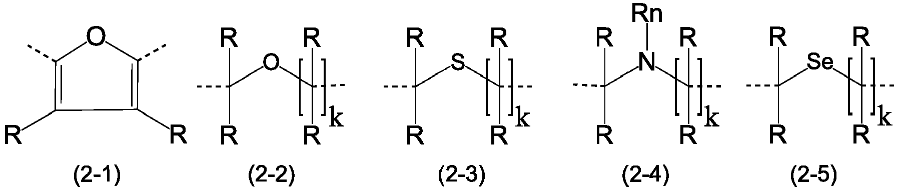 with **R** and **Rn** being H, D, or any monovalent organic group formed by removing a hydrogen atom from an organic molecule having at least one hydrogen, and **k** is independently in each occurrence 1 or 2 or 3, and two to four instances of R present on neighboring carbon atoms or carbon atoms separated by a heteroatom independently in each occurrence may fuse, and the dashed lines indicating the covalent linkage to the remainder of the macrocyclic ligand according to formula (1-1). In each linker (2-1) to (2-5) the shortest sequence of atoms is exactly three for k=1 and there is a heteroatom in the centre of this sequence that is able to coordinate the central Europium. Similarly, the linker L being selected according to (2-2) to (2-5) contains 4 or 5 atoms in its shortest macrocyclic sequence for k being 2 or 3, respectively. Generally, symmetrical linkers are preferred, i.e., where one macrocyclic coordinating heteroatom is sandwiched by two, three, or four non-coordinating carbon atoms. Further preference is given to weakly polarizable and chemically robust units. In (2-1) to (2-5), positions for optional substitutions are indicated by R and Rn. R and Rn may be any suitable organyl group, formed by removing one hydrogen from an organic molecule containing at least one hydrogen atom, including, but not limited to, aryl, heteroaryl, or branched, cyclic or linear alkane or heteroalkene, halogens or deuterium. Additionally, two instances of R present in the same or two different instances of L may link to each other to form a cyclic group. For example, two Rs present in (2-2) in the same instance of L on neighboring carbon atoms may link to each other to form a cyclohexane group. Similarly, two R groups present in (2-2) in the same instance of L on the same carbon atom may link to each other to form a spiro group. In this context (2-1) represents a particular embodiment of the more general linker (2-2); the former ones can be constituted by linking 4 instances of R on neighboring carbon atoms separated by the heteroatom oxygen. In various embodiments, instances of R have 1 to 80 atoms. Yet, in other instances, it will be 1 to 30 atoms. R is generally charge-neutral.

Preferably 0 to 36, more preferably 0 to 18 of these substituents can be present, for example 1 to 18, 1 to 12 or 1 to 6 substituents. Those substituents may be any chemical fragment that can be covalently attached that results in chemically stable organic molecules. Without limiting the full scope of the invention, examples of substituents s1 to s77 that may be present as part of the macrocyclic organic ligand are illustrated in **Fig. 1****.** Here, the dashed lines may represent the preferred connection of the shown molecular fragment to the macrocyclic backbone. Generally suitable substituents are selected independently of each other, yet preference is given to macrocyclic organic ligands that are symmetrically substituted, which implies that a plurality of identical substitutes is preferably selected. In various embodiments hydrogens present on macrocyclic ring atoms may be substituted by deuterium (s1), halogens (s2 to s4), C1-C10 linear or branched alkyl, perfluorinated alkyl, partially fluorinated alkyl, (see s7 to s27) in various embodiments substituted aryl (see s41, s45), in various embodiments substituted heteroaryl (s48 to s52), perfluorinated aryl, partially fluorinated aryl, in various embodiments substituted or non-substituted cycloheteroalkyl (s53), in various embodiments substituted alkenyl, in various embodiments substituted alkynyl. Generally, in various non-aromatic side groups, carbon atoms might be substituted by silicon (s28 to s32). The substituting side group may as well be heteroaryl groups specifically designed to transport charges, such as embodied by s54 to s58 for hole and s48 to s52, s75 for electron transport, respectively. Two instances of R present on the same macrocyclic atom may be substituted forming a spiro linkage, see s62, s66, s67, s70, and s74, where two dashed lines on the same carbon atom indicate the spiro-carbon atom, which is as well a macrocyclic carbon atom. In other embodiments, two instances of R being present on neighboring macrocyclic carbon atoms or being present on neighboring macrocyclic carbon atoms interrupted by one macrocyclic heteroatom are fused into a single side group. Examples, of suitable side groups in Fig. 1 are indicated by two dashed lines depicted on different atoms of the substituent s. For example, s60 may substitute two Rs present on directly neighboring macrocyclic carbon atoms thereby forming a cyclohexane group, of which two carbon atoms are part of the macrocyclic ring. In case of s69 this cyclohexane group is further substituted. Two neighboring macrocyclic carbon atoms may as well be connected by an ethylene double bond, which can be considered by linking two Rs with themselves - a situation indicated by s76. n case of s77 two neighboring macrocyclic carbon atoms may form part of a benzene ring, being fused to the macrocyclic ring. Using s59 an alternative fused side group may be formed by connecting two macrocyclic ring atoms separated by a heteroatom. For example, a thiophene or furan may be formed in case the macrocyclic heteroatom is sulfur of oxygen.

Within this invention, the intended application of the coordination compound is light generation in particular by electroluminescence. With this in mind, the ligand is preferably configured such that the excitation of the coordination compound is confined to the central Europium cation. In this way, an intrametallic transition with highest efficiency is obtained. With respect to the choice of the substituents, side groups that are not easily polarized and that have a sufficiently high triplet level above the transition of the first electronically excited state of the central divalent Europium are preferred. Low polarizability is ensured for aliphatic or heteroaliphatic substituents or using small aryl- or heteroaryl systems with less than 8 conjugated atoms or heteroatoms. In case heteroatoms are part of conjugated side groups, preference is generally given to the heteroatoms N and O, and even more preference is given to O. In various embodiments, side groups with a triplet energy > 2.5 eV, or preferably > 2.7 eV are used. Sufficiently high triplet energy of > 2.7 eV is generally observed for organyl groups comprising of aliphatic or heteroaliphatic fragments or for fragments comprising only small aryl- or heteroaryl systems with less than 8 conjugated atoms or heteroatoms, which thus should preferably be employed if a deep blue electroluminescent emitter is the intended use of the coordination compounds according to the invention. Today, triplet energies of organic molecules can easily and sufficiently accurately be calculated using a wide range of open source or commercial density functional theory (DFT) software packages. Alternatively, triplet energies can be experimentally probed for example as described in van Dijken, A., et al. "Carbazole compounds as host materials for triplet emitters in organic light-emitting diodes: polymer hosts for high-efficiency light-emitting diodes." Journal of the American Chemical Society 126.24 (2004): 7718-7727. As a simple rule, suitable high triplet energy building blocks of the macrocyclic organic ligand are preferably either non-aromatic (aliphatic) or comprise aromatic building blocks containing at most 8 aromatic carbon or hetero atoms, whereby various aromatic building blocks are being separated from each other by at least one nonaromatic carbon or heteroatom. In this context, the nitrogen and oxygen present in carbazole and dibenzofuran are considered a nonaromatic heteroatom. The examples s1 to s77 depicted in Fig. 1 generally exhibit the desired properties of low polarization and sufficiently high triplet energy to be used for the design of deep blue emitting divalent Europium coordination compounds.

The substitutions on the nitrogen are generally labeled Rn, for example in formula (2-4). Within the scope of this invention, an instance of Rn may be fused with an instance of another substitution R from a macrocyclic carbon atom. However, outside the scope of the invention is a linkage of two instances of Rn with each other that are not covalently linked to two neighboring macrocycle atoms (thus in a 1,2-substitution scheme) or to two macrocycle atoms separated by one further macrocycle atom (thus in a 1,3-substitution scheme). Such linkages would often form highly three-dimensional cages, typical of the cryptand-type macrocyclic ligands, compare WO 2021/244801. Those ligands are often not able to form a symmetric structure thereby forming structures with high total dipole moment, and, as such, they are not well-suited for the design of volatile emitter molecules suitable for gas-transfer processing.

Preferred are macrocyclic ligands that are rotation or mirror symmetrical and where the heteroatoms are separated along the macrocyclic ring by carbon atoms. In an even more preferred situation, the number of macrocyclic carbon atoms between the heteroatoms is identical for each pair of neighboring macrocyclic heteroatoms. With respect to formula 1-1, in each instance of n, k is 1 or 2 or 3 combined with n being 6 and 5 and 4, respectively. In this preferred situation formula (1-1) can be specified by the generic formulae (3-1) to (3-3): 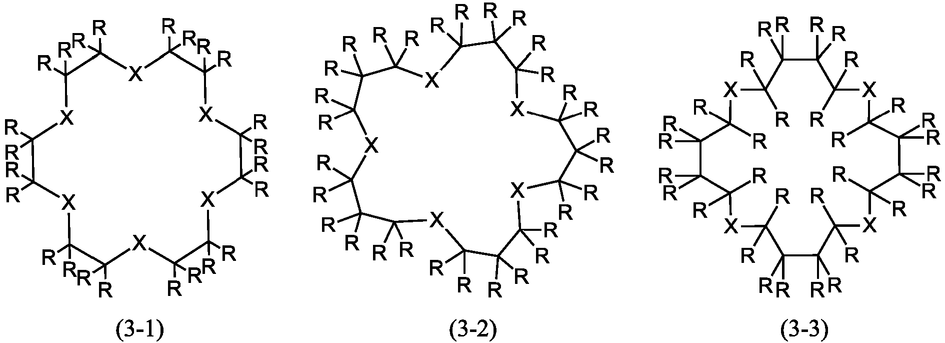 with X representing the heteroatoms being selected from N-Rn, P, S, Se, or O, preferably N-Rn, S, Se, or O and **R** and Rn being H, D, or any monovalent organic group formed by removing a hydrogen atom from an organic molecule having at least one hydrogen, being identical or different in each occurrence, and two or more instances of R present on neighboring carbon atoms and/or carbon atoms separated by one instance of X independently in each occurrence may fuse.

The preferred macrocyclic ligands (3-1) to (3-3) represent simple crown ethers in case all instances of X are equal to O and none of the Rs is substituted. In other embodiments substituted or non-substituted aza or thio crown ethers may be formed by choosing some or all instances of X to be N or S. The generic structures (3-1) to (3-3) feature 6 to 4 macrocyclic heteroatoms, respectively, able to coordinate to divalent Europium. Those 6 to 4 heteroatoms are selected from P, O, S, N and Se. No two heteroatoms are direct neighbours, i.e., they are not linked directly by a chemical bond. Instead, all heteroatoms are separated from each other by at least two carbon atoms, i.e., by a linear ethylene or propylene or butylene chain segment. Therefore, the overall number of macrocyclic atoms present in structures (3-1) is 18, i.e., 12 carbon and 6 hetero atoms, the overall number of macrocyclic atoms in structures (3-2) is 20, i.e., 15 carbon and 5 hetero atoms, whereas the overall number of macrocyclic atoms in structures (3-3) is 20, split into 16 carbon and 4 hetero atoms. The R depicted in (3-1) to (3-3) again represent any organyl group formed by abstracting a hydrogen atom from a chemical stable group, formed by removing one hydrogen from an organic molecule containing at least one hydrogen atom, including, but not limited to, aryl, heteroaryl, or branched, cyclic or linear alkane or heteroalkene, halogens or deuterium, such as shown in Fig. 1. In one instance, R might be twofold negatively electrically charge, or in up to two instances R might be single negatively charged.

Without limiting the scope of the invention, M1 to M69 shown in **FIG. 2** further illustrate examples of macrocyclic organic ligands that might be used to construct the metal-organic coordination compounds employed in the electroluminescent device according to the invention. The concrete compounds depicted serve for illustration purposes and shall help to show the scope of the invention. In this context, most of the possible substituents that may be present on certain carbon or heteroatoms have been omitted for clarity. They may nevertheless be present.

The majority of examples depicted in FIG. 2 exemplifies macrocyclic organic ligands with 12 macrocyclic carbon and 6 macrocyclic heteroatoms, i.e. organic ligands based on rings with 18 atoms. Exceptions are compounds M9, M13, M14, and M15 with 19 macrocyclic atoms, as well as M10, M11, M38, M41, M43, M44, and M45 with 20 macrocyclic atoms. Six heteroatoms are present in the majority of examples depicted in FIG. 2. Exceptions are examples M11, and M41 exemplifying five heteroatoms and M43, M44, M45 exemplifying four heteroatoms, while M38 depicts an example with 8 macrocyclic heteroatoms.

The heteroatoms are mostly selected from the preferred atoms Se, N, O, and S. Only three examples are based on a 18-crown-6 motive with macrocyclic oxygens being replaced other heteroatoms: by PH (M34), SiH₂ (M35), or BH (M36).

As explained above, any suitable macrocyclic carbon or heteroatom may be substituted using a suitable substituent. Here M1 to M11, for example are depicted without any substituents. M13 and M14 illustrate the situation where 6 macrocyclic carbon atoms are each twice substituted by a methyl group. Various examples are shown for illustration purpose, where two macrocyclic nitrogen's present in the organic ligand are substituted with linear (M25, M29, M45) or branched (M27) alkyl groups, benzyl (M26), or adamantyl (M28). In M30, the hydrogens present on the two nitrogen's are substituted by deuterium. For M31, and M32, one nitrogen is substituted with a linear chain attached to a cyclic aza crown ether group, i.e., to another macrocyclic organic ligand.

For applications requiring high chemical stability, it may be beneficial to substitute hydrogen partly or completely by deuterium. For example, all possible hydrogens present in the macrocyclic ligand are replaced by deuterium in M23. On the other hand, in example M30 only the two most chemical reactive hydrogens present on the macrocyclic nitrogen atoms, are substituted by deuterium, s1 group from Fig. 1.

As explained above, several substituents present on the macrocyclic organic atoms may be linked to each other, and various examples are given in Fig. 2. For example, in M16, and M39, two times two instances of R, and in M17, three times two instances of R, present on neighboring macrocyclic carbon atoms with a direct bond are linked with the divalent butane-based s60 group from Fig. 1 into cyclohexane fragments. The compounds M16, M17, and M39 each exemplify two different substitutions on specific macrocyclic carbon atoms. Note that addition of a single residue R as well as addition of two different residues R and R' on the same macrocyclic carbon atom creates a stereogenic centre in the ligand. The ligands for which this becomes relevant are for example those containing cyclohexyl groups, i.e., M16, M17, M39, M54 and M61. If not explicitly drawn in the structure, we refer to all possible stereoisomers and enantiomers of the compound. For M16 and M39, we exemplify some possible present stereoisomers, namely trans-anti (ta), trans-syn (ts), cis-anti (ca), and cis-syn (cs), at the very end of Fig. 2. Here, trans/cis specifies how the cyclohexyl unit is attached to the macrocycle, while syn/anti specify the relative orientation of the cyclohexyl rings. As evident from the DFT calculations for the four stereoisomers of M16 with A1, the central quantities (Dipole, Ems, EBE, ES-EBE) are quite similar for ta and ts isomers, whereas the differences between ca and cs are more pronounced. M21 depicts the situation where two instances of R present on the same macrocyclic carbon atom are linked with s62 from Fig. 1 to fuse into cyclohexane groups. Thus, the macrocyclic carbon atom is spiro-linked to its two substituents. In the case of M15, two times two instances of R present on neighboring macrocyclic carbon atoms with a direct bond are linked with s63 from Fig. 1 into bis-cyclic aliphatic groups; overall this substitution pattern appears 3 times in M15, thus a total of 12 hydrogens are substituted. Similarly, four instances of R fuse with tetravalent butene-based groups s61 from Fig 1, into a benzene fragment, with four macrocyclic carbon atoms being now aromatic. A similar situation resulting in 3 benzene rings is shown for M19. In M12, M20, and M42 four substituents on two neighboring macrocyclic carbon atoms without a direct bond, i.e. separated by a heteroatom, fuse with tetravalent ethane-based groups s59 from Fig. 1. Here one or two furanyl groups are formed with the oxygen and the two substituted carbon being macrocyclic ring atoms. In the case of M24, four substituents on two neighboring macrocyclic carbon atoms separated by nitrogen are linked with trivalent propylene-based group s77 to form pyridine groups, and nitrogen and the two substituted carbon atoms are parts of the macrocyclic ring. In case of M22, benzene and furan forming substituents are combined thus forming di benzofuran with 5 atoms of the di benzo furan being macrocyclic ring atoms. In this particular example, 16 substituents are not equal to hydrogen.

Substituents may be charge-neutral, for example alkane or alkene fragments with two or more covalent links to two or more carbon atoms of the macrocyclic ligands according to the invention. Otherwise, for example, linear or branched alkane side chains may be chosen if a good solubility in non-polar solvents is needed. For other applications, coordination compounds with high thermal stability, for example suitable for evaporation or sublimation, may be needed. In this case, small and light weight substituents are preferably employed, i.e., organyl fragments with individually less than 20 atoms and or individually a molecular weight of less than 100g/mol. Similarly, halogenated, particularly fluorinated, side groups, such as depicted in s11, s15, s36 in **FIG. 1** may improve volatility and/or stability of the coordination compound according to the invention. Since the intended application of the coordination compound of the invention is light generation, in particular by electroluminescence, the ligand preferably may be chosen such that the excitation of the coordination compound is confined to the central Eu cation. In other words, ligand-to-metal or metal-to-ligand change transfer character in the excited state is preferably avoided. In this way, an intrametallic transition with highest efficiency is obtained. With respect to the choice of the substituents, preferred are side groups that are not easily polarized and that have a sufficiently high triplet level above the transition of the first electronically excited state of the emitter molecule. Low polarizability is ensured for aliphatic or heteroaliphatic substituents or using small aryl- or heteroaryl systems with less than 8 conjugated atoms or heteroatoms. In case heteroatoms are part of conjugated side groups, preference is generally given to the heteroatoms N and O, and even more preference is given to O. In various embodiments, side groups with a triplet energy > 2.5 eV, or preferably > 2.7 eV are used. Sufficiently high triplet energy > 2.7 eV is generally observed for organyl groups comprising of aliphatic or heteroaliphatic fragments or for fragments comprising only small aryl- or heteroaryl systems with less than 8 conjugated atoms or heteroatoms, which thus should preferably be employed substituents if a deep blue electroluminescent emitter is the intended use of the mixture according to the invention. The side groups depicted as s1 to s77 in Fig 1 as well as the macrocyclic ligands with their side groups exemplified in Fig. 2 are choses such as to maintain sufficiently high triplet energy of the ligand and to reduce the probability of charge transfer states, by generally choosing materials with low electron affinity.

Nowadays, triplet energies of organic molecules can be calculated easily and with sufficient accuracy using a wide range of open source or commercial density functional theory (DFT) and time-dependent (TD)-DFT software packages. Alternatively, triplet energies can be experimentally probed, for example as described in van Dijken, A., et al. "Carbazole compounds as host materials for triplet emitters in organic light-emitting diodes: polymer hosts for high-efficiency light-emitting diodes." Journal of the American Chemical Society 126.24 (2004): 7718-7727.

As a simple rule, suitable high triplet energy building blocks of the macrocyclic organic ligand are preferably either non-aromatic (aliphatic) or comprise aromatic building blocks containing at most 8 aromatic carbon or hetero atoms, whereby various aromatic building blocks are being separated from each other by at least one nonaromatic carbon or heteroatom. In this context, the nitrogen and oxygen present in carbazole and dibenzofuran are considered a nonaromatic heteroatom.

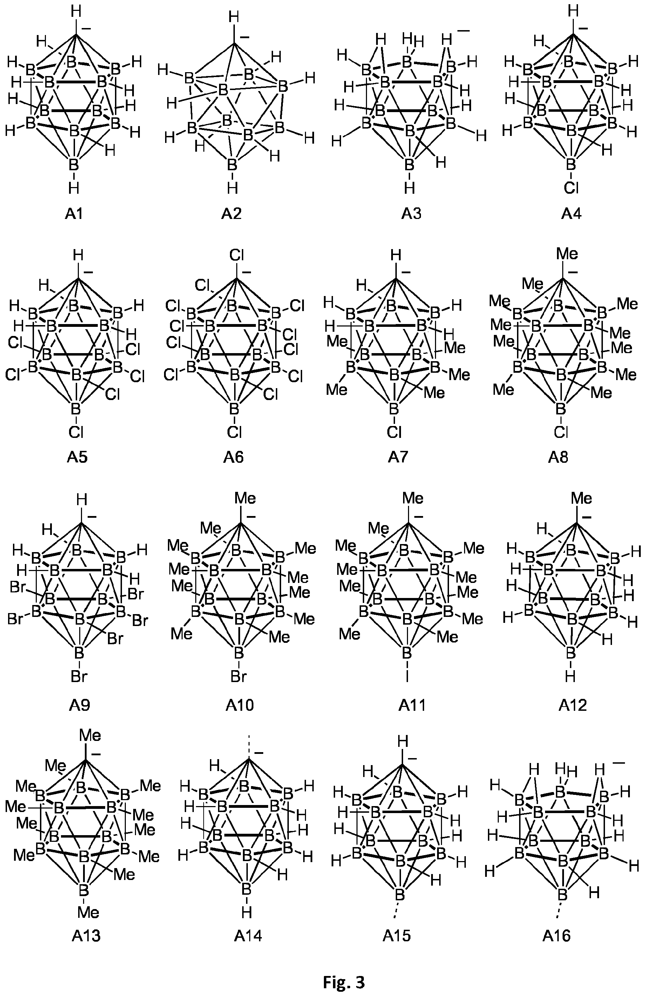

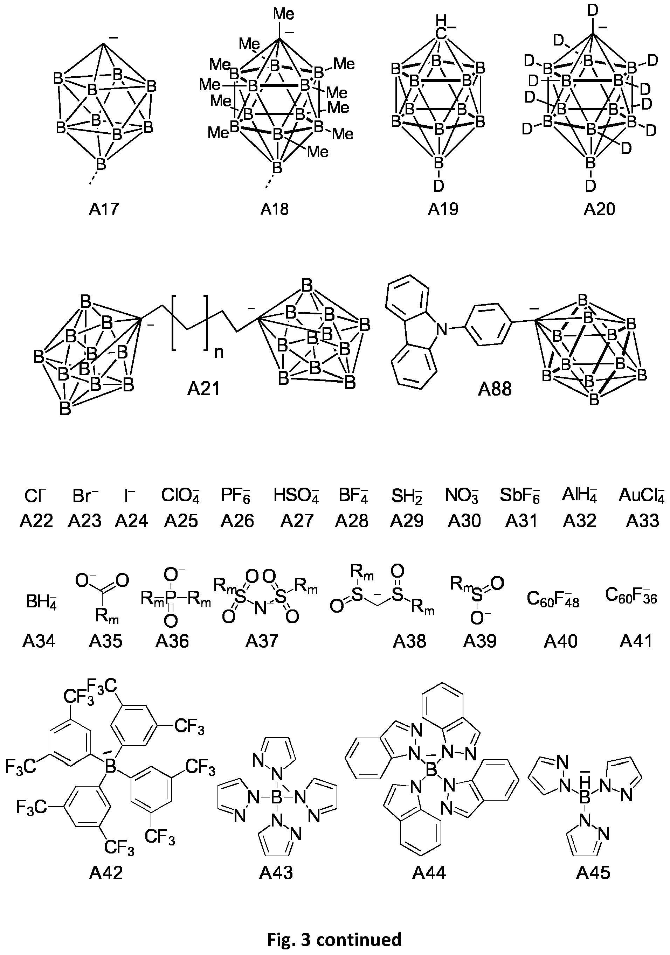

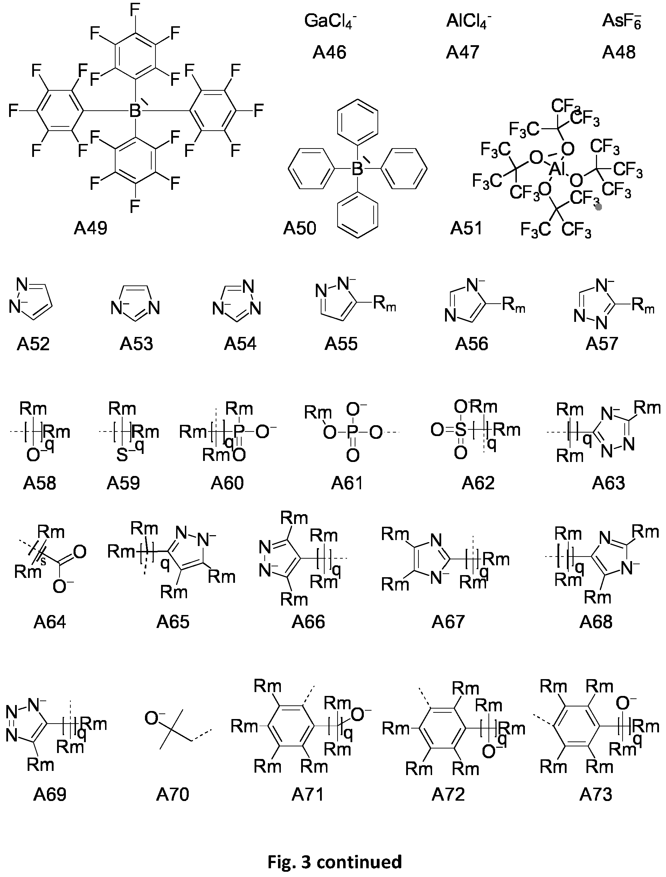

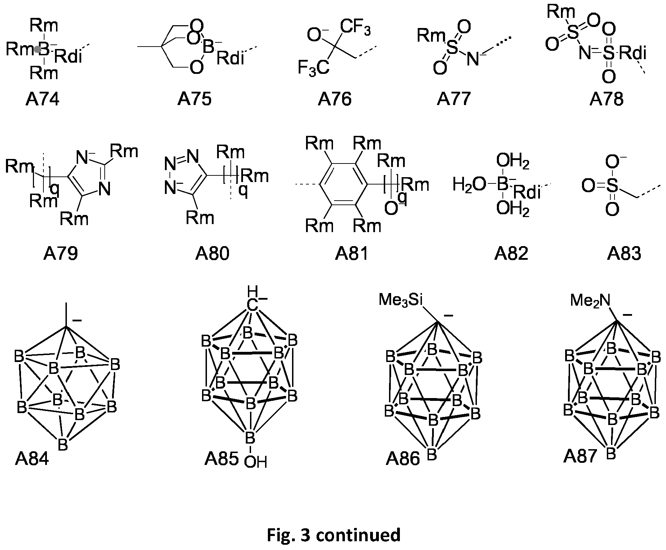

In various embodiments, the macrocyclic organic ligand that coordinates to a divalent Europium cation within the coordination compound being used in the electroluminescent device according to the invention may itself already be singly or multiply (preferably dually) negatively charged. In various embodiments, suitable anionic groups are covalently attached to the macrocyclic organic ligand for example at positions R. Without limiting the scope of the invention, examples of such anionic substitutions may be any singly or doubly negatively charged organyl groups that are sufficiently chemically stable. Generally, preference is given to anionic groups that do not absorb light with a wavelength in the range of 380-700 nm, more preferably in the range of 430-500 nm. Further preference is given to lightweight anionic groups with molecular weight of less than 1000 g/mol, preferably less than 500g/mol. Further preference is given to anions that do not strongly interact with the excited Eu cation present in the coordination compound. In other words, preferred are weakly coordinating anions with a distinct three-dimensional structure that is able to distribute the negative charge over a plurality of atoms. Without limiting the general scope of this invention, examples of anionic side groups are depicted as A13 to A16 and A58 to A83 in **Fig. 3****,** where a dashed line indicates the covalent link to the remainder of the macrocyclic ligand, for example at positions R, and **R_{b}** has the same meaning as above and **Rₘ** independently in each occurrence represents monovalent groups formed by removing a hydrogen atom from a substituted or non-substituted alkane, or arene, or heteroarene, and **R_{di}** represents a divalent group formed by removing two hydrogen atoms from a substituted or non-substituted alkane, or arene, or heteroarene, and **q** independently in each occurrence is 0, 1, 2, or 3 and **s** independently in each occurrence is 1, 2, or 3. Twofold negatively charged macrocyclic ligands are as well exemplified as M41, M42, and M46 to M51 in Fig. 2, where different closocarborate cluster type anionic groups are covalently attached to the aza-crown ethers using alkyl or heteroalkyl linkers between each two macrocyclic nitrogen atoms and the anionic side group.

Instead of covalently attaching anionic groups, the macrocyclic organic ligand may as well comprise negatively charged hetero atoms, such as borates or negatively charged aryl groups, such as pyrrolate as part of the scaffold of the macrocyclic organic ligand. For example, this can be achieved by deprotonation of the aromatic pyrrole or triazole building blocks. The optional negative charge present in the ligand may as well be substantially localized on a particular heteroatom that is part of the scaffold of the organic ligand used in the invention. For example, a negatively charged borate may be used as one or two of the macrocyclic atoms, illustrating a singly or twofold negatively charged macrocyclic ligand. Further possible covalently-linked anionic side groups are disclosed in WO2021/244801 A1 and WO 2022/218562 A1.

In preferred embodiments of the coordination compounds being present in the device of the present invention, the sum of the negative charges of the covalently attached anionic groups matches the charge of the central divalent Eu cation, such that the resulting metal-organic coordination compound is charge-neutral. In such a configuration, no unbound negatively charged anions are present, which elegantly avoids anion drift in device configuration under applied electric fields. Therefore, preferred are negatively charged ligands containing exactly two singly charged anionic groups or exactly one twofold negatively charged anionic group.

The negatively charged anionic side groups exemplified in FIG. 2 and 3 shall not limit the scope of the invention. In various embodiments, anionic groups covalently linked to the organic ligand may be twofold or even higher charged, for example by attaching sulfate, phosphate, or chromate anionic groups. Similarly, the polycyclic organic ligand may carry more than two negative charges. In such a case, a charge neutral compound may be obtained by incorporation of additional suitable organic or inorganic cations, such as ammonium, alkali, alkaline earth metal cations or similar into the coordination compound being part of the device according to the invention. While any anionic side groups, for example those depicted in **FIG. 3****,** may be used, preference is generally given to chemically soft side groups that do not strongly interact with the electronically excited Eu cation. As such, preference is given to anionic side groups that do not tend to form covalent chemical bonds with the central cation, but where the interaction is mainly of electrostatic nature. Accordingly, bulky anions or anionic groups in which the negative charge is distributed over many atoms are preferred. Additionally, preference is given to anions that do not absorb light with a wavelength in the range of 380-700 nm, more preferably in the range of 430-500 nm. Very well suited in this context and therefore preferred are covalently attached borate type cluster fragments selected according to formulae a5 to a9 in Fig.3 and here re-drawn for convenience: 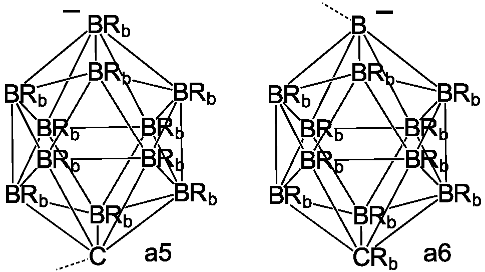 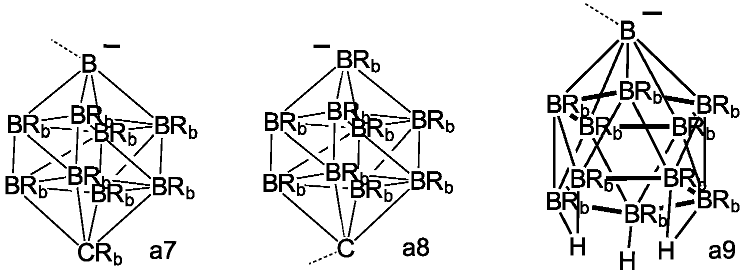 wherein the dashed line indicates the covalent linkage to the remainder of the organic macrocyclic ligand, and **R_{b}** independently in each occurrence represents either hydrogen, deuterium, halogene - preferably chlorine, or an alkyl chain - preferably C1-3- alkyl, more preferably methyl.

In various embodiments, the coordination compound may include at least one negatively charged anion that is not covalently bound to the macrocyclic organic ligand. The same requirements with respect to charge and energy requirements as described above apply and suitable anions are depicted as A1 to A13, A19 to A57, and A84 to A88 in Fig. 3. The negatively charged anion may be a small inorganic anion such as, but not limited to, halogens, such as A22 to A34 in Fig. 3. When an external field is applied to a layer comprising the coordination compound according to invention, for example in operative OLED device configuration, anions may drift towards oppositely charged electrodes, especially when using small and non-bulky anions. Such behaviour may define a so-called light emitting chemical cell.

A light emitting chemical cell may be an embodiment of an OLED in this description. Drift of charged species within the electroluminescent device including the Europium coordination compound may lead to very low driving voltages, which may facilitate high power-efficiencies. This may be desirable for some applications, such as general illumination or signage. Yet, for other applications that require fast response times, for example flat panel displays, such ion drift may lead to time dependent current-voltage-luminance (IVL) characteristics, which may be difficult to control, and may not be desirable as such. Therefore, the choice of the anions may depend strongly on the application.

In various embodiments, the coordination compound may contain comparably large and bulky organic anions. Such anions may be employed if ion drift is not desired. Examples without limiting the general scope of the invention of such anions include fluorinated or non-fluorinated fullerene (C₆₀⁻, C₆₀F₃₆⁻, C₆₀F₄₈⁻) fluorinated aryls and fluorinated or non-fluorinated aryl or heteroaryl-borates for example A42, A49, and A51 shown in Fig. 3.

The negatively charged anion may include more than one atom, preferably more than three atoms. Such larger anions are generally bulkier and, as such, are better suited for applications where drift of anions is not desired. Furthermore, the anion may have a molecular weight of at least 128 g/mol. Suitable anions shown in Fig. 3 and further ones are disclosed in WO 2021/244801.

In various embodiments, anions without substantial absorption at wavelengths in the range of 380-700 nm, more preferably in the range of 430-500 nm, may be used. In case there are two non-covalently bound anions present, they may be the same or of different type.

In various embodiments, a doubly negatively charged anion is present in the coordination compound according to the invention, such as for example the closoborate [B₁₂H₁₂]²⁻ or the borane cluster *fac*-[B₂₀H₁₈]²⁻ or A21 in Fig. 3.

As with the embodiments using covalently attached anionic groups, preference is given to anions that do not strongly interact with the electronically excited central Eu cation. As such, preference is given to anionic side groups that do not tend to form covalent chemical bond with the central cation, but where the interaction is mainly of electrostatic nature. Accordingly, bulky anions or anionic groups in which the negative charge is distributed over many atoms are preferred. Further preferred are light weight anions with individually less than 1000 g/mol and more preferably less than 500 g/mol. Very well suited in this context, and therefore preferred, are substituted or non-substituted *closo-* and/or *nido-* (car)borate cluster anions as well as iodide. Preferably, two identical anions selected from a1 to a4 are chosen: 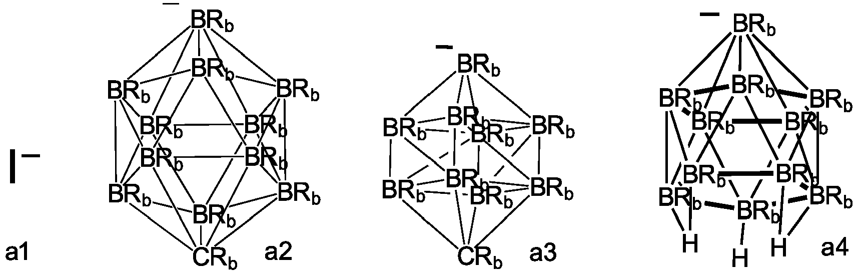 with **R_{b}** having the same meaning as above.

These particular anions also show the desired property of high triplet energy (> 2.7 eV) combined with low absorption in the visible spectral region. At the same time, they are light weight for high volatility.

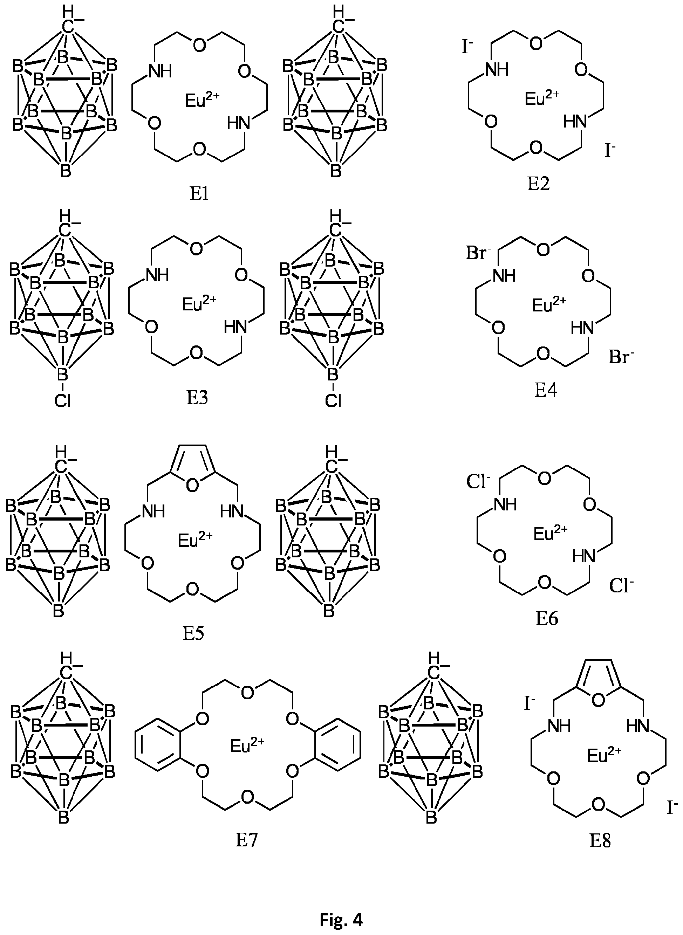

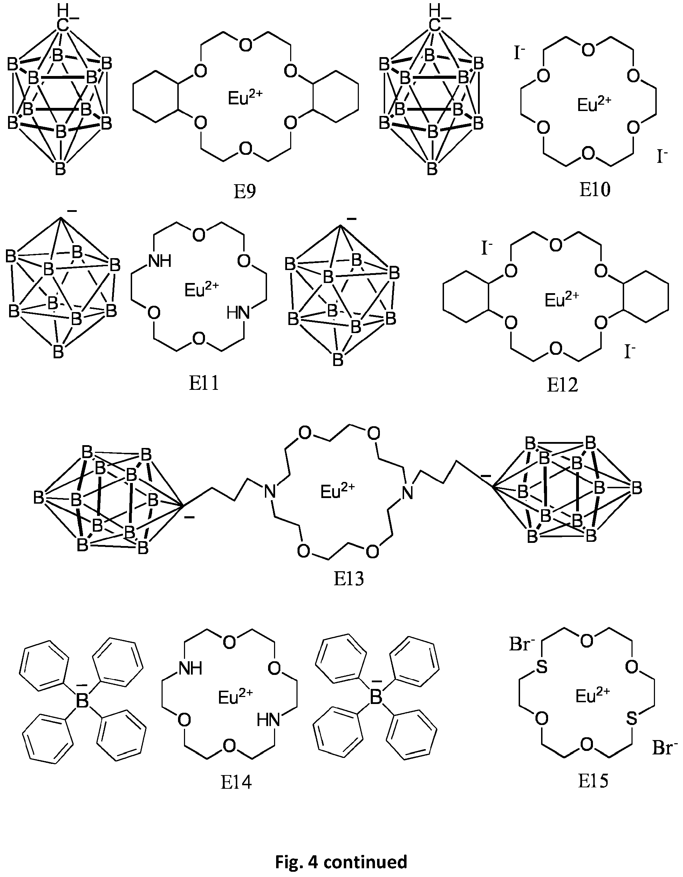

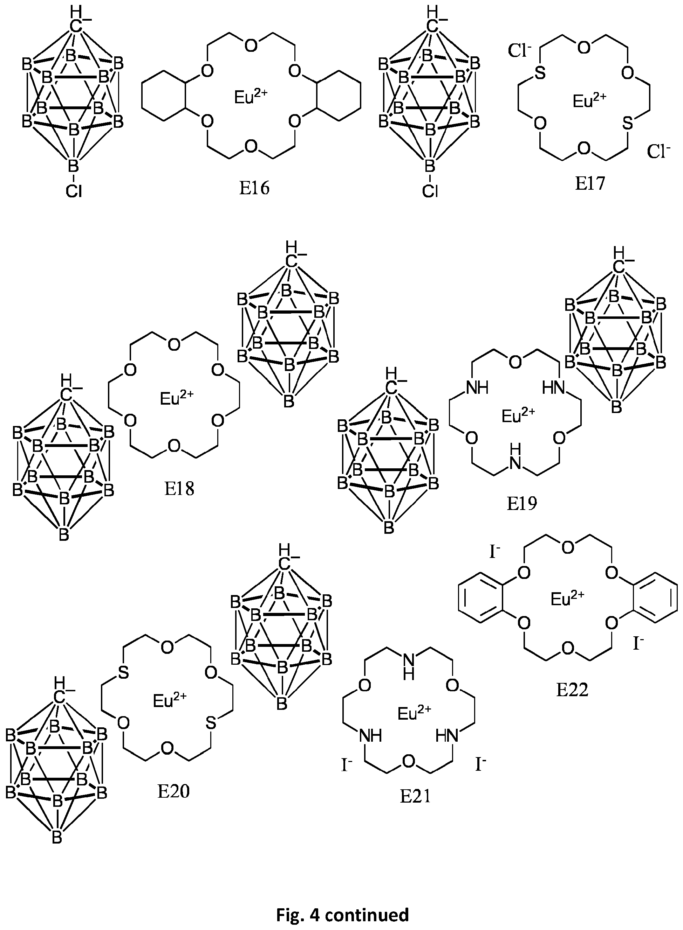

Without limiting the general scope of the invention, concrete examples of coordination compounds that might be used in electroluminescent devices according to the invention can be obtained by combining pairwise a specific organic macrocycle from Fig. 2 with two different or, preferably, 2 identical anions selected from Fig. 3. In doing so, a limited set of examples for illustration purpose is shown as E1 to E22 in **Fig. 4** yet many more compounds can be generated by this combinatorial approach. For example, E1 uses a simple non-substituted di-aza-crown, which is shown as M3 in Fig. 2 and is combined with two anions of the instance A1 shown in Fig. 3. Like M3, also A1 is non-substituted, i.e. all instances of R_{b} as part of the generic formula a2 are equally set to hydrogen. Examples E2, E4, E6, and E14 are based on the same di-aza-crown M3, yet combined with different anions, in particular halogens A22, A23, A24, and tetraphenylborate, A50. E3 and E19 are once more derived from E1, yet this time the anion is substituted once with a chlorine using anion A4 (E3) and twice by a chlorine and a methyl group (E19). E13 illustrates another example closely related to E1. Here, the simplest anion (all R_{b} are set to hydrogen) generated by the generic formula a5, A14, is covalently linked to an di-aza-crown macrocycle. Its thus and example, where M3 is covalently linked to two instances of A1 using a propyl spacer connected to the nitrogen's of the macrocycle. In this example, no free anions are present. Finally, E5, E7, E9, E18, and E20 all employing the same anion as in example E1, i.e. A1 but combine it with different macrocycles. In particular E5 uses a furan di-aza crown (M12), E7 di-benzo crown ether (M40), E9 di-hexyl crown ether (M39), E18 a simple crown ether (M1), and E20 a di-thia crown ether (M2).

This invention considers electroluminescent devices comprising specific coordination compounds as active light emitting material. In OLED devices the active light emitting layer is configured comprising the emitting organic compound imbedded into one (b) or more (c) charge neutral host materials, often configured to transport charges. The excitation that might be formed on the coordination compound (a) after charge recombination does sense the physical presence of the secondary host material (b). Therefore, the energy - and charge transport levels of the secondary host are of crucial importance to enable electroluminescent light generation of high efficiency.

Thus, in all embodiments of the invention, the coordination compound (a) is mixed with, or adjacent to, a second charge-neutral organic compound (b). The second organic material (b) may be chosen from a wide range of generic classes of substantially organic materials, including but not limited to small organic molecules, preferably with a molecular weight less than 1500 g/mol, large molecules or polymers with organic weight of more than 1500 g/mol, dendrimers, metal-organic complexes, or organic materials not comprising any metals. Generally, the second organic material may as well be processed in a low molecular weight form and later be combined into a higher molecular weight form. Examples here are metal organic frameworks or crosslinkable polymers. Generally preferred are second organic materials that add a desired functionality to the mixture according to the invention. Such a functionality can be, without limitation, improved air or moisture stability, improved thermal stability, improved charge transport properties, improved dispersion of the coordination compound according to formula (1-1), improved optical characteristics - such as lowering the refractive index of the mixture or improved processing to name just a few.

In various embodiments, the coordination compound (a) is imbedded into the at least one second charge-neutral organic compound (b) at 0.1 - 99.0 vol%, preferably at 1 - 90 vol%, and most preferably at 3 - 30 vol%, based on the mixture which is 100 vol%. Thus, in various embodiments, the coordination compound might take a majority or a minority of the overall volume of the mixture. Yet, in more preferred embodiment, the coordination compound (a) takes a minority part of the volume and has the function of an organic dopant, whereas the one or more organic materials (b) take a majority part of the volume for example to funnel energy or charges towards the coordination compound.

In various embodiments, the coordination compound (a) and the second charge-neutral organic compound (b) together from an emission layer, with the concentration of the coordination compound (a) within the charge-neutral organic compound (b) being not constant measured in the direction perpendicular to the emission layer. For example, it may be that the concentration of the coordination compound is higher than the average of the overall emission layer. It may well be that within said emission layer one or more sublayers exists which contain substantially only the coordination compound. One or more compound (b) host sublayers may as well be partially or fully depleted of the coordination compound. In case one or more substantially pure sublayers that do containing nearly exclusively the coordination compound are present, than the combined partial layer thickness of the one or more sublayers comprising substantially the metal organic coordination compound is in the range of 0.1 - 99.0 %, preferably 1 - 90 %, and most preferably 3 - 30 %, based on an overall thickness of the organic layer, which is 100%.

In various embodiments, the second organic material (b) being part of the mixture according to various embodiments or being part of an adjacent layer that comprises the coordination compound (a) may be a matrix having suitable optical properties, such as, for example, a high transparency in certain desired parts of the visible spectrum. If this matrix is brought in optical contact to a light source emitting at a sufficiently short wavelength, this light may be absorbed by the coordination compound and reemitted at a substantially longer wavelength. A suitable light source may for example be a light emitting diode, emitting light at a wavelength substantially shorter than 430 nm, which may be reemitted by the coordination compound present in the mixture at a wavelength longer than 430 nm. The matrix may have any physical dimensions. It may for example be a thin layer of 10 nm to 10,000 nm. The matrix may as well be of granular form or in form of small particles of average diameter between 10 nm and 100,000 nm. For use in optical devices, in the latter cases, the matrix may be applied inside another host material for support.

In various preferred embodiments, an emission layer in the form of either the mixture of a Europium coordination compound (a) imbedded into a second charge-neutral material (b) or the two adjacent layers with one comprising the coordination compound (a) and the other the second charge-neutral material (b) is used as part of the electroluminescent device according to the invention in particular to generate color-pure deep blue emission from the intrametallic transition after direct or indirect optical or electrical excitation. The excitation on the coordination compound qualitatively consists of an electron and a hole. To emit light with high efficiency while being imbedded into or nearby an interface to a second organic material, it is mandatory that the positive charge, commonly referred to as hole, is confined to the coordination compound. Thus, a mandatory requirement is that the second charge-neutral organic compound has a higher electron binding energy than the charge-neutral coordination compound. In other words, the most weakly bound electron in the coordination compound should be less strongly bound than the most weakly bound electron of the second organic material. The requirement thus means that for a hole being present in the emission layer (either interface type or imbedded) according to the invention, it is energetically favorable to reside on the coordination compound as opposed to residing on the second organic material.

Measuring the transport levels of organic materials is an established field based on a wide selection of methods and a wide variety of techniques have been published in the literature. However, for the purpose of various embodiments, the particular technique of how to measure the electron binding energy and or the electron affinity is not essential, e.g., only the relative order of the materials being present in the mixture according to the invention, i.e., between the coordination compound and the second organic materials, may be of importance.

With the recent huge advances in quantum mechanical computing techniques and progress in the development of density functional theory, an easy way to deduct electron binding energies (EBEs) and electron affinities are DFT calculations. Experimental methods involve cyclic voltammetry in solution. For solid films UPS or AC-2 (Riken Keiki) are often used. Further experimental techniques are very well known in the art, e.g. see R.J.Cox, Photographic Sensitivity, Academic Press, 1973, Chapter 15. Without limiting the general scope of the invention, a very modest selection of possible charge transport materials is illustrated as H1 to H23 in **FIG. 5** and some corresponding EBEs are given in **Table 5** below. Additionally, calculated electron binding energies of various neutral coordination compounds are tabulated in **Table 4** below. As a side remark, the use of the term "HOMO" for Eu(II) coordination compounds is scientifically not correct. This is because the term commonly refers to the highest fully (doubly) occupied orbital, whereas divalent Eu has seven partially (singly) occupied orbitals that lie energetically above its highest fully (doubly) occupied orbital. Since those singly occupied orbitals are much more relevant for the photophysical processes than the doubly occupied one, we use the more general term electron binding energy (EBE) instead of the more common but incorrect term HOMO energy. EBE is a more modern expression for the ionization potential (IP). Both, HOMO and EBE (and IP) refer to the binding energy of the most weakly bound electron in a molecule, though the value given for the HOMO is typically of opposite sign. Accordingly, removing an electron from or, in other words, accepting a hole on divalent Europium leaves six electrons in its originally half full 4f-shell, which corresponds to the following change in its electronic configuration: [Xe] 4f⁷5d⁰6s⁰ → [Xe] 4f⁶5d⁰6s⁰. Formally, this process yields trivalent europium, or Eu(III), and requires to overcome the electron binding energy. Furthermore, to describe the electron-binding energy in electronically excited metal-organic compounds comprising Eu(II), we use the term excited-state electron binding energy (ES-EBE), which is related to what is commonly known as the electron affinity or LUMO energy of most organic materials.

In various preferred embodiments, the second charge-neutral organic compound (a) has an electron binding energy higher than 4.5 eV, preferably higher than 5.1 eV and most preferably higher than 5.7eV. Generally, organic materials with deeper HOMO (corresponding to a higher EBE) generally allow to design more chemically stable organic devices. Additionally, the coordination compound present in the mixture or interlayer according to embodiments of this invention is preferably emitting deep blue light with a substantial fraction of the emitted light at emission energies higher than 2.5 eV. With an electron binding energy of no more than 4.5 eV, this would imply an electron binding energy in the lowest excited state (ES-EBE) of the emitter molecule of no more than 2.0 eV, which might still yield a chemically stable emitter, yet stronger bound excited electrons are preferred.

No requirements on the second organic material (b) are needed to ensure electron confinement on the charge-neutral coordination compound, as Eu(I) is energetically not accessible. In other words, the typical coordination compounds comprising divalent Europium according to invention typically do not trap electrons. Or in yet other words: an excited divalent Europium would not create a charge transfer state by transferring a hole to a surrounding matrix, whilst leaving the excited electron on the coordination compound.

Yet, while electron transfer from the second organic material (b) to the metal-organic coordination compound (a) is unlikely, excitation energy transfer from the metal-organic coordination compound to the second organic material may occur. Therefore, the second charge-neutral organic compound (b) has a triplet energy that is higher than the emission energy of the coordination compound (a).

In passing, we note that the multiplicity of the coordination compound in both, its ground state and first electronically excited state is neither a triplet nor a singlet but, as already mentioned above, a multiplet with seven unpaired electrons. The emission proceeds via the spin-conserving and thus parity- and Laporte-allowed 5d-4f transition: [Xe] 4f⁶5d¹6s⁰→ [Xe] 4f⁷5d⁰6s⁰. In contrast, for organic materials, the lowest electronic energy levels are in most cases the triplet levels. Therefore, to confine the energy on the emitting coordination compound the surrounding matrix has a higher triplet energy vs the emission energy of the coordination compound.

There are many possible ways to probe the triplet energy level of an organic molecule. A simple way is to use suitable quantum mechanical calculations. Experimentally, the onset or the peak of the phosphorescence spectrum is taken as triplet energy, which is usually detected using gated spectroscopy, as pioneered by Romanovskii et al. "Phosphorescence of π-conjugated oligomers and polymers." Physical Review Letters 84.5 (2000): 1027. Without limiting the general scope of the invention, a very modest selection of possible organic materials that might be present as second organic material (b) as part of a mixture or in an adjacent layer used in an electroluminescent device according to the invention is illustrated as H1 to H23 in **FIG. 5** and some of their corresponding triplet levels are given in **Table 5** below. Similarly, calculated energies of the first excited state of various coordination compounds are tabulated in **Table 4** below. In preferred embodiments, the emission layer used in the electroluminescent device according to invention emits in the deep blue spectral region substantially at wavelength shorter than 496 nm, preferably less than 477 nm, most preferably less than 459 nm. Consequently, the second organic compound (b) has preferably a triplet energy higher than 2.5 eV, preferably higher than 2.6 eV and most preferably higher than 2.7 eV to still ensure sufficient energy confinement on the coordination compound. In this context, "substantially" means that at least 50%, preferably at least 65%, more preferably at least 80% of the emission or of the integral under the wavelength emission spectrum are below the above thresholds and/or that the peak of a Gaussian emission spectrum is a shorter wavelength compared to the preferred boundary wavelength defined above.

While the coordination compound (a) in its first electronically excited state will not transfer a hole to the nearby matrices (for example (b)), it might transfer an electron leaving behind the positively charged coordination compound comprising Eu(III). For high emission efficiency from the coordination compound, such a transfer of charge/electrons from the excited emitter molecule is preferably prevented by confining the excited electron to the coordination compound (a). Therefore, the preferred second charge-neutral organic material (b) being in physical contact with coordination compound (a) via an interface or via a mixture forming the emission in the electroluminescent device according to the invention has an electron affinity that is lower than the electron binding energy of the coordination compound in its lowest electronically excited state (ES-EBE). In this context, electron affinity is associated with the energy of the lowest unoccupied molecular orbital (LUMO) of the organic material.

Similar to hole transport, also electron transport levels of organic materials can easily be probed by a wide variety of methods. Again, quantum chemical calculations are most straightforward and cyclic voltammetry in solution offers experimental access, though with some limitations since the measurement takes place in solution environment and not in a thin film, which may significantly affect those levels. For some of the materials illustrated as H1 to H23 in **FIG. 5****,** the corresponding electron affinities are quoted in **Table 5** while calculated electron binding energies of various electronically excited coordination compounds are provided in **Table 4** below. As explained previously, chemically stable mixtures that efficiently emit light are generally obtained for materials where the charges are confined to the emitter (a). Thus, it is preferred that the second organic compound (b) has an electron affinity higher than 2.0 eV.

Up to this point, the situation was explored where the emitting molecule (a) is in physical contact with one host material (b). However, in state-of-the-art electroluminescent devices the emitting molecule is often in physical contact with not just one, but two or more charge neutral materials. In one embodiment the emitting coordination compound (a) is imbedded into a co-host formed by a second charge neutral material (b) and a third charge neutral material (c). In this situation the emitter is in physical contact with two more materials. With this particular embodiment in mind, it may be specified such that the second material (b) is configured as predominantly hole transporting, while the third material (c) is predominantly electron transporting. In such a situation, the electron transporting material has preferably the lowest LUMO and the hole transporting material the highest HOMO of the two charge transport materials, respectively. In other embodiments, the second charge neutral material (b) may be ambipolar, capable of transporting both, electrons, and holes, whilst the third material (c) is either ambipolar too, or predominantly hole transporting, or predominantly electron transporting, or is a wide bandgap material with low ability to transport charges that predominantly serves a function different than charge transport. In another embodiment, there is a first organic layer comprising the emitter (a) and being embedded into a second host (b), and this first organic layer is adjacent to a second organic layer comprising a third organic material (c). In this embodiment the emitter (a) is in physical contact with at least one second charge neutral material, for example a host (b) within the bulk of the first organic layer, while at the interface between the first and the second organic layer the emitting coordination compound (a) is in physical contact the second and the third organic materials (b, c).

In all the embodiments described in the above paragraph, the coordination compound (a) is simultaneously in physical contact with two or more charge neutral organic materials (b, and c, aso). In preferred embodiments, the same requirements that are described above for a single organic material (b) are preferably fulfilled for each of the organic charge neutral materials individually being in contact with the emitting material (b). In particular, preferred is still electron confinement on the emitting material for high emission quantum efficiency; thus, all further second charge-neutral organic compound (b, c, aso) each individually should have preferably an electron affinity that is lower than the electron binding energy of the coordination compound (a) in its lowest electronically excited state, preferably higher than 2.3 eV, more preferably higher than 2.5 eV, and most preferably higher than 2.7 eV. Similar, the coordination compound (a) should be preferably hole trapping within the whole ensemble of materials present; thus, the further present charge-neutral organic compounds (b, and c, aso) each individually have preferably a higher electron-binding-energy than the charge-neutral metal-organic coordination compound (a), preferably higher than 4.5 eV, more preferably higher than 5.1 eV, and most preferably higher than 5.7 eV. And finally, preferred embodiments ensure energy confinement on the - preferably deep blue emitting - coordination compound (a); thus, the further present organic compounds (c, aso) each individually have preferably a triplet energy that is higher than the emission energy of the coordination compound (a), preferably, each of the further organic compounds (b, c, aso) has a triplet energy higher than 2.6 eV, more preferably higher than 2.7 eV, and most preferably higher than 2.8 eV.

Two organic materials with different energy levels may as well form meta-stable excited states, typically called exciplex. In such a charge-transfer state, the electron residues on the material with the lower LUMO, while the hole is confined on the material with the shallower HOMO. Such states are commonly observed in co-host organic systems, where one of the two hosts is specifically designed to transport electrons and exhibits a comparably low LUMO, while the other organic material is designed for hole transporting and thus features a comparably shallow HOMO level. The charge transfer state, i.e. the exciplex, may form between those shallow HOMO and deep LUMO between the two materials and may or may not be emissive. Because it is an excited state, this changes little with respect to charge confinement on the coordination compound (a) within its plurality of host materials (b, c, and so on). Yet for energy confinement, it is not sufficient to just have the triplet level of each host material (b, c, and so on) above the emission energy of the coordination compound (a). Additionally, as well the energy of the CT state, i.e. the energy of the exciplex that might form between a pair of host materials (b and c) present in the vicinity of the coordination compound (a) has to be higher than the emission energy of the coordination compound (a), to still ensure good energy confinement on the emitter and thus high emission quantum efficiency. Keeping in mind that the exciplex energy can be approximated by the HOMO-LUMO difference of the two host materials (b and c) involved, this preferred requirement can be expressed in terms of the HOMO-LUMO difference within the co-host vs the emission energy, i.e. the energy difference between the HOMO of the second charge-neutral organic compound (b), and the LUMO of the third charge-neutral compound (c), and/or the energy difference between the HOMO of the third charge-neutral organic compound (c) and the LUMO of the second charge-neutral compound (b) are preferably higher compared to the emission energy of the coordination compound (a) in its lowest electronically excited state, preferably wherein said energy difference is higher than 2.6 eV, more preferably higher than 2.7 eV, and most preferably higher than 2.8 eV.

Generally, the exact scientific nature (or name for that matter) of any potentially accepting energy level in the near vicinity of the excited coordination compound (a) is not relevant. It is desirable that the energy of the possible accepting level (whatever its specific nature) is higher than the emission energy of the coordination compound (a) in the first excited state. The potentially accepting level may for example be the ground state absorption of a certain electrical dopant molecule or metal used in the design of the device. Or the potentially accepting level may be the ground state absorption of a dimer formed by two identical molecules. The potentially accepting level may as well be polaron absorption by a positively or negatively excited host organic host molecule. Whatever the exact nature of those ground- or excited absorbing states - in each case it is required that the absorption energy of this state is higher than the emission energy of the coordination compound in its first electronically excited state.

In organic amorphous solids, such as predominantly found in electroluminescent devices, the individual organic molecule is typically imbedded within the layer in a rather unique way, depending on the exact nature and position of all neighbouring molecules. Similar, certain molecular degrees of freedom that do exist on a single molecule level, such as rotation degrees, might be frozen once the molecule becomes packed into an organic layer. Those typical features of amorphous organic layers contribute to inhomogeneous broadening of -for example- the conjugation length. Therefore, energy levels of organic layers, such as triplet energy or HOMO or LUMO energy are typically not sharp distinct single values, but instead fluctuate around a mean value depending on position within the layer. In scientific literature, a Gaussian Distribution is frequently taken as approximation of this energy distribution function, typically referred to as Density of States or DOS. Within this disclosure energy values are typical referred to as a fixed individual value and this is a good approximation, if the density of states is comparably narrow such that terms like "higher as" or "lower as" are meaningful because the two density distributions do not substantially overlap.
This simple situation is illustrated on the left of Fig. 17 as (a). Yet, the middle picture (b) illustrates the more realistic case, where two materials with significant wide DOS are compared. The centre of the DOS still has the same offset as in picture (a), i.e. the energy of one material is still "higher" as compared to the other one. However, this is clearly not for all pair wise materials combinations within the organic layer the case. Generally preferred are energetic situation that hold true within most of the organic layer. For example, with respect to triplet energy confinement, the energy of the excited state of the emitter may be below the centre of the DOS of the triplet energy of a certain surrounding host, as illustrated in the middle, (b) above. Yet, typically triplet levels are broadened by about 100meV, therefore preferred is that the triplet energy of the host is even 0.1eV and even more preferred 0.2eV above the energy of the excited state of the coordination compound. This is illustrated by figure (c), where the same width as in figure (b) is used, but the energy difference is now sufficient, such that a clear energetic order between the two materials is established in nearly all cases.

The combination of unique emission properties of the particular described divalent Europium coordination compounds with the ease of processing makes those coordination compounds highly attractive for application in organic electronic devices. In this description, an organic electronic device may be any device or structure including substantially organic layers or subunits, where an electro-magnetic stimulus may be converted into an electrical field or current or vice versa, or where an input electrical current or electrical field may be used to modulate an output electrical current or electrical field.

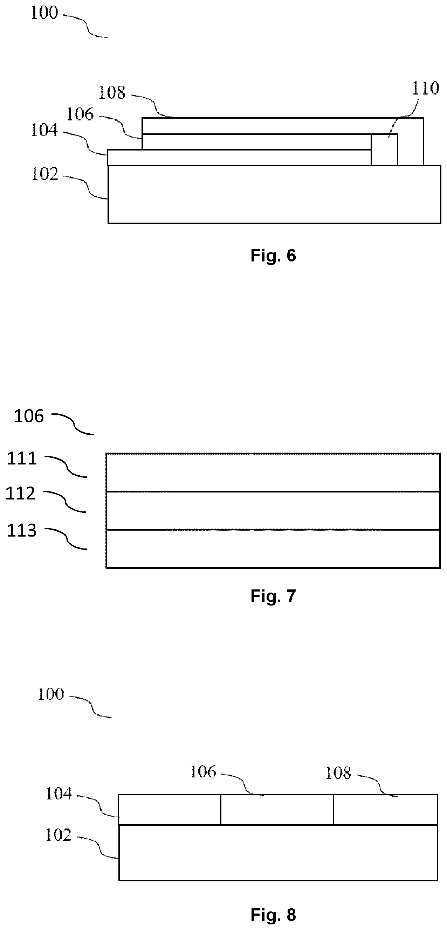

**FIG. 6** and **FIG. 8** illustrate embodiments of an organic electronic device 100 configured as optically active device. The organic electronic device may include a first electrode 104, e.g., on a substrate 102 or as the substrate; a second electrode 108; and an organic layer 106 arranged such that it is electrically interposed between the first and second electrodes 104, 108. The first and second electrodes 104, 108 may be electrically insulated from each other by an insulating structure 110, e.g. a resin or polyimide. The first and second electrodes 104, 108 may be stacked over each other (FIG. 6) or may be arranged in a common plane (FIG. 8).

The organic layer 106 may include the coordination compound according to claim 1 or to any of the described or illustrated embodiments, e.g., the layer may contain just the coordination compound, or the layer might comprise of further organic or non-organic materials. The organic layer may be a single layer or contain a plurality of sublayers. **FIG. 7** illustrates the situation where the organic layer 106 comprises a plurality of sublayers 111, 112, and 113. The coordination compound according to claim 1 may be part partly or exclusively contained in one or more layers present in the overall organic layer 106.

In this invention, the organic electronic device 100 is configured as ar organic electroluminescent device.

The organic layer 106 is arranged electrically between the first and second electrodes 104, 108, such that an electronic current may flow from the first electrode 104 through the organic layer 106 to the second electrode 108 and vice versa during operation, e.g., in light emission applications. Alternatively, in photoelectric applications, a charge carrier pair may be formed in the organic layer 106 and charge carriers of the charge carrier pair may be transported to the first and second electrodes 104, 108 respectively. In other words, in light emission applications, upon application of sufficient voltage, holes and electrons are injected from the anode and the cathode, respectively, and drift towards the organic layer 106, where charges of opposite sign recombine to form a short-lived localized excited state. The short-lived excited state may relax to the ground state thereby giving rise to light emission.
The first and second electrodes 104, 108 may be substantially unstructured layers, e.g., for general lighting applications, or may be structured, e.g., for light emitting diodes or transistors for pixels in a display application.

The organic electronic device 100 may be configured to emit substantially monochromatic light such as red, green, blue, or polychromatic light such as white. The light may be emitted through the first electrode 104 (bottom emitter), through the second electrode 108 (top emitter), or through first and second electrodes 104, 108 (bidirectional emitter). The light may as well be substantially emitted in a direction parallel to the organic layer 106 using suitable opaque electrodes 104, 108. In such a layout, lasing may be achieved, and the device may be an organic laser, which, in this description, may be considered as a specific type of electroluminescent devices.
The mixtures according to various embodiments may have excellent emission properties, including a narrow deep blue emission spectrum with short excited state lifetime. Given their high atomic weight and open shell electronic structure, the optical transitions of Eu(II) complexes are widely indifferent to excitation with either spin 1 or spin 0 electron-hole pairs. In other words, both singlet and triplet excitations are harvested, resulting in very efficient light emission. As such, the mixtures according to various embodiments may be ideally suited for application in organic electroluminescent devices, such as organic light emitting diodes (OLED). In this description, an electroluminescent device may be any device including an organic layer disposed between and electrically connected to an anode 104/108 and a cathode 108/104. Upon application of sufficient voltage, holes and electrons may be injected from the anode 104/108 and the cathode 108/104, respectively, and drift towards the organic layer 106, where charges of opposite sign recombine to form a short-lived localized excited state. The short-lived excited state may relax to the ground state thereby giving rise to light emission. Relaxation pathways without light emission, such as thermal relaxation, may be possible too, but may be considered undesirable, as they lower the conversion efficiency of current into light of the device. Organic light emitting cells (LECs) may be considered as a subclass of OLED devices comprise of mobile charged species inside the active organic layer 106, which are able to drift inside an external applied electrical field. As such OLEDs encompass LEC type devices.

Further layers may be formed and in electrical connection between the first and second electrodes 104, 108, e.g., configured for charge carrier (electron or hole) injection, configured for charge carrier transport, configured for charge carrier blockage or configured for charge generation. For example, FIG. 7 may represent the situation where the coordination compound disclosed in claim 1 or any other part of this description is present in layer 112 whereas the nearby layers 111 and or 113 may be configured as charge transport or charge blocking layers. The recombination of electrons and holes may as well happen at the interface of the organic layer 106, which contains the coordination compound according to the invention and an adjacent layer, such as an electron blocking layer. For example, in case layer 112 depicted in FIG. 7 contains the mixture according to invention comprising a hole transporting second organic materials and the layer in physical contact 111 is configured to be an electron transporting layer, then charge recombination may happen at the interface between layer 111 and 112 with subsequent energy or charge transfer to the coordination compound present in layer 112. Further optically functional layers, e.g., a further electroluminescent material and/or a wavelength conversion material may be formed electrically between the first and second electrodes 104, 108 and in the optical path of the organic layer 106, e.g., on top of the second electrode 108 and/or on the opposite side of the substrate 102. In addition, encapsulation structures may be formed encapsulating the electrically active area, e.g., the area in which electrical current flows and may be configured to reduce or avoid intrusion of oxygen and/or water into the electrically active area. Further optically functional layers, e.g., an antireflection coating, a waveguide structure and/or an optical decoupling layer may be formed within the optical light path of the organic layer 106.

For example, hole or electron blocking layers may be used to optimize the individual hole and electron currents through the organic electronic device 100. This may be known to those skilled in the art as charge balance in order to optimize efficiency and operational stability. In various embodiments, dedicated hole or electron charge transport layers may be present in the organic electronic device 100 to space the emission region from the first and second electrodes 104, 108. For example, layers 111 and or 113 depicted in FIG. 7 may be configured as electron - and or hole blocking layer, while layer 112 contains the coordination compound according to the invention.

Examples of hole transport materials include known materials such as fluorene and derivatives thereof, aromatic amine and derivatives thereof, carbazole derivatives, dibenzofuran, dibenzothiophene, and polyparaphenylene derivatives. Examples of electron transport materials include oxadiazole derivatives, triazine derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and its derivative, diphenoquinone derivatives, and metal complexes of 8-hydroxyquinoline and its derivatives and various derivatives of silanes. Fig. 5 depicts a very limited selection of possible host materials for illustration purpose.

In various embodiments, those charge transport layers may include electrical dopant molecules or metals or may be in contact to charge injection layers.
Any of those auxiliary layers may be fully organic or may include inorganic functional moieties. For example, charge transport layers may be made of the class of Perovskite materials.

In case that the charge recombination occurs substantially close to or at the interface of the organic layer comprising the coordination compound according to the invention with a nearby charge transport or blocking layer then it is preferred that the organic materials being present in the charge transport or blocking layer have a higher electron binding energy than the charge-neutral coordination compound, and/or having a higher triplet and/or a higher exciplex energy compared to the emission energy of the coordination compound in its lowest electronically excited state, and/or having an electron affinity that is lower than the electron binding energy of the coordination compound in its lowest electronically excited state. This ensures that both charges and energy are confined on the coordination compound according to the invention instead of transferring to the nearby organic layer. For example, in case layer 112 depicted in **FIG. 7** contains the coordination compound according to the invention (a) and comprising a hole transporting second organic material (b) and the layer in physical contact 111 is configured to be an electron transporting layer, then charge recombination may happen at the interface between layer 111 and 112. In this situation it is preferred that those organic materials present in layer 111 (c, and so on) have a higher electron binding energy relative to the neutral coordination compound (a) present in the mixture in layer 112. Therefore, positive charges that may be present in the mixture in layer 112 do not transfer significantly to the organic layer 111. Further preferred is a higher triplet and/or exciplex energy and/or an electron affinity that is lower than the electron binding energy of the coordination compound in its lowest electronically excited state. Thus, in this preferred arrangement of layer 111 and 112, electrons, holes, and energy are confined on the coordination compound (a) being present in layer 112 instead of transferring to the organic materials present in layer 111.
The coordination compound according to the invention as illustrated or described in any one of the embodiments may be used as a thin substantially organic emission layer 106 of any thickness in the range of 0.1 to 100 nm, preferably in the range of 3 to 20 nm. The concentration of the coordination compound throughout the cross section of the organic layer may be constant or varied. Typical variable concentrations are in the range of 0 to 100 vol%, i.e., the layer may be partially containing either no coordination compound or just coordination compound. Such situations are indeed frequently observed if laterally movable evaporation sources are employed to co-sublime the organic material with the coordination compound. The emission layer 106 may as well be configured as a plurality of mixtures according to the invention having different concentrations of coordination compound. For example, in **FIG. 7****,** layer 111, 112, and 113 may all contain a second charge neutral organic host material (b) and the three layers may contain 0, 3, 20 vol% of the metal-organic coordination compound (a), respectively. The emission layer 106 may as well be configured such that the metal organic coordination compound (a) is present in two adjacent layers, for example 112 and 113 depicted in **FIG. 7****,** but two different charge neutral organic host materials (b, and c) are present in both layers. It may for example be a substantially hole transporting material (b) in layer 112, yet a substantially electron transporting organic material (c) in layer 113.

The requirements for adjacent organic materials are similar if the coordination compound has a very high volume or weight or molar concentration. In the extreme case, a guest-host emission layer may contain only 1% or less or the second organic material (b), i.e., it is a substantially pure layer containing the divalent Europium coordination compound (a), disclosed in claim 1 and in the description. It might for example be beneficial to avoid co-deposition but instead to sandwich a nearly pure and thin layer of the coordination compound (a) within two suitable organic layers (for example of same type, (b) or different type (b, and c). In such a situation the substantially pure layer containing the coordination compound (a) may be rather thin, i.e., between 0.2 to 10 nm, preferably 1 to 3 nm. The interface of such a substantially pure layer of coordination compound (a) with the adjacent organic layers containing material b and or c classifies as a situation where the coordination compound is "in close proximity" or in the "vicinity" or in "physical contact" with the organic materials labelled c and b. The situation is further illustrated by referring to **FIG. 7****.** Here, layer 112 may be configured as substantially pure layer of coordination compound (a), while layer 111 and or layer 113 may contain organic materials, in particular charge transport or charge blocking materials. In such situation, it is preferred that the organic materials (b, c, and so on) being present in the charge transport or blocking layer 111 and or 113 have a higher electron binding energy than the charge-neutral coordination compound, and having a higher triplet energy compared to the emission energy of the coordination compound (a) in its lowest electronically excited state, and having an electron affinity that is lower than the electron binding energy of the coordination compound in its lowest electronically excited state. Similar, if one or both of the layers 111 and 113 comprise a co-host system comprising of two organic materials (b, and c) than their pairwise exciplex energy is preferably higher than the energy of the coordination compound (a) in its first electronically excited state. This preferred set of rules ensures that both charges and excitons are confined on the coordination compound being present in layer 112 instead of transferring to the nearby organic layers.

The second organic material (b) that is present in the organic layer 106 may in various embodiments be a charge transport material to improve charge transport into and through the organic layer 106 or to facilitate charge recombination. Charge transport materials may be any material that are able to transport either holes or electrons or both types of charges upon applying a suitable electrical field. In particular a charge transport material may be any aryl, or heteroaryl organic compound or any metal complex or any mixture thereof. Examples of materials present in the light emitting layer 106 include carbazole derivatives, including carbazole-phosphine oxide materials, oxadiazole derivatives, triazine derivatives, silane derivatives and any other material or combination of materials with sufficiently high triplet level that may transport charges or otherwise benefit the device performance. Without limiting the scope of the invention, a small selection of possible charge transport materials is depicted as H1 to H23 in **FIG. 5****.**

The organic layer 106 that contains the mixture according to the invention may contain any further organic or inorganic material in a range of 0.1 to 99.0 vol% that is not intended to transport charges. For example, the organic layer 106 may include polymers (in a mixture or as a compound) which may be added to improve film quality and prevent crystallization. Other materials may be added to evenly space the coordination compound inside the organic layer 106.

According to various embodiments guest-host systems comprising the coordination compound (a) and a second charge neutral material (b) may both be processed using vacuum based techniques. In other words, the evaporation temperature of the coordination compound (a) and the second, preferably organic, material (b) may be sufficiently low to allow for thermal vacuum processing techniques to be used. Reduced evaporation temperatures can be achieved according to the invention by using the metal-organic coordination compounds with their size discriminating macrocyclic ligand as here the ionic character of the compounds is strongly suppressed, if compared to similar organic salts based on other, for example polycyclic and or different sizes ligand design. Consequently, the evaporation temperature is reduced and incorporation into organic electronic devices becomes possible using state-of-the-art vacuum deposition techniques.

In various embodiments, the organic electronic device 100 includes two or more subunits each including at least one light emitting layer. The subunits may be stacked over each other physically separated and electrically connected by a charge generation layer or, alternatively, may be arranged side by side. The subunits may be subpixels of a pixel in a display or general lighting application. The light emitted by the subunits may be mixed to generate a light of a predetermined color. Each subunit may emit light of the same or a different color. The overall light emitted by such organic electronic device 100 may contain a narrow spectral region, such as blue, or may contain a wide spectral region such as white, or a combination thereof. The coordination compound according to the invention comprising the divalent Europium compound illustrated or described in any one of the embodiments may or may not be present in all subunits of the organic electronic device 100.

In various embodiments, the light emitted by the organic electronic device 100 may be in optical contact to at least one optically active layer, including any optically active materials such as organic molecules or quantum dots. The optically active layer may be a spectral filter element, which may absorb part of the light emitted by the organic electronic device 100. In another embodiment, the optically active layer may absorb at least part of the light emitted by the organic electronic device 100 and may reemit it at longer wavelength (wavelength conversion), e.g., by quantum dots. As example, the organic layer 106 may be configured to emit light substantially at wavelengths shorter than 500 nm and the optically active layer may be configured to substantially reemit light at wavelengths longer than 500 nm. The optically active layer may be placed in between the anode and cathode of the organic electronic device 100 or outside of it. The optically active layer may as well be part of the organic layer 106.

In one embodiment according to the invention, the organic electronic device 100 is configured as a large area OLED device with intended use for illumination, signage, or as a backlight. In another embodiment, the organic electronic device 100 may include a plurality of OLEDs arranged in a pixelated layout (plurality of OLED pixels) that are individually electrically connected, e.g., for flat panel display applications. Here, individual pixels may have the capability of emitting light of substantially narrow spectral portions; especially of red, green, and blue. The mixture may or may not be present in any of the individual pixels.

In another embodiment, the individual pixels may be configured to emit white light. Red, green, and blue spectral portions are generated by using suitable filter elements in optical contact with the respective pixelated OLEDs.

In another embodiment, the OLED pixels emit blue light, and the red and green spectral portions may be generated by using a suitable color conversion element in optical contact with the OLED pixels.

In another embodiment, the OLED pixels emit substantially in the near-UV spectral region with wavelength < 450 nm and the red and green and blue spectral portions may be generated by using a suitable color conversion element in optical contact with the OLED pixels.

In various embodiments, the organic electronic device 100 includes an anode 104; a cathode 108; and an organic layer 106 disposed between the anode 104 and the cathode 108. The organic layer 106 includes a coordination compound according to various embodiments. The coordination compound includes - divalent Europium coordinated by a macrocyclic organic ligand according to the present invention having 12 to 48 macrocyclic atoms.

An organic electronic device 100 according to various embodiments may be fabricated using a wide range of commonly used techniques, including, but not limited to, deposition of all or some layers, from gas phase vacuum deposition, solution phase, or gas phase using a carrier gas method.

Due to the high symmetry of the macrocyclic ligands many Europium organic complexes according to the invention show a relatively low dipole moment allowing for thermal deposition from gas phase with high yields. Thus, in various embodiments, deposition via the gas phase in vacuum may be used, whereby the coordination compound may either undergo sublimation or evaporation and may or may not be co-deposited with a second organic material able to form a guest-host system. The coordination compounds according to the invention show an improved sublimation/evaporation yield. The transfer into the gas phase may be improved by using a carrier gas technology, whereby an inert gas that may not be deposited into the organic layer comprising the coordination compound may be helping the sublimation or evaporation of the coordination compound or the guest-host system to be deposited. During the deposition process from gas phase, the coordination compound may be co-deposited with a second organic material using two separate thermal sources, in other words, the guest-host film is formed in-situ after deposition. During such co deposition two or more additional materials may be deposited using a triple or quadruple evaporation, whereby the coordination compound according to the invention might be further diluted within the mixed layer to be deposited. Alternatively, the guest-host system may as well be thermally processed from one crucible. In other words, a mixture or a precursor thereof is already present before sublimation or evaporation. A precursor may for example be an additional auxiliary ligand present as part of the coordination compound that dissociates during thermal evaporation and that is substantially not built into the organic layer comprising the coordination compound according to the invention. Preferred in this situation are similar volatilities for the second organic material (b) and the coordination compound (a). Alternatively, the coordination compound (a) and the second organic material (b) may form a frozen glass, thereby forcing the individual components to sublime at similar temperatures.

Another preferred technique to fabricate layers including the coordination compounds according to various embodiments may be deposition from a liquid phase using a mixture of or a single organic solvent, whereby the coordination compound according to various embodiments may be dissolved or forms a suspension within the organic solvent; in this description may be referred to as the ink. The ink using this deposition process may include a wide variety of other materials apart from the coordination compound according to various embodiments to allow fabrication of triple or higher-order mixed layers from solution. Additives within the ink may for example, but may not be limited to, be organic or inorganic materials capable of transporting charges, materials that improve the film formation, materials that improve the distribution of the coordination compound within guest host layer, organic or inorganic materials that improve the efficiency of the device, e.g., by reducing the refractive index. The deposition from solution may not be limited to any specific technique. Examples of the deposition from solution include spin coating, casting, dip coating, gravure coating, bar coating, roll coating, spray coating, screen printing, flexographic printing, offset printing, inkjet printing. The low dipole of the coordination compounds according to the invention generally improves their solubility in organic solvents with low polarity index, which is generally considered advantageous. In particular, solvents with relatively low polarity index such as tetrahydrofuran or toluene or hexane may be used as part of the ink formulation.

Various post processing techniques may be applied to improve the performance or stability of the organic electronic device. In one embodiment, some or all layers of the organic electronic device include functional groups capable of chemically crosslinking upon thermal or optical exposure thereby forming larger covalently bound molecules with improved physical properties. In another embodiment the functional groups are present on a second organic material (b) and after crosslinking the second organic material becomes a polymer. In yet another embodiment the functional groups capable of crosslinking are present on both, the coordination compound (a) and the second organic material (b), and after crosslinking, a single polymeric material comprising both materials is formed.

In various embodiments, the coordination compound according to the invention may be formed in-situ using deposition from solution. Here, the organic macrocyclic ligand of the present invention excluding the divalent Europium, may first be deposited onto a suitable substrate or other organic layer thereby forming a seed layer. Any suitable technique may be used to fabricate this seed layer. This seed layer including the organic ligand may include any further material. Preferred may be further additional inert organic or inorganic materials that aid the layer formation or improve its thermal stability or improve the distribution of the organic ligand or second organic material within this seed layer. In a next deposition step and sequential to forming the seed layer including the organic ligand excluding the metal, a layer including a molecular salt comprising the divalent Europium may be fabricated using a solution process. The Europium compound may be any charge neutral compound including Eu(II) and one or two suitable anions. The anions may as well be covalently bound to a suitable polymer. The ink including the Europium compound may as well include one or more additives to fabricate mixed layers. These additives may be organic or inorganic materials to aid charge transport, may be organic or inorganic materials that improve the efficiency of the device, or may be any material that improves the film formation. At the interface of the seed layer including the organic macrocyclic ligand, the solubilized divalent Europium compound will interact with the macrocyclic organic ligand thereby forming the coordination compound according to various embodiments in-situ. Alternatively, the process of first forming the layer containing the ligand and secondly processing the lanthanide compound may be inverted.

For one or more aspects, at least one of the components set forth in one or more of the preceding figures may be configured to perform one or more operations, techniques, processes, and/or methods as set forth in the example section below.

### EXAMPLES

The examples set forth herein are illustrative and not exhaustive.

Any of the examples may be combined with any other example (or combination of examples), unless explicitly stated otherwise. The foregoing description of one or more implementations provides illustration and description but is not intended to be exhaustive or to limit the scope of aspects to the precise form disclosed. Modifications and variations are possible in light of the above teachings or may be acquired from practice of various aspects.

### I Synthesis of various divalent Europium coordination compounds with macrocyclic ligands and their characteristics

All coordination compounds synthesized are hereafter referred to as E1 to E22. Their chemical structures are depicted in **Fig. 4****.**

All experimental manipulations were carried out under an inert atmosphere. Tetrahydrofuran (Acros Organics, extra dry, AcroSeal) was dried and distilled from K/benzophenone or purchased as anhydrous from Acros Organics. Toluene (Acros Organics, Extra Dry, AcroSeal) was purchased as anhydrous from Acros Organics, Methanol (Acros Organics, Extra Dry, AcroSeal) was purchased as anhydrous from Acros Organics. Europium(II) iodide, Europium(II) bromide and Europium(II) chloride (Aldrich, AnhydroBeads, 10 mesh, 99.999% trace metals basis) were used as purchased. 1,4,7,10,13,16-Hexaoxacyclooctadecane (Aldrich, 99%), 2,3,11,12-dibenzo-1,4,7,10,13,16-hexaoxacyclooctadeca-2,11-diene (Aldrich, 98%), 1,4,10,13-tetraoxa-7,16-diazacyclooctadecane (Aldrich, ≥96%) and 1,4,7,14,17,20-hexaoxa[7.7]orthocyclophane (Aldrich, 98%) were sublimated before the use. 1,7,13-Trioxa-4,10,16-triazacyclooctadecane and 1,4,10,13-tetraoxa-7,16-dithiocyclooctadecane (purity ≥96%) were purchased from Chemieliva. Trimethylammonium carbadodecaborate and triethylammonium closo-1-carbadecaborate (Katchem, >97%) were used as purchased. 6,9,12-Trioxa-3,15-diaza-1(2,5)-furanacyclohexadecaphane was prepared according to a published procedure (dx.doi.org/10.1021/jo501966q I J. Org. Chem. 2014, 79, 10334-10341). Synthesis of bis[bis(trimethylsilyl)amide] bis(tetrahydrofuran) europium(II) (Eu(HMDS)₂) and europium(II) tetraphenylborate is described in WO2021244801A1.

### Europium(II) (bis-tetrahydrofurane) carbadodecaborate:

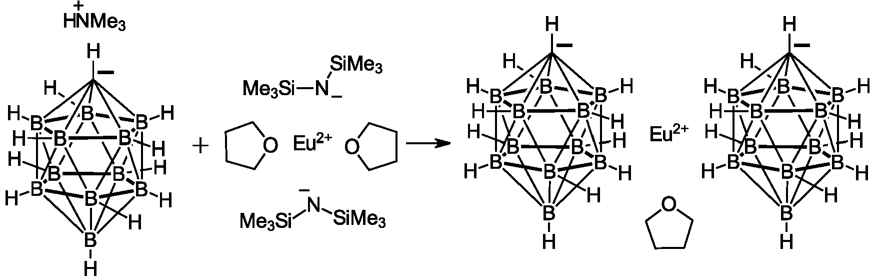

A solution of 5.76 mmol (2.0 eq., 1170mg) trimethylammonium carbadodecaborate in 20 ml THF was dropwise combined with a solution of 2.88 mmol (1.0 eq., 1777mg) europium(II)[bis(trimethylsilyl)amido]bis(tetrahydrofuran) in 40 ml THF. The resulting suspension was stirred for 1 h at room temperature and then filtrated. The resulting powder was washed with THF and dried under reduced pressure. Yield: 97 %. This compound, europium(II) (bis-tetrahydrofuran)carbadodecaborate, is used in the synthesis of **E1, E5, E18, E19** and **E20.**

### Europium(II) (bis-tetrahydrofurane) closo-1-carbadecaborate:

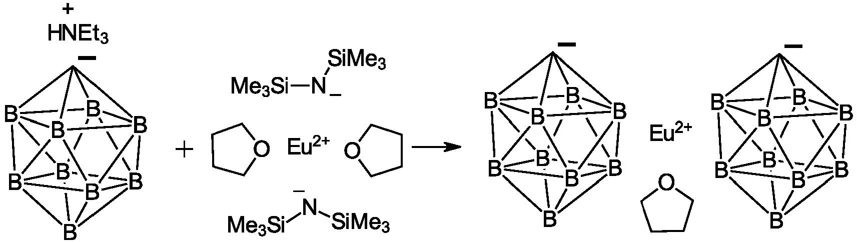

It was prepared analogously to europium(II) (bis-tetrahydrofurane) carbadodecaborate from europium(II)[bis(trimethylsilyl)amido]bis(tetrahydrofuran) and triethylammonium closo-1-carbadecaborate and used in the synthesis of **E11.** Yield: 95 %.

### E1: and general synthetic procedure for preparation of coordination compounds E5, E18 to E20.

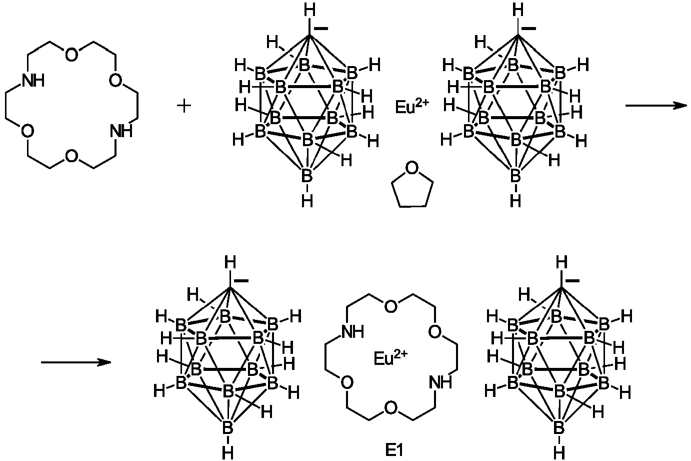

A solution of 1.85 mmol (1.0 eq., 486mg) 1,4,10,13-tetraoxa-7,16-diazacyclooctadecane (for the synthesis of E1), or respective amounts of other crown ligands, in 20 ml toluene was dropwise added to a solution of 1.85 mmol (1.0 eq., 945mg) europium(II) (tetrahydrofuran)carbadodecaborate in 120 ml toluene. The resulting suspension was stirred for 1 h at room temperature. The solvent was removed in vacuum. The resulting solid powder was washed with diethyl ether. Yield: 77 %. Resulted powder was sublimated at 310°C (1.66E-6 mBar), yield 90%. **MS (ESI):** m/z = 557.6 (M - CB₁₁H₁₂)⁺; 285.4 (free crown + Na⁺)⁺; 263.4 (free crown + H⁺)⁺; 238.7 (M - 2 CB₁₁H₁₂⁻ + 2MeOH)²⁺; 223.7 (M - 2 CB₁₁H₁₂⁻ + MeOH)²⁺. Elemental Analysis. Calc.: C, 24.01; H, 7.20; N, 4.00. Found.: C, 23.83; H, 7.14; N, 4.06. Yields and analytical data for compounds **E5, E18 to E20** see in Table1.

**E2: and general synthetic procedure for preparation of coordination compounds E8, E10, E12, E21 and E22.** A solution of 0.91 mmol (1.0 eq., 368mg) europium(II) iodide in 11 ml THF was added dropwise to a solution of 0.91 mmol (1.0 eq., 240mg) of 1,4,7,10,13,16-hexaoxacyclooctadecane for preparation of E2, or other ligands for preparation of E8, E10, E12, E21 and E22, in 20 ml THF. The resulting suspension was stirred for 1 h at room temperature and then filtrated. The resulting powder was washed with THF and dried in vacuum at room temperature. Yield in the case of E2 is 501 mg (82.3 %).

### Synthesis of trimethylammonium 12-chloro-1-carbadodecaborate

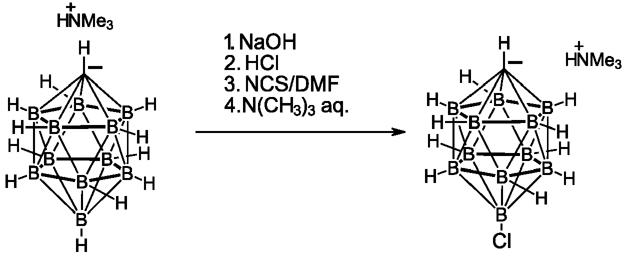

Trimethylammonium carbadodecaborate (1 eq, 4 g, 19.7 mmol) is dissolved in 15 ml of 10% sodium hydroxide. The clear solution is stirred and heated under reduced pressure until released trimethylamine is removed. The solution is cooled with an ice bath, acidified with concentrated hydrochloric acid (pH 1-2) and extracted with diethylether (2x50ml). Combined extracts are evaporated to dryness on rotation evaporator. Residue is dissolved in DMF (20ml), cooled down to -10ºC, the solution of N-chlorosuccinimide (0.9 eq, 2.37 g, 17.7 mmol) is added dropwise. The cooling bath is removed, reaction mixture is stirred at room temperature for 1 h. Solvent is evaporated at reduced pressure, residue is dissolved in water and neutralized with an aqueous solution of trimethylamine resulting in precipitation of a product as a white powder. The crude product is separated by filtration, washed with water and dried. Purification of the product is achieved by re-crystallization from water. Yield: 3.4g (72.7%). ESI-MS (-): (M-TMA)- m/z: 177.16 (100.0%), 178.16 (80.5%), 176.17 (78.6%), 179.16 (62.3%).

**Europium(II)(tetrahydrofurane)12-chloro-1-carbadodecaborate**
was prepared analogously to **europium(II) (tetrahydrofurane)carbadodecaborate** from europium(II)[bis(trimethylsilyl)amido(bis-tetrahydrofurane) (0.5 eq, 2.86 g, 4.63 mmol) and trimethylammonium 12-chloro-carbadodecaborate (1 eq, 2.2 g, 9.26 mmol) in diethylehter in a quantitative yield. This compound was used in the synthesis of E3 and E16.

**E3:** was synthesized analogously to E1 by using 1,4,10,13-tetraoxa-7,16-diazacyclooctadecane and europium (II)(bis-tetrahydrofurane)12-chloro-1-carbadodecaborate. Yield and analytical data are given in Table 1

**E4:** was synthesized analogously to E2 from 1,4,10,13-tetraoxa-7,16-diazacyclooctadecane and EuBr2. Yield and analytical data are given in Table 1.

**E5** was synthesized analogously to E1 from 6,9,12-trioxa-3,15-diaza-1(2,5)-furanacyclohexadecaphane and europium(II) (tetrahydrofuran)carbadodecaborate. Yield and analytical data are given in Table 1.

**E6:** was synthesized analogously to E2 from 1,4,10,13-tetraoxa-7,16-diazacyclooctadecane and EuCl₂. Yield and analytical data are given in Table 1.

**E7:** A suspension of 0.54 mmol (1.0 eq., 195 mg) 2,3,11,12-dibenzo-1,4,7,10,13,16-hexaoxacyclooctadecane in 100 ml toluene was heated until it became a clear solution. This solution was added dropwise to a solution of 0.53 mmol (0.98 eq., 424 mg) europium(II) (tetrahydrofuran)carbadodecaborate in 60 ml toluene. The resulting suspension was stirred for 1 h at the elevated temperature. The solvent volume was reduced to 50 % in vacuum. The resulting suspension filtrated and the solid was washed with toluene and hexane. Yield: 95 %. Resulted powder was sublimated at 235°C (5.40E-7 mBar), yield 12%. **MS (ESI):** m/z = 656.3 (M - CB₁₁H₁₂⁻)⁺; 383.2 (free crown + Na⁺)⁺; 361.2 (free crown + H⁺)⁺; 288.6 (M - 2 CB₁₁H₁₂⁻ + 2MeOH)²⁺; 272.6 (M - 2 CB₁₁H₁₂⁻ + MeOH)²⁺.

**E8:** was synthesized analogously to E2 from 6,9,12-trioxa-3,15-diaza-1(2,5)-furanacyclohexadecaphane and europium(II) iodide. Yield and analytical data are given in Table 1.

**E9:** A solution of 0.54 mmol (1.0 eq., 202 mg) 2,3,11,12-dicyclohexano-1,4,7,10,13,16-hexaoxacyclooctadecane in 4.2 ml toluene was added dropwise to a solution of 0.53 mmol (0.97 eq., 420 mg) europium(II) (tetrahydrofuran)carbadodecaborate in 61 ml toluene. The resulting suspension was stirred for 1 h at room temperature. The solvent was removed in vacuum. The resulting solid powder was washed with toluene and hexane. Yield: 95 %. Resulted powder was sublimated at 335°C (1.00E-6 mBar), yield 58%. **MS (ESI):** m/z = 667.8 (M - CB₁₁H₁₂⁻)⁺; 395.5 (free crown + Na⁺)⁺; 373.5 (free crown + H⁺)⁺; 294.6 (M - 2 CB₁₁H₁₂⁻ + 2MeOH)²⁺; 278.9 (M - 2 CB₁₁H₁₂⁻ + MeOH)²⁺; 262.9 (M - 2 CB₁₁H₁₂⁻)²⁺. Elemental Analysis. Calc.: C, 32.60; H, 7.46. Found.: C, 32.62; H, 7.30.

**E10:** was synthesized analogously to E2 from 18-crown-6 and europium(II) iodide. Yield and analytical data are given in Table 1.

**E11:** was prepared analogously to E1 from 1,4,10,13-tetraoxa-7,16-diazacyclooctadecane and europium(II) (bis-tetrahydrofurane) closo-1-carbadecaborate.Yields and analytical data see in Table 1.

**E12:** was synthesized analogously to E2 from 2,3,11,12-dicyclohexano-1,4,7,10,13,16-hexaoxacyclooctadecane and europium(II) iodide. Yield and analytical data are given in Table 1. **Preparation of Trimethylammonium 7,16-Bis(3-(1-carbadodecaboranuidyl)propyl)-1,4,10,13-tetraoxa-7,16-diazacycloocta-decane** was prepared in a modified synthesis of a previously reported procedure by Michl et al. (J. Am. Chem. Soc. 2004, 126 (48), 15795-15801):

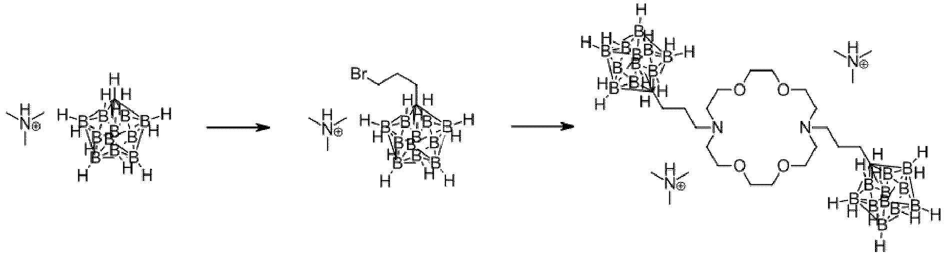

**Cesium 1-(3-bromopropyl)-1-carbadodecaborate:** Trimethylammonium carbadodecaborate (1 eq, 2.03 g, 10 mmol) was dissolved in an aqueous solution of NaOH (20%, 60 ml). The solution was extracted with Et₂O (3x 25 ml), the combined extracts washed with an aqueous solution of CsCl (20%, 2x 30 ml) and the aqueous CsCl-layer re-extracted with Et₂O (3x 30 ml). All organic layers were combined and concentrated in vacuum. The obtained white solid was dried properly in vacuum at 100 °C before it was redissolved in THF (125 ml). The solution was cooled to -78 °C and n-BuLi (1.6 M in hexane, 2 eq, 12.5 ml, 20 mmol) was added dropwise. The mixture was allowed to slowly warm to room temperature. Stirring at rt was continued for 30 min. This solution was then added to a solution of freshly distilled 1,3-dibromopropane (3.5 eq, 7.07 g, 35 mmol) in THF (27 ml) via cannula at 0 °C within 10 min. After addition was completed, the mixture was warmed to rt and stirring was continued for 18 h. The reaction was quenched by adding H₂O (10 ml). The solution was concentrated in vacuum. The residue was diluted with H₂O (15 ml) and extracted with Et₂O (4x 70 ml). The combined extracts were washed with an aqueous solution of CsCl. (20 %, 3x 100 ml) and the aqueous CsCl-layers re-extracted with Et₂O (3x 120 ml). All organic layers were combined, concentrated and dried in vacuum. The residue was purified by recrystallization from water. The title compound was isolated as colorless crystals. Yield: 2.8 g (71 %); MS (ESI): m/z = 264.3 [M-Cs]⁻; Elemental analysis: Calc.: C 12.1 %, H 4.32 %; found: C 11.8 %, H 4.58 %.

**Trimethylammonium 7,16-Bis(3-(1-carbadodecaboranuidyl)propyl)-1,4,10,13-tetraoxa-7,16-diazacyclooctadecane:** A mixture of cesium 1-(3-bromopropyl)-1-carbadodecaborate (2 eq, 774 mg, 1.95 mmol) and 1,4,10,13-tetraoxa-7,16-diazacyclooctadecan (1 eq, 253 mg, 0.96 mmol) in MeOH (30 ml) was heated in a pressure tube to 80 °C for 5 d. The mixture was cooled to rt, the precipitate was filtered off, washed with EtOH and Et₂O and dried in vacuum. The obtained solid was dissolved in an aqueous solution of Trimethylamine (50 %, 50 ml) at 40 °C. The solution was stirred for 2 h. The excess Trimethylamine was evaporated. The precipitating solid was filtered, washed with ice-cold water and EtOH and dried in vacuum. The title compound was yielded as a brittle foam. Yield: 240 mg (33 %); MS (ESI): m/z = -314.1 [M-2 Me₃NH]²⁻, 630.0 [M-2 Me₃NH+H]⁻.

**E13:** A mixture of Trimethylammonium 7,16-bis(3-(1-carbadodecaboranuidyl)propyl)-1,4,10,13-tetraoxa-7,16-diazacyclooctadecane (1 eq. 128 mg, 0.17 mmol) and THF (1.75 ml) was treated with a solution of Eu(HMDS)₂ (1 eq, 105 mg, 0.17 mmol) in THF (1.75 ml) at rt. The mixture was stirred for 1 h at rt. The precipitate was filtered off, washed with THF (3x 2 ml) and dried in vacuum. The title compound was yielded as colorless powder. Yield: 130 mg (97 %)

**E14:** A solution of 0.29 mmol (1.0 eq., 77mg) of 1,4,10,13-tetraoxa-7,16-diazacyclooctadecan in 10 ml MeOH was added dropwise to a solution of 0.29 mmol (1.0 eq., 273 mg) europium(II) tetraphenylborate in 10 ml MeOH. The resulting suspension was stirred for 1 h at room temperature and then filtrated. The resulting powder was washed with MeOH and hexane. Yield: 290 mg (83 %). When attempting to sublimate, the compound decomposed.

**E15:** was synthesized analogously to E2 and E4 from 1,4,10,13-tetraoxa-7,16-dithiocyclooctadecane and EuBr₂. Yield and analytical data are given in Table 1

**E16:** was synthesized analogously to E1 and E3 by using dicyclohexano-18-crown-6 and europium (II)(bis-tetrahydrofurane)12-chloro-1-carbadodecaborate. Yield and analytical data are given in Table 1

**E17:** was synthesized analogously to E2 and E6 from 1,4,10,13-tetraoxa-7,16-dithiocyclooctadecane and EuCl₂. Yield and analytical data are given in Table 1

**E18:** A solution of 0.53 mmol (1.0 eq., 140 mg) 1,4,7,10,13,16-hexaoxacyclooctadecan in 4.3 ml toluene was added dropwise to a solution of 0.53 mmol (0.99 eq., 420 mg) europium(II) (tetrahydrofuran)carbadodecaborate in 60 ml toluene. The resulting suspension was stirred for 1 h at room temperature. The solvent was removed in vacuum. The resulting solid powder was washed with toluene and hexane. Yield: 99 %. Resulted powder was sublimated at 265°C (4.60E-6 mBar), yield 7%. **MS (ESI):** m/z = 287.4 (free crown + Na⁺)⁺; 240.8 (M - 2 CB₁₁H₁₂⁻ + 2MeOH)²⁺; 224.7 (M - 2 CB₁₁H₁₂⁻ + MeOH)²⁺; 208.7 (M - 2 CB₁₁H₁₂⁻)²⁺. Elemental Analysis. Calc.: C, 23.94; H, 6.89. Found.: C, 23.59; H, 6.57.

**E19:** was obtained analogously to E1 from europium(II) (tetrahydrofuran)carbadodecaborate and 1,7,13-Trioxa-4,10,16-triazacyclooctadecane. Yield and analytical data are given in Table 1

**E20** was obtained analogously to E1 from europium(II) (tetrahydrofuran)carbadodecaborate and 1,4,10,13-tetraoxa-7,16-dithiocyclooctadecane. Yield and analytical data are given in Table 1.

**E21** was obtained analogously to E2 from europium(II) iodide and 1,7,13-Trioxa-4,10,16-triazacyclooctadecane. Yield and analytical data are given in Table 1.

**E22** was obtained analogously to E2 from europium(II) iodide and dibenzo-18-crown-6. Yield and analytical data are given in Table 1.

### Summary of the analytical data (sublimation, ESI-MS, and elemental analysis, and emission color of the prepared compounds

**Table 1 Summary of the analytical data for compounds E, compare Fig. 4 (synthesis yield, sublimation yield and temperature, ESI-MS, and elemental analysis, and emission color)**

| Name see | Synthesis Yield, % | Sublimation temperature/ yield | ESI-MS, m/z | Elemental Analysis | Color / eV |
|---|---|---|---|---|---|
| Fig. 4 | | | | | |
| E1 | 77 | 310°C | 557.6 (M - CB11H12-)+; 285.4 (free crown + Na+)+; 263.4 (free crown + H+)+; 238.7 (M - 2 CB11H12- + 2MeOH)2+; 223.7 (M - 2 CB11H12- + MeOH)2+ | Calc.: C, 24.01; H, 7.20; N, 4.00. | Color / eV |
| | | 90%. | | | |
| | | | | Found.: C, 23.90; H, 7.13; N, 3.96 | |
| E2 | 82 | 300°C | 542.4 (M - I-)+; 285.4 (free crown + Na+)+; 263.4 (free crown + H+)+; 239.6 (M - 2 I- + 2MeOH)2+; | Calc.: C, 21.57; H, 3.92; N, 4.19. | 2.75 (film) |
| | | 95% | | Found.: C, 21.54; H, 3.86; N, 4.19 | |
| | | | 223.7 (M - 2 I- + MeOH)2+ | | |
| E3 | 88 | 380°C | 285.4 (free crown + Na+)+; 263.4 (free crown + H+)+; 238.7 (M - 2 CB₁₁CIH11- + 2MeOH)2+; 223.7 (M - 2 CB11CIH11- + MeOH)2+ | Calc.: C, 21.86; H, 6.29; N, 3.68. | 2.75 (film) |
| | | 58% | | Found.: C, 21.54; H, 6.15; N, 3.64 | |
| E4 | 91 | 235°C | 494.3 (M - Br-)+; 285.4 (free crown + Na+)+; 263.4 (free crown + H+)+; 239.6 (M - 2 Br-+ 2MeOH)2+; | Calc.: C, 25.10; H, 4.56; N, 4.88. | 2.75 (film) |
| | | 34% (320% 8%) | | Found.: C, 24.89; H, 4.64; N, 4.85 | |
| | | | 223.7 (M - 2 Br- + MeOH)2+; 207.8 (M - 2 Br-)2+ | | |
| E5 | 66 | 340°C | 579.7 (M - CB11H12-)+; 307.4 (free crown + Na+)+; 285.4 (free crown + H+)+; 250.9 (M - 2 CB11H12- + 2MeOH)2+; 234.8 (M - 2 CB11H12- + MeOH)2+ | Calc.: C, 26.60; H, 6.70; N, 3.88. | 2.83 (pow) |
| | | 67% | | Found.: C, 26.52; H, 6.52; N, 3.88 | |
| E6 | 74 | Decomposed | 450.4 (M - Cl-)+; 263.4 (free crown + H+)+; 223.7 (M - 2 Cl- + MeOH)2+; 207.7 (M - 2 Cl- )2+ | - | 2.88 (film) |
| E7 | 95 | 235°C | 656.3 (M - CB11H12-)+; 383.2 (free crown + Na+)+; 361.2 (free crown + H+)+; 288.6 (M - 2 CB11H12- + 2MeOH)2+; 272.6 (M - 2 CB11H12- + MeOH)2+. | - | 2.82 (pow) |
| | | 13% | | | |
| E8 | 44 | 230°C | 562.2 (M - I-)+; 307.4 (free crown + Na+)+; 285.4 (free crown + H+)+; 250.9 (M - 2 I- + 2MeOH)2+; 234.8 (M - 2 I- + MeOH)2+ | Calc.: C, 24.37; H, 3.51; N, 4.06. | 2.93 (thf) |
| | | 90% | | Found.: C, 24.12; H, 3.62; N, 4.02 | |
| E9 | 95 | 335°C | 667.8 (M - CB11H12-)+; 395.5 (free crown + Na+)+; 373.5 (free crown + H+)+; 294.6 (M - 2 CB11H12- + 2MeOH)2+; 278.9 (M - 2 CB11H12- + MeOH)2+; 262.9 (M - 2 CB11H12-)2+. | Calc.: C, 32.60; H, 7.46; N, 0.00. | 2.83 (pow) |
| | | 58% | | | |
| | | | | Found.: C, 32.62; H, 7.30; N, 0.00 | |
| E10 | 82 | 250°C | 544.3 (M - I-)+; 340.9 (Eu2+ + 2 free crowns)2+; 287.4 (free crown + Na+)+; 240.8 (M - 2 I- + 2MeOH)2+; | Calc.: C, 21.51; H, 3.61; N, 0.00. | 2.95 (thf) |
| | | 63% | | Found.: C, 21.43; H, 3.59; N, 0.00 | |
| | | | 224.7 (M - 2 I- + MeOH)2+ | | |
| E11 | 88 | 330°C | 285.4 (free crown + Na+)+; 263.4 (free crown + H+)+; 238.7 (M - 2 CB9H10- + 2MeOH)2+; 223.7 (M - 2 CB9H10- + MeOH)2+ | Calc.: C, 25.75; H, 7.10; N, 4.29. | 2.79 (MeOH) |
| | | 95% | | Found.: C, 25.53; H, 7.23; N, 4.28 | |
| E12 | 81 | 230°C | 652.5 (M - I-)+; 449.2 (Eu2+ + 2 free crowns)2+; 395.5 (free crown + Na+)+; 294.9 (M - 2 I- + 2MeOH)2+; | Calc.: C, 30.87; H, 4.66; N, 0.00. | 2.72 (THF) |
| | | 57% | | Found.: C, 30.66; H, 4.88; N, 0.00 | |
| | | | 278.9 (M - 2 I- + MeOH)2+ | | |
| E13 | 97 | Decomposed | 630.0 (free crown + H+)-; 314.4 (free crown)2- | - | 2.83 (MeOH) |
| E14 | 83 | Decomposed | 285.4 (free crown + Na+)+; 263.4 (free crown + H+)+; 238.7 (M - 2 B(Ph)4- + 2MeOH)2+; 223.7 (M - 2 B(Ph)4- + MeOH)2+ | - | 2.77 (pow) |
| E15 | 80 | Decomposed | 528.2 (M - Br-)+; 372.9 (2 x free crowns + Eu2+)2+; 319.3 (free crown + Na+)+; 297.3 (free crown + H+)+; 256.5 (M - 2 Br- + 2MeOH)2+; 240.8 (M - 2 Br- + MeOH)2+ | - | 2.58 (pow) |
| E16 | 92 | 280°C | 449.2 (Eu2+ + 2 free crowns)2+; 395.5 (free crown + Na+)+; 294.9 | Calc.: C, 25.75; H, 7.40; N, 4.29. | Not emissive |
| | | 20% | (M - 2 A- + 2MeOH)2+; | Found.: C, 25,53; H, 7.23; N, 4.28 | |
| | | | 278.9 (M - 2 A- + MeOH)2+ | | |
| E17 | 33 | Decomposed | 484.3 (M - Cl-)+; 372.9 (2 x free crowns + Eu2+)2+; 319.3 (free crown + Na+)+; 297.3 (free crown + H+)+; 256.4 (M - 2 Cl- + 2MeOH)2+; 240.7 (M - 2 Cl- + MeOH)2+ | - | 2.87 (THF) |
| E18 | 90 | 265°C | 287.4 (free crown + Na+)+; 240.8 (M - 2 CB11H12- + 2MeOH)2+; 224.7 (M - 2 CB11H12- + MeOH)2+; 208.7 (M - 2 CB11H12-)2+. | Calc.: C, 23.94; H, 6.89; N, 0.00. | 2.91 (pow) |
| | | 31%. | | | |
| | | | | Found.: C, 23.59; H, 6.57; N, 0.00 | |
| E19 | 78 | 270°C | 284.4 (free crown + Na+)+; 262.4 (free crown + H+)+; 239.1 (M - 2 A- + 2MeOH)2+; 223.2 (M - 2 A- + MeOH)2+ | Calc.: C, 12.10; H, 4.32; N, 0.00. | 2.9 (THF) |
| | | 79% | | Found.: C, 11.76; H, 5.06; N, 0.02 | |
| E20 | 95 | 320°C 6% | 592.8 (M - A-)+; 372.9 (2 x free crowns + Eu2+)2+; 319.3 (free crown + Na+)+; 297.3 (free crown + H+)+; 256.4 (M - 2 A- + 2MeOH)2+; 240.8 (M - 2 A- + MeOH)2+ | - | 2.88 (pow) |
| E21 | 84 | 230°C | 573.4 (M - I- + MeOH)+; 541.4 (M - I-)+; 476.5 (M - 2I- + | Calc.: C, 21.60; H, 4.08; N, 6.30. | 2.64 (THF) |
| | | 98% | MeO- + MeOH)+; 284.4 (free crown + Na+)+; 262.4 (free crown + H+)+; 239.1 (M - 2 I- + 2MeOH)2+; 223.2 (M - 2 I- + MeOH)2+ | Found.: C, 21.47; H, 3.99; N, 6.31 | |
| E22 | 92 | Decomposed at 300°C | 640.4 (M - I-)+; 437.1 (Eu2+ + 2 free crowns)2+; 383.4 (free crown + Na+)+; 297.9 (M - 2 I- + 2ACN)2+; | - | 2.61 (THF) |
| | | | 277.4 (M - 2 I- + ACN)2+ | | |

Analytical summarized in Table 1 confirm the correct chemical identity and composition of synthesized coordination compounds E1 to E22, as well as their high purity. Particularly, the elementary analysis data of those materials that do not decompose confirms that each of them consist of a single Eu(II), a single macrocyclic ligand, and two anions, i.e. that the molar ratio of Eu(II) to organic ligand to anion is 1:1:2.

Owning to high volatility, the vast majority of the coordination compounds, e.g., E1 to E3, E5 and E8 to E12, were further purified using a three-temperature **zone sublimation** tool (CreaPhys, DSU-5) being installed in a nitrogen glovebox. Here, the weight of the sublimed material was measured relative to the weight of the material in the sublimation source, giving the sublimation yield, which is quoted in Table 1. A few compounds, such as E6 or E14, were not sufficiently volatile for sublimation. These materials use tetraphenyl borate or chloride anions, which ae not part of the preferred anions disclosed via the generic formulas a1 to a9. However, vast majority of the preferred coordination compounds according to the invention offer sufficient volatility required for display mass production.

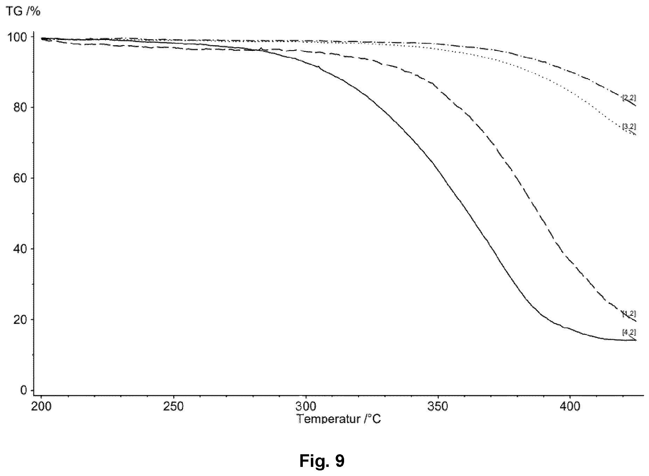

Example **thermal gravity analysis** (TGA) data of sublimed compounds E2, E11, E1, and E3 are depicted in **Fig. 9** as solid, dashed, dotted, and dash-dotted line, respectively. The data were collected using a Netzsch STA449 F5 Jupiter system using open Aluminium crucibles. All measurements were done at reduced pressure of approximately 10⁻² mbar with a heating rate of 10K/min. The curves confirm the high volatility and complete sublimation or evaporation of those for exemplary compounds. As well the relative volatilities between those four very similar compounds does correlate well with the theoretically calculated dipole moments, compare Table 3 below. For example, E2, E11, E1, and E3 feature an increased dipole moment of 0.1, 2.0, 4.1, and 4.5 Debye, respectively which correlates very well with a reduced volatility that does translate into an evaporation or sublimation at relatively higher temperatures.

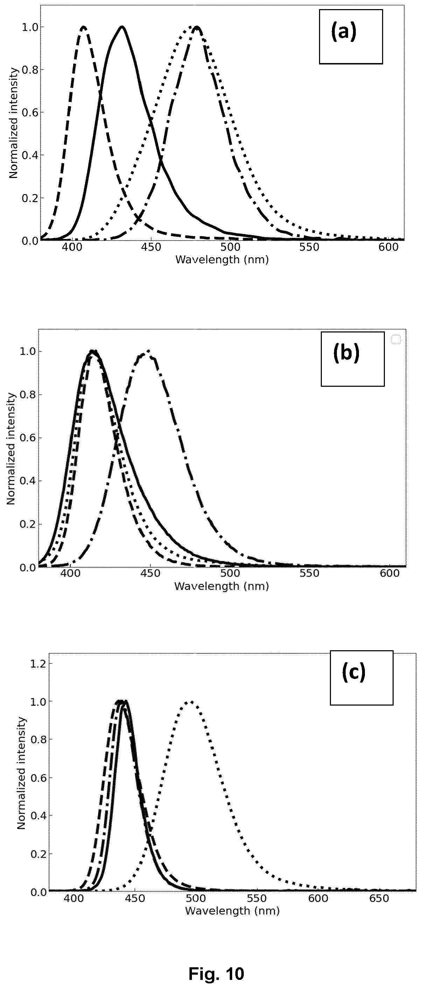

The last column of Table 1 shows the measured photoemission peak energy of all the compounds made. All those data are collected for sublimed material unless the material did not sublime as indicated in column 3. The emission was collected after UV excitation as labelled either in tetrahydrofuran (THF) or methanol (MeOH) solution or as a powder directly after sublimation (pow) or a 50 nm thin film was evaporated (film). The spectral differences between those various conditions are minor. Representative **photo-emission spectra** of 12 sublimed compounds as solid powder and measured under inert gas (nitrogen) are depicted in **FIG. 10****.** In particular, the solid, dash-dot, dash, and dotted lines in Fig. 10 (a) correspond to compounds E5, E14, E7, and E1, respectively; whereas the solid, dash-dot, dash, and dotted lines in Fig. 10 (b) correspond to compounds E9, E3, E16, and E18, respectively; and finally the solid, dash-dot, dash, and dotted lines in Fig. 10 (c) correspond to compounds E2, E4, E6, and E20, respectively. As evident from the graphs, all compounds feature a single Gaussian emission peak, which is relative to typical organic emitters of narrow band width. The emission peak position is given in Table 1 above; most of the materials emit in the blue or even deep blue spectral region around 460 nm and are as such ideally suited for display applications.

**Table 2 Collection of solution photoluminescence quantum yields of various coordination compounds.**

| **Coordination** compound | ***PLQY, %*** |
|---|---|
| E1 | 60 (THF) |
| E5 | 20 (Toluene) |
| E2 | 26 (THF) |
| E9 | 95 (THF) |
| E3 | 60 (THF) |

In **Table 2** photoluminescence quantum yields (PLQY) after optical excitation of various coordination compounds dissolved in either toluene or Tetrahydrofuran are given. Those emission efficiencies are often solvent dependent, as the solvent does act as ligand too.

In **Table 3** the **ambient stability** of various divalent Europium compounds has been probed. To do so, a thin solid layer of the compounds was exposed to air, while the photo-emission intensity being continuously probed as a function of time. During air exposure no spectral changes had been observed, but the emission intensity decreased in a nearly mono-exponential fashion as a function of time. In Table 2 the emission decay time (1/e ~37% of the initial intensity) is quoted. With 7 min, this time is comparably short for the iodide compound E2 yet it increases to 2h for the closocarborate type compound E1. Since all three given examples are based on the same macrocyclic ligand (M3 in Fig. 2) the different ambient stability is purely down to the different anions. The observed ambient stability correlates very well with the calculated energy levels of the compounds, which are summarized in Table 3 below. As expected, the ambient stability increases as the Electron affinity increases. Thus, preferred for application in mass production are materials with comparably high electron affinity, in particular higher than 2.3 eV, more preferably higher than 2.5 eV, and most preferably higher than 2.7 eV.

**Table 3 Measured emission stabilities in air and calculated Electron affinities of various coordination compounds.**

| compound, see Fig. 4 | Electron binding energy (EBE) in eV, see Table 4 | Emission decay to 37% of original intensity / min |
|---|---|---|
| E2 | 5.24 | 7 |
| E3 | 5.76 | 23 |
| E1 | 6.13 | 120 |

### II Quantum-Chemical Methods to calculate relevant parameters of Europium coordination compounds

### Computational Protocols

The computational protocol to determine structures, emission energies **(EE),** and the electron binding energies of Eu(II) complexes in their electronic ground (4*f⁷*5*d*⁰) (**EBE**) and first (energetically lowest) excited (4*f*⁶5*d*¹) (**ES-EBE**) state consists of 3 main steps, all of which can be accomplished with freely available open-source software (xTB: https://github.com/grimme-lab/xtb;

CREST https://github.com/crest-lab/crest; CENSO https://github.com/grimme-lab/CENSO) and the commercially available quantum-chemical program package ORCA (https://www.faccts.de/orca/). These three steps are firstly, the generation of a large comprehensive ensemble of all possible structures of given complex in a large energy window with fast semi-empirical methods, secondly a multi-level energetical screening, optimization, and reranking of the structures in the large ensemble with increasingly accurate density-functional theory (DFT) to determine the relevant (energetically lowest) conformer(s), and thirdly the calculation of the desired properties with a (TD)-DFT methodology.

In principle, any quantum-chemistry software can be used for these calculations and would provide near-identical results if the methods described in detail below (functionals, dispersion corrections, basis sets, geometric Counter Poise corrections, effective core potentials, solvent models and parameters) are applied in the same way.

Due to the statistical (non-deterministic) nature of the simulations in step one of this approach, the results are not exactly reproducible. However, if the simulation times are sufficiently long, the approach will always yield the same relevant (lowest energy) conformer after step 2, which will have very similar properties in the calculations in step 3. As a very conservative estimate, the precision of the predicted dipole moments (over repeated runs for the same molecule) should be ±1 D and ±0.1 eV for emission energies and ionization potentials.

The three main steps of the computation approach are:
**1. Generation of a comprehensive conformer ensemble** with the CREST program version 2.12 using the implemented semi-empirical tight-binding model GFN2-xTB and the Analytical Linearized Poission-Boltzmann (ALPB) solvation model with parameters for toluene as implemented in the xTB software version 6.4.1.
   The conformer generation uses at least two iterations with seven parallel metadynamics simulations, each with at least 30 picoseconds (ps) of simulation time (420 ps total), but more can be necessary for specific complexes.
   Since CREST by default excludes all molecules with topological changes in the bonding pattern compared to the starting structure (as these are isomers not conformers), changes on the central Eu-atom have to be explicitly allowed by excluding Eu from the topology check (-notopo Eu). This is required to ensure that structures with different coordination geometries and numbers of ligand-atoms attached to Eu are also considered (e.g. an iodine coordinated to Eu(II) can move away and coordinate to an NH-proton instead).
   If isolated (not covalently bound) anions are included in the complex like iodide or closoborane, the NCI mode of CREST is invoked (-nci -wscal 1.5).
   All structures within 8 kcal/mol of the lowest structure are kept in the ensemble (and are thus included in step 2).
   Commandline prompt for the input-structure input.xyz:
      *crest input.xyz -gfn2 -alpb toluene (-nci -wscal 1.5) -mdlen 30 -nmtd 7 -notopo Eu -ewin 8*
**2. Multi-level screening, optimization, and reranking of the conformer ensemble** from 1. in 4 sub-steps with DFT methods of increasing accuracy using the CENSO program as driver and ORCA 5.0.3 to carry out the DFT calculations.
   **(A) Prescreening** based on PBE-D4/def2-SV(P)+gCP, single-point energies using the structures from step 1 (notation PBE-D4/def2-SV(P)+gCP//GFN2/ALPB(toluene)). Solvent effects are included by adding the GFN2-xTB/ALPB free energy of solvation (CENSO default) and the 28-electron def2-ECP effective core potential is used for Eu and all atoms heavier than krypton (ORCA default). All conformers whose energy is within 7 kcal/mol of the lowest conformer at this level of theory are included in step 2B.
      *Commandline prompt: censo -inp crest_conformers.xyz -solvent toluene -u 7 -chrg 0 -prog orca -part0 on -func0 pbe-d4 -part0_threshold 7*
   **(B) Screening** based on r2SCAN-3c, single-point energies calculated for the structures from step 1 using the SMD model with parameters for toluene to include solvent effects (r²SCAN-3c/SMD(toluene)//GFN2-xTB/ALPB(toluene)). The resulting single-point energies are combined with thermostatistical contributions (zero-point vibrational energy, entropic and enthalpic vibrational, translational and rotational contributions) evaluated at the GFN2-xTB/ALPB(toluene) level of theory using the modified rigid-rotor harmonic-oscillator (mRRHO) approximation (CENSO default) to obtain free energies. All conformers with a free energy that is within 4.5 kcal/mol of the lowest conformer at this level of theory are included in step 2C. *Commandline prompt: censo -inp crest_conformers.xyz -solvent toluene -u 7 -chrg 0 -prog orca -part0 on -func0 pbe-d4 -part0_threshold 7 -part1 on -part1_threshold 4.5*
   **(C) Reoptimization** of the structures (from step 1) with r²SCAN-3c using the SMD solvent model with parameters for toluene and the "lax" convergence criteria setting of CENSO. Entropic and enthalpic contributions are included at the GFN2-xTB/ALPB(toluene) theory level using mRRHO approximation combined with the single-point Hessian approach (CENSO default). All conformers with a free energy that is within 1.5 kcal/mol of the lowest conformer at this level of theory are included in step 2D.
      *Commandline prompt: censo -inp crest_conformers.xyz -solvent toluene -u 7 -chrg 0 -prog orca -part0 on -func0 pbe-d4 -part0_threshold 7 -part1 on -part1_threshold 4.5 -part2 on - optlevel2 lax -part2_threshold 1.5*
   **(D) Final Reranking** of the structures from 2C using single-point energies calculated with the ωB97X-V functional using the def2-TZVPP basis set and def2-ECPs and the SMD(toluene) model for solvent effects. Thermostatistical corrections (enthalpy, entropy) are taken from step 2C.
      If there is more than one structure within 1.0 kcal/mol of the lowest structure at this level of theory and the respective structures are similar, then only the lowest structure is taken to the next step (3). If there are two or more structures within 1 kcal/mol with different coordination geometries (different atoms coordinating to Eu, different coordination geometry), they are all included in the next step.
      *Command-line prompt: censo -inp crest_conformers.xyz -solvent toluene -u 7 -chrg 0 -prog orca -part0 on -func0 pbe-d4 -part1 on -part2 on -part3 on -func3 wb97xv -basis3 def2-tzvpp*
**3. Calculating of EE, EBE, and ES-EBE** from 2D with the ωB97X-D3 dispersion-corrected density functional (ORCA keyword !wB97X-D3) using the def2-TZVP basis set and def2-ECPs 28-electron pseudopotential for Eu, the def2-SVP basis set (and if necessary def2-ECPs) for all other atoms, the geometrical Counter Poise correction (ORCA: gCP(DFT/SVP)) for basis set incompleteness error, and the SMD solvation model with (slightly modified, see below) parameters for anisole. Convergence thresholds for geometry optimizations in ORCA are set to "loose" (!LOOSEOPT).
   - **EE: Emission energies** are calculated by optimizing the lowest electronically excited state of the lowest conformer from 2D with time-dependent (TD-)DFT/ωB97X-D3 in the Tamm-Dancoff approximation (TDA) using the basis sets, corrections as specified in 3. For the excited-state optimization, the electronic part of the SMD solvation model (C-PCM) is replaced with the linear-response polarizable-continuum model (LR-PCM) using equilibrium solvation for the gradient calculation during the optimization, and non-equilibrium solvation for final emission energies (ORCA default). The emission energy corresponds to the energy of the first excited state after the optimization is converged.
   - **EBE: Electron binding energies of the neutral coordination compound** are calculated as the difference between the electronic energy of the fully relaxed complex with ground-state Eu(II) and the energy of the fully relaxed complex with Eu(III) (singly positively charged) according to the following equation: EBE = E(Eu2) - E(Eu3). The optimizations use the ωB97X-D3 level of theory as specified in 3.
   - **ES-EBE: Electron binding energy of Eu(II) in the lowest electronically excited state** is calculated as the electronic energy difference between the geometry-optimized complex with Eu(II) in its first excited state and the corresponding geometry-optimized complex with Eu(III) (Eu3, singly positively charged) according to the following equation: ES-EBE = E(Eu2*) - E(Eu3).
      Optimization of the electronically excited Eu(II) complex uses the same TDA-ωB97X-D3 level of theory specified in 3B. Optimization of the Eu(III) complex uses the same ωB97X-D3 level of theory specified in 3 (sample inputs S2 and S3).

### Technical Details and Sample Inputs:

The workflow described in step 1. and 2. of this protocol is taken from the following article with some modifications to the default energy cutoffs and methods:
*Efficient Quantum Chemical Calculation of Structure Ensembles and Free Energies for Nonrigid Molecules*
S. Grimme, F. Bohle, A. Hansen, P. Pracht, S. Spicher, and M. Stahn
J. Phys. Chem. A 2021, 125, 19, 4039-4054 (https://pubs.acs.org/doi/pdf/10.1021/acs.jpca.1c00971) All ORCA calculations for steps 2 and 3 employ the resolution-of-the-identity (RI) and chain-of-spheres-exchange (COSX) approximation with the implemented fitting basis sets (def2/J) and default integration grids.

### Calculation results:

**Table 4 Summary of experimental data for various coordination compounds depicted in FIG. 2 (M code), FIG. 3 (A code), FIG. 4 (E code) and obtained using quantum mechanical calculations**

| **Number** | **Ligand, acc. to** **Fig. 2** | **Anion, acc. to** **Fig. 3** | **Complex, acc. to** **Fig. 4** | **Dipole / D** | **EE / eV** | **EBE / eV** | **ES-EBE / eV** |
|---|---|---|---|---|---|---|---|
| 1 | M1 | A1 | E18 | 4.3 | 3.09 | 6.59 | 3.22 |
| 2 | M1 | A24 | E10 | 0.1 | 2.78 | 5.24 | 2.20 |
| 3 | M2 | A1 | E20 | 2.9 | 2.75 | 6.31 | 3.27 |
| 4 | M2 | A23 | E15 | 0.0 | 2.78 | 4.93 | 1.84 |
| 5 | M2 | A22 | E17 | 0.0 | 2.83 | 4.71 | 1.68 |
| 6 | M2 | A24 | | 0.0 | 2.71 | 5.51 | 2.56 |
| 7 | M3 | A1 | E1 | 4.1 | 2.83 | 6.13 | 2.96 |
| 8 | M3 | A2 | E11 | 2.0 | 2.67 | 5.79 | 2.70 |
| 9 | M3 | A3 | | 4.7 | 2.68 | 5.80 | 2.70 |
| 10 | M3 | A4 | E3 | 4.5 | 2.88 | 5.76 | 2.65 |
| 11 | M3 | A5 | | 4.2 | 2.86 | 6.35 | 3.21 |
| 12 | M3 | A6 | | 2.8 | 2.82 | 6.47 | 3.41 |
| 13 | M3 | A8 | | 1.5 | 2.69 | 5.88 | 2.75 |
| 14 | M3 | A9 | | 4.1 | 2.59 | 6.42 | 3.12 |
| 15 | M3 | A10 | | 2.3 | 2.62 | 6.00 | 2.79 |
| 16 | M3 | A11 | | 4.0 | 2.72 | 6.14 | 2.98 |
| 17 | M3 | A12 | | 4.3 | 2.68 | 6.04 | 2.89 |
| 18 | M3 | A13 | | 1.8 | 2.96 | 6.67 | 3.29 |
| 19 | M3 | A22 | E6 | 0.0 | 2.72 | 4.45 | 1.44 |
| 20 | M3 | A23 | E4 | 0.0 | 2.76 | 4.64 | 1.55 |
| 21 | M3 | A24 | E2 | 0.1 | 2.78 | 5.24 | 2.20 |
| 22 | M3 | A28 | | 2.1 | 2.68 | 5.29 | 1.87 |
| 23 | M3 | A50 | E14 | 12.3 | 2.70 | 5.95 | 2.88 |
| 24 | M3 | A84 | | 1.8 | 2.75 | 5.78 | 2.66 |
| 25 | M3 | A85 | | 6.3 | 2.95 | 5.55 | 2.26 |
| 26 | M3 | A86 | | 2.5 | 2.80 | 5.99 | 2.76 |
| 27 | M3 | A87 | | 0.4 | 2.90 | 6.25 | 3.02 |
| 28 | M3 | A88 | | 2.1 | 2.75 | 5.88 | 2.68 |
| 29 | M4 | A1 | | 2.6 | 2.73 | 6.12 | 2.95 |
| 30 | M4 | A2 | | 2.5 | 2.59 | 5.79 | 2.73 |
| 31 | M5 | A1 | E19 | 3.8 | 2.77 | 5.91 | 2.78 |
| 32 | M5 | A24 | E21 | 3.3 | 2.78 | 5.20 | 2.20 |
| 33 | M5 | A2 | | 3.4 | 2.69 | 5.68 | 2.67 |
| 34 | M5 | A4 | | 2.9 | 2.75 | 5.75 | 2.70 |
| 35 | M6 | A1 | | 0.7 | 2.76 | 5.85 | 2.77 |
| 36 | M6 | A2 | | 1.3 | 2.76 | 5.48 | 2.47 |
| 37 | M6 | A4 | | 2.3 | 2.73 | 5.64 | 2.57 |
| 38 | M7 | A1 | | 4.5 | 2.70 | 6.12 | 3.03 |
| 39 | M8 | A1 | | 4.2 | 2.66 | 5.83 | 2.82 |
| 40 | M8 | A2 | | 1.9 | 2.57 | 5.66 | 2.81 |
| 41 | M9 | A1 | | 2.9 | 2.73 | 5.85 | 2.73 |
| 42 | M10 | A1 | | 2.3 | 2.74 | 5.89 | 2.71 |
| 43 | M11 | A1 | | 2.9 | 2.73 | 5.80 | 2.84 |
| 44 | M11 | A2 | | 4.8 | 2.59 | 5.66 | 2.79 |
| 45 | M11 | A4 | | 5.6 | 2.80 | 5.78 | 2.89 |
| 46 | M12 | A1 | E5 | 3.0 | 2.97 | 6.37 | 3.10 |
| 47 | M12 | A24 | E8 | 3.2 | 2.91 | 5.35 | 2.26 |
| 48 | M13 | A1 | | 3.6 | 2.98 | 6.20 | 3.01 |
| 49 | M14 | A2 | | 4.3 | 2.73 | 5.75 | 2.65 |
| 50 | M15 | A1 | | 5.1 | 3.02 | 6.74 | 3.37 |
| 51 | M16-ta | A1 | | 4.2 | 2.77 | 5.90 | 2.73 |
| 52 | M16-ts | A1 | | 4.7 | 2.73 | 5.86 | 2.73 |
| 53 | M16-cs | A1 | | 4.8 | 2.85 | 5.97 | 2.82 |
| 54 | M16-ca | A1 | | 7.0 | 2.51 | 6.03 | 2.92 |
| 55 | M16-ta | A24 | | 2.9 | 2.79 | 4.98 | 2.26 |
| 56 | M17 | A1 | | 2.1 | 2.76 | 5.74 | 2.60 |
| 57 | M18 | A1 | | 2.7 | 2.76 | 6.02 | 2.86 |
| 58 | M19 | A1 | | 3.5 | 2.83 | 5.96 | 2.74 |
| 59 | M19 | A24 | | 3.2 | 2.89 | 5.56 | 2.52 |
| 60 | M20 | A1 | | 1.3 | 2.80 | 6.05 | 2.85 |
| 61 | M22 | A1 | | 1.5 | 2.94 | 6.55 | 3.22 |
| 62 | M25 | A1 | | 4.0 | 2.91 | 6.29 | 3.05 |
| 63 | M25 | A2 | | 3.9 | 2.81 | 5.96 | 2.86 |
| 64 | M26 | A1 | | 6.9 | 2.89 | 6.25 | 3.03 |
| 65 | M34 | A1 | | 3.5 | 2.28 | 5.98 | 3.27 |
| 66 | M37 | A2 | | 4.6 | 2.74 | 6.45 | 3.26 |
| 67 | M37 | A24 | | 0.0 | 2.68 | 5.46 | 2.50 |
| 68 | M38 | A1 | | 3.4 | 2.52 | 5.46 | 2.34 |
| 69 | M39-ca | A1 | E9 | 2.6 | 2.95 | 6.24 | 2.93 |
| 70 | M39-cs | A1 | E9 | 1.8 | 2.94 | 6.34 | 2.95 |
| 71 | M39-ta | A1 | | 2.8 | 2.90 | 6.10 | 2.84 |
| 72 | M39-ca | A24 | E12 | 0.1 | 3.00 | 5.34 | 2.08 |
| 73 | M39-cs | A24 | E12 | 0.9 | 3.09 | 5.33 | 1.83 |
| 74 | M39 | A4 | E16 | 3.5 | 2.96 | 6.49 | 3.19 |
| 75 | M40 | A1 | E7 | 0.9 | 2.93 | 6.37 | 3.11 |
| 76 | M40 | A2 | | 2.1 | 2.83 | 5.99 | 2.56 |
| 77 | M40 | A24 | E22 | 0.6 | 3.08 | 5.45 | 2.21 |
| 78 | M41 | - | | 3.7 | 2.75 | 6.38 | 3.31 |
| 79 | M42 | - | | 2.2 | 2.80 | 6.59 | 3.28 |
| 80 | M46 | - | | 3.2 | 2.72 | 6.35 | 3.30 |
| 81 | M47 | - | | 6.5 | 2.84 | 6.35 | 3.37 |
| 82 | M48 | - | E13 | 7.7 | 2.57 | 6.32 | 3.39 |
| 83 | M50 | - | | 2.6 | 2.73 | 5.51 | 2.42 |
| 84 | M51 | - | | 5.2 | 2.65 | 6.11 | 3.07 |
| 85 | M52 | - | | 4.9 | 2.65 | 5.50 | 2.44 |
| 86 | M53 | A2 | | 1.2 | 2.90 | 5.85 | 2.59 |
| 87 | M54 | A2 | | 0.2 | 2.98 | 5.76 | 2.50 |
| 88 | M55 | A2 | | 4.3 | 2.71 | 5.68 | 2.61 |
| 89 | M56 | A2 | | 7.2 | 2.64 | 5.75 | 2.77 |
| 90 | M57 | A1 | | 3.4 | 2.82 | 5.86 | 2.69 |
| 91 | M57 | A2 | | 2.7 | 2.66 | 5.70 | 2.66 |
| 92 | M58 | A1 | | 1.5 | 2.69 | 5.70 | 2.63 |
| 93 | M59 | A2 | | 1.6 | 2.63 | 5.79 | 2.77 |
| 94 | M60 | A24 | | 1.5 | 3.03 | 5.60 | 2.40 |
| 95 | M61 | A24 | | 2.8 | 2.67 | 5.40 | 2.47 |
| 96 | M62 | A24 | | 4.0 | 2.91 | 5.61 | 2.51 |
| 97 | M63 | A24 | | 2.0 | 2.84 | 5.47 | 2.42 |
| 98 | M64 | A23 | | 0.5 | 2.98 | 5.57 | 2.35 |
| 99 | M65 | A24 | | 1.3 | 2.69 | 5.68 | 2.77 |
| 100 | M66 | A24 | | 3.9 | 2.87 | 5.58 | 2.42 |
| 101 | M67 | A24 | | 1.8 | 2.90 | 5.75 | 2.70 |
| 102 | M68 | A24 | | 4.0 | 2.75 | 5.58 | 2.64 |
| 103 | 2 x M69 | A23 | | 15.3 | 2.70 | 4.47 | 1.53 |
| 104 | 2 x M69 | A24 | | 20.7 | 2.60 | 5.03 | 2.12 |
| 105 | M70 | A24 | | 18.5 | 2.97 | 5.41 | 2.13 |
| 106 | M71 | A24 | | 10.4 | 2.86 | 5.25 | 1.94 |
| 107 | M72 | A24 | | 8.7 | 2.83 | 5.27 | 1.95 |
| 108 | CE1 | A24 | | 23.3 | 2.38 | 4.81 | 1.95 |
| 109 | CE2 | A1 | | 50.5 | 2.79 | 6.28 | 3.08 |
| 110 | CE2 | A24 | | 32.7 | 2.83 | 5.81 | 2.68 |
| 111 | 1 x CE3 | A24 | | 19.5 | 2.73 | 6.24 | 3.29 |
| 112 | 2 x CE3 | A24 | | 20.8 | 2.96 | 5.47 | 2.24 |
| 113 | 3 x CE3 | A24 | | 14.0 | 2.93 | 5.76 | 2.65 |

Table 4 provides key parameters obtained by the quantum chemical protocol described above for 107 emitters generated by combining the ligands displayed in FIG. 2 with the anions shown in FIG. 3. CE1 and CE2 (compare FIG. 2) denote examples comprising polymacrocylic ligand, which are also known as cryptands. CE3 denotes a comparative example which comprises a macrocyclic ligand smaller than those according to the invention (9 instead of at least 12 ring atoms), of which 3 examples are considered (111-113) with the Eu:ligand:anion ratio varied from 1:1:2 over 1:2:2 to 1:3:2. Similarly, rows 103 and 104 show a complex exemplifying the smallest ring size according to invention with anions A23 and A24. The respective compounds have been disclosed in CN113801148A(B). Because of the small number of ring atoms, those compounds form sandwich-like complexes with a less preferable Eu:ligand:anion ratio of 1:2:2. This is in contrast to the other examples with 18 and more ring atoms, which fully encompass the Eu cation and thus typically form complexes with a preferred molar ratio Eu:ligand:anion ratio of 1:1:2.

Table 4 shows calculated dipole moments of all compounds given in Debye. A low dipole moment is one of prerequisites for a compound's high volatility and good solubility in non-polar solvents. The vast majority of the metal-organic coordination compounds feature a dipole moment below 8 Debye. Accordingly, the sublimation experiments for compounds E2 (M3+A24, dipole 0.1 D), E8 (M12+A24, dipole 3D), E10 (M1+A23, dipole 0.1 D), and E12 (M39+A23), demonstrate high sublimation yields > 50% and sublimation temperatures below 250°C, compare column 3 of Table 1. In contrast, the comparative examples, the complexes according to invention with less preferred very small ring sizes and Eu:ligand:anion ratios different from 1:1:2 (M39), and one of the examples according to invention (E14) with ligand M3 combined with the less preferred tetraphenylborate anion (A50) have large calculated dipole moments. As demonstrated in the sublimation experiments above (column 3 in Table 1), this leads to reduced volatility which makes these compounds less preferable for gas-transfer processing, such as sublimation.

However, our sublimation experiments for E2, E4 and E6 collected in Table 1 also demonstrate that sublimation yield for the macrocycle M3 decreases from preferred iodide (A24) to less preferred bromide (A23) from 100% to 30%, respectively, while M3 with least preferable chloride (A22) completely decomposes upon sublimation. These results show that the dipole moment is not the only factor defining volatility. The difference in the volatility in those cases could is explained in terms of anion' ability to approach to the Eu(II) center and the thermodynamic stability of the respective EuX₂ salts, which increases with decreasing size of the halogen. The smallest in the series chloride anions penetrate from outer to inner sphere of the complex, which upon a heating in vacuum facilitates the formation of the stable inorganic ionic compound EuCl₂. Instead, the much larger iodide anion is well separated from Eu(II) and the respective salt is less stable, such that the formation of EuI₂ is not observed. The intermediate-sized bromide stays in between the extremes. Therefore, iodide is the preferred halogene.

The next column (6) shows the calculated emission energy (EE) in electron volts. The desirable color of the emission is in the deep blue spectral region corresponding to the emission energies around 2.75 eV. The preferred range for the emission energy considering the uncertainty in the calculation is from 2.5 to 3.0 eV. Most coordination compounds considered in this disclosure are within this preferred range while many are much closer to the desirable deep-blue color of 2.75 eV. The only exception from the range given above are emitters that involve all-oxo-crowns, e.g., M1, M15, M39 and M60. The use of those emitters in OLEDs is more challenging considering that matrices with triplet energy levels above 3.0 eV are scarce. This demonstrates that some non-oxygen heteroatoms are desirable to achieve the preferred EE range. This is because of a general trend that can be observed when comparing the EE values for M1, M53, M3, M5 and M8 with 0, 1, 2, 3, and 4 of the oxygen donors replaced by nitrogen in comparison with anion A1, or in case of M53 A2. With increasing number of nitrogens, EE decreases from 3.09 eV over 2.90 eV, 2.83 eV and 2.77 eV to just 2.66 eV, respectively. Further, this is in line with similar trends reported in the literature for example in Yan et Al, Inorg. Chem. Front., 2022, 9, 4794. The phosphor-containing ligand M34 combined with anion A1 represents a further exception from the desired EE value, which has a strongly red-shifted emission energy of 2.21 eV; macrocyclic phosphorus is a less preferred heteroatom present in the macrocycle. Finally, CE1 also shows a low emission energy of 2.38 eV, which in line with the experimental observations detailed in CN113801148A(B). This can be traced back to the different, poly-macrocycles structure of the ligand CE1.

The column entitles EBE (7) shows the electron-binding energy of the complex, consistently given in eV. The EBE of emitters should be above 5.5 eV to be sufficiently stable against oxidation of Eu(II) to Eu(III) by environmental oxygen, which enables handling of the metal-organic coordination compounds in ambient conditions. Comparing the EBE values obtained for ligand M3 with different anions shows that carborate anions (A1-13 and A84-88) ensure favourable EBE values, whereas halogenides and smaller anions (e.g. A22-A24, A28) often lead to values below the desired 5.5 eV. The relation between ambient air stability and predicted EBE value has been experimentally investigated. The results of these experiments are collected in Table 3 and conclusively demonstrate that a complex with ligand M3 and anion A1 has the highest EBE of 6.13 eV and is most stable, followed by M3 with A4 (EBE 5.76 eV) and the least stable M3 with A24 (5.24 eV). Besides the anion also the macrocyclic ligand has an influence on the EBE value. For example, replacing the 2^{nd} row donor atoms O and N with their higher homologues S, Se, and P can lead to an increase of the EBE value. This can be exemplified for anion A24 by comparing ligands M1 and M3 (only N and O donor atoms) to M2, M37, M62 and M67 (also S and Se donor atoms). Another possibility is to replace the ethyl bridge between the donor atoms with the strongly electron-withdrawing ortho-closocarborane (C₂B₁₀H₁₀) group, as exemplified in ligands M64 and M65.

Moreover, the EBE is directly linked to the excited-state EBE displayed in the next column (8), which describes how strong the emitter binds its electrons in the excited state relevant for emission. ES-EBE is related to the electron affinity (EA) and LUMO energies of common OLED materials. Accordingly, ES-EBE is a critical parameter for OLED function. Values above 2.3 eV are desirable, while values above 2.5 eV are preferred and values above 2.7 eV are most preferred. This is because higher values simplify the desired confinement of the charge carriers and allow for a much wider selection of host materials. Specifically, the (absolute) value of the LUMO of the host material is preferred to be below the ES-EBE value of the emitter, since otherwise electron-transfer from emitter to host might occur in the excited state instead of the desired emission from the emitter. Since the ES-EBE value is directly linked to the EBE value via the EE value of the complexes, the ES-EBE value behaves very similar to the EBE values with respect to anions and ligands. Generally, large and soft anions such as closoborates attain high ES-EBE values, while smaller anions such as iodide, bromide and chloride lead to small ES-EBE values below 2 eV. Similar to the EBE value, also the ES-EBE can be influenced not only by the anion but also by the ligand, e.g., via the donor atoms or presence of electron-withdrawing groups, c.f. ligands M2, M37, M62, M64, M65, and M67 with Anion A24.

Instead of having the anions as separate entities, the charged macrocyclic ligands M41, M42, M46-48, M50-52 exemplify several ways to covalently attach a variety of charged carborates to the ligand. All the resulting complexes have desirable EE, EBE, and ES-EBE values and low dipole moments. Besides the point and type of covalent attachment, chemical modifications of the attached carborates allow to influence the properties of these complexes employed in this invention. For example, attaching the carborate via an ether bridge at the B-vertex as exemplified in M50 leads to lower dipole moments, EBE, and ES-EBE values than attachment via an alkyl brigde to the C-vertex (e.g. M46 and M48).

The discussed examples that might be used in devices according to invention and their comparison with CE1 to CE3 illustrate how key properties of the emitter change depending on employed ligand and anions. It is immediately clear that none of the comparative examples fulfil all three requirements to function in OLED device at the same time. CE1-CE3 exhibit a high dipole and are thus not volatile. Combining the wrong ligand and anions furthermore leads to strong interactions of the corresponding anions with Eu(II), causing EBE and ES-EBE values far below than the desired 5.0 eV and 2.2 eV, respectively. Similarly, the combination of M69 with A24 and A23 from the prior art CN113801148A(B) demonstrates that too small macrocycles which do not encompass the Eu(II) cation leads to a different ligand to Eu(II) ration than 1:1, and, in turn, a much larger dipole moment and lower volatility. Hence, although CE5 exhibits blue luminescence with emission energy of 2.60 eV and a reasonable EBE values, it is insoluble in apolar solvents and does not sublime.

This contrasts with many of the emitters that are potentially used in devices according to the invention, particularly the combinations M2, M65, and M67 with A24 (iodide), M5, M11 and M3 with A4 (mono-chloro-closocarborate), M6, M17, and M58 with A1 (closocarborate), all of which fulfil all four requirements: they have a small dipole moment, an emission energy in the deep blue region, an EBE above 5.5 eV, and an ES-EBE well above 2.3 eV.

In conclusion, by combing macrocyclic ligands with a right cavity size with suitable anions - preferably of closoborate type or iodide - and hosting such obtained emitter with the correct type of charge and energy confining organic host materials allows to manufacture OLED devices via gas-transfer processing that exhibit deep-blue emission and high stability. The combination of deep blue color, high ambient stability, favourable electronic properties, and high volatility has indeed not been described in any prior art and as such describes a highly beneficial combination of properties, suitable to make deep blue and efficient OLED devices.

### III Collection of second organic materials parameters that might be present in mixtures according to the invention or various comparative examples

**Table 5: Collection of HOMO, LUMO, and Triplet energies of various organic materials as provided by material vendors or literature ^{1,2,3,4,5}.**

| Material | IUPAC name | Synonym | HOMO, eV | LUMO, eV | Triplet, eV |
|---|---|---|---|---|---|
| H1³ | [3-(9-Carbazolyl)-9-oxa-1-fluorenyl]tris(phenyl)silane | H1 | 6.2 | 2.4 | 3.00 |
| H2¹ | 3,3'-Di(9H-carbazol-9-yl)-1,1'-biphenyl | mCBP | 6.0 | 2.4 | 2.80 |
| H3¹ | 1,3-Di(9H-carbazol-9-yl)benzene | mCP | 5.9 | 2.4 | 2.90 |
| H4² | 1,3-Bis(3,6-di-tert-butyl-9H-carbazol-9-yl)benzene | mCP-t-Bu | 5.8 | 2.4 | 2.90 |
| H5² | 5-[5-[2,4,6-tris(1-methylethyl)phenyl]-2-pyridinyl]-5H-Benzimidazo[1,2-a]benzimidazole | PPBI | 5.7 | 2.0 | 3.30 |
| H6¹ | Bis[3,5-di(9H -carbazol-9-yl)phenyl]diphenylsilane | SimCP2 | 6.1 | 2.5 | 3.00 |
| H7¹ | 1,1-Bis[(di-4-tolylamino)phenyl]cyclohexane | TAPC | 5.5 | 2.0 | 2.87 |
| H8¹ | 4,4',4"-Tris(carbazol-9-yl)triphenylamine | TCTA | 5.8 | 2.4 | 2.73 |
| H9⁴ | 9-(3-(triphenylsilyl)phenyl)-9H-3,9'-bicarbazole | SiCzCz | 6.0 | 2.3 | 2.92 |
| H10⁵ | 9-(3-(9H-carbazol-9-yl)phenyl)-9H-3,9'-bicarbazole | mCPBC | 5.8 | 2.2 | 3.00 |
| H11¹ | 4,4',4"-Tris[(3-methylphenyl)phenylamino]triph enylamine | m-MTDATA | 5.0 | 2.0 | 2.67 |
| H23³ | Triphenyl[6-(triphenylsilyl)-9-oxa-3-fluorenyl]silane | H2 | 6.5 | 1.5 | 3.00 |

The UPAC names and relevant parameters of organic materials used in various mixtures are given in **Table 5.** The compounds were purchased from Ossila (labeled 1), Lumtec (labeled 2), synthesized according to literature (labeled 3), Sagechem (labeled 4), and Puri materials (labeled 5) and their corresponding HOMO, LUMO and Triplet energy values are taken from the websites of the vendors or scientific literature by searching for the material using its name or synonym. The chemical structures for the organic materials are shown in FIG. 5. Here, HOMO and LUMO energies correspond to electron binding energy (EBE) and electron affinity (EA), respectively.

### IV Mixtures guest-host mixtures using divalent Europium coordination compounds

All experiments (sample preparation and measurement) were carried out in a nitrogen containing glovebox. Mixtures of a coordination compound, E, and a second organic material, H, are created by thermal co-evaporation of both materials in an ultra-high-vacuum chamber. In all cases depicted here, the ratio of the coordination compound to the organic material is 1:9 vol%, which is achieved during the sample preparation by fixing the evaporation rates of each material accordingly. The samples are produced on pre-cleaned 25 x 25 mm quartz substrates. The resulting samples are organic thin films with a total thickness reaching 50 nm. Subsequently, there is a 100 nm layer of Aluminium deposited on the thin film to prevent any negative impact of oxygen and moisture exposure on the sample over time.

The samples are characterized by way of time-correlated single photon counting method (TCSPC). The experiment is carried out using a HORIBA Fluoromax 4P spectrofluorometer with a TCSPC extension. The excitation wavelength of the laser used in the experiment is 295 nm. The laser pulse width is < 1 ns. The slit in front of the detector is set to 1 nm and the monochromator in front of the detector is set to the peak emission of the coordination compound in solution (compare FIG. 10, or last column of Table 1 above) used in the mixture.

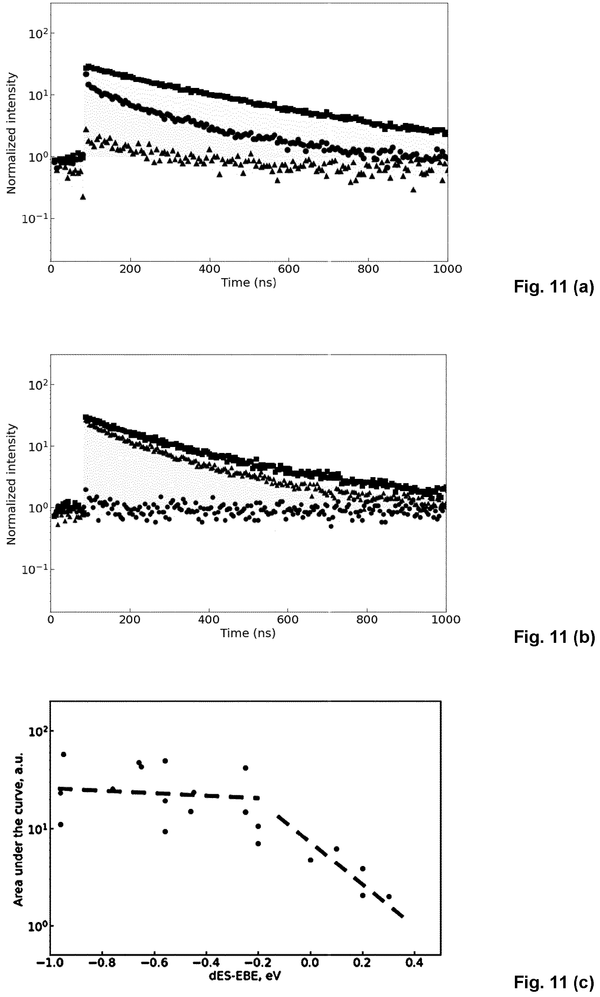

Example decay curves of six mixtures, are plotted in **FIG. 11 (a)** and **(b)** in a semi-logarithmical fashion. In Fig. 11 (a) the same coordination compound, E1, is combined with three different host materials, H7 (squares), H2 (circles), H8 (triangles), while in Fig. 11 (b) the same host material, H1, is combined with three different coordination compounds, namely E1 (squares), E2 (circles), E3 (triangles). Already a simple visual inspection of the data shows that E1:H8 in (a) as well as E2:H1 in (b) show a very short excited state lifetime, i.e. they are strongly quenched, while the other four combinations depict much longer excited state lifetimes close to an monoexponentially decay, i.e. the emission of the coordination compound is much less quenched in the present of those four host materials. To quantify the efficiency of light emission from the coordination compound in the mixture, the area under each curve is calculated. Prior to the calculation, each curve is normalized to have the same noise level at 1. The initial luminescence from the mixture originates from fluorescence of the organic material used in the mixture. To include only the emission from the coordination compound, the integration is carried out in the range of 150 - 1000 ns. It is considered that a larger area under the curve is directly correlated to larger quantum efficiency of the coordination compound within the mixture. The typical literature expected excited state lifetime of the non-quenched divalent Europium decay interpretation is about 1.25 µs, see for example WO2021244801A1, which corresponds to an emission quantum yield of 1. Thus, in mixtures that have a lifetime component in the range of 1 µs, it is considered that this decay component originates purely from the coordination compound, and that comparing areas under the curves for each mixture is a valid way of determining which mixture has a larger quantum efficiency. The aromatic organic host materials feature excited state lifetimes of about 1 ns, i.e. 1000 times shorter.

**Table 6 The area under the emission decay curve of various mixtures of organic materials H (compare FIG. 5) with coordination compounds E (compare FIG. 4). HOMO, LUMO, and triplet quantify hole, electron, and energy confinement - see text for details.**

| Mixtures | | | HOMO (host) - EBE (emitter), eV | LUMO (host) - ES-EBE (emitter), eV | Triplet (host) - EE (emitter), eV | Area under curve |
|---|---|---|---|---|---|---|
| 1 | H1 | E1 | 0.17 | -0.56 | 0.25 | 19.43 |
| 2 | H1 | E5 | -0.07 | -0.7 | 0.11 | 3.3 |
| 3 | H1 | E2 | 1.06 | 0.2 | 0.25 | 2.04 |
| 4 | H1 | E3 | 0.54 | -0.25 | 0.25 | 14.61 |
| 5 | H2 | E1 | -0.13 | -0.56 | 0.05 | 9.3 |
| 6 | H2 | E5 | -0.37 | -0.7 | -0.09 | 4.21 |
| 7 | H2 | E2 | 0.76 | 0.2 | 0.05 | 3.86 |
| 8 | H2 | E3 | 0.24 | -0.25 | 0.05 | 14.61 |
| 9 | H3 | E1 | -0.23 | -0.56 | 0.15 | 49.08 |
| 10 | H4 | E3 | 0.04 | -0.25 | 0.15 | 41.8 |
| 11 | H5 | E1 | -0.43 | -0.96 | 0.55 | 10.97 |
| 12 | H5 | E2 | 0.46 | -0.2 | 0.55 | 7 |
| 13 | H6 | E1 | -0.03 | -0.46 | 0.25 | 14.92 |
| 14 | H6 | E5 | -0.27 | -0.6 | 0.11 | 5.75 |
| 15 | H6 | E2 | 0.86 | 0.3 | 0.25 | 2 |
| 16 | H7 | E1 | -0.63 | -0.96 | 0.12 | 22.97 |
| 17 | H7 | E5 | -0.87 | -1.1 | -0.02 | 3.1 |
| 18 | H7 | E2 | 0.26 | -0.2 | 0.12 | 10.6 |
| 19 | H7 | E3 | -0.26 | -0.65 | 0.12 | 43.29 |
| 20 | H8 | E1 | -0.3 | -0.53 | -0.02 | 2.32 |
| 21 | H9 | E1 | -0.13 | -0.66 | 0.17 | 47.37 |
| 22 | H9 | E2 | 0.76 | 0.1 | 0.17 | 6.14 |
| 23 | H10 | E1 | -0.33 | -0.76 | 0.25 | 25.5 |
| 24 | H10 | E2 | 0.56 | 0 | 0.25 | 4.72 |
| 25 | H11 | E1 | -1.13 | -0.96 | -0.08 | 3.6 |
| 26 | H11 | E2 | -0.24 | -0.2 | -0.08 | 2 |
| 27 | H23 | E19 | 0.59 | -1.28 | 0.23 | 21.1 |
| 28 | H23 | E11 | 0.71 | -1.20 | 0.33 | 26.8 |
| 29 | H23 | E1 | 0.37 | -1.46 | 0.17 | 10.0 |

The area under the decay curves for a wide range of mixtures of a second organic material, H, combined with various coordination compounds, E, are given in the last column of **Table 6.** The chemical structures and the names and the relevant properties of the organic materials, H1 to H11 and H23, can be found in FIG. 5 and Table 5, respectively. For the Europium coordination compounds, E, the structures are depicted in FIG. 4, while their relevant calculated parameters are tabulated in Table 4 above.

According to a preferred embodiment of the invention, the organic compound, **H,** has a higher electron binding energy than the charge-neutral coordination compound, to ensure that the neutral emitting molecule is able to trap a hole during electroluminescent device operation. This difference in electronvolt of the "HOMO" Energy of the host material and the calculated electron binding energy, EBE, of the coordination compound is given in column 2 of Table 6. Here a negative sign means that the criteria is not met, i.e. the coordination compound is not able to confine a hole within the given mixture. For example, #18 E2:H7 shows a preferred relatively high positive value, while #16 E1:H7 shows a less preferred negative value, indicating poor hole trapping on E1 within H7.

Preferably the organic compound has an electron affinity that is lower than the electron binding energy of the coordination compound in its lowest electronically excited state. This difference in electronvolt of the "LUMO" energy of the host material and the calculated electron binding energy in the excited state, ES-EBE, of the coordination compound is given in column 3. Here, a negative sign means that the criteria is met, i.e. that the electron is confined on the excited emitter complex and does not transfer its excited electron to the surrounding host. For example, in #2 the host H1 is able to confine the electron of emitter E5, while the same host is not able to confine the E2 in example #3.

Preferably the second organic compound has a higher triplet energy compared to the emission energy of the coordination compound from the first electronically exited state. This difference in electronvolt of the triplet energy of the host material and the measured peak emission energy of an evaporated thin film of the coordination compound, EE, is given in column 4. Here, a positive sign means that the criteria is met, i.e. that the emission energy is confined on the emitter and does not transfer to the surrounding host material. For example, in #14 H6 is able to energetically confine emitter E5, while in #6 host H2 is not preferred for this emitter as it does not confine its energy.

The area under the decay curve corresponds to the emission quantum yield of the coordination compound. One can easily distinguish two qualitatively different cases: If the electron and energy confinement (column 3 and 4) are met than the area under the curve is relatively high. If one of the two criteria is not met, then the area under the curve and thus the emission quantum yield, are low. For example, in # 21 host H9 combined with emitter E1 does confine the electron and does show high area of 47, while in #22 the excited electron of E2 is not confined in the same host H9 and the corresponding area under the curve is only about 7. Example #1 and #25 illustrate the situation of triplet confinement (#1) and lack thereof (#25) for emitter E1 hosted in H1 and H11, where the area under the curve drops fivefold from about 20 to 4. On the other hand, the hole confinement, quantified in column 2, is not important for the photoemission quantum yield. For example, in example #8 and #9 the hole confinement is qualitatively different, yet both mixtures show high quantum yield, testified by a relatively high area under the curve. Here, after photo excitation, it is not possible to just transfer a hole from the excited guest to the surrounding matrix, as this would leave behind an energetically unfavourable Eu(I) complex. However, hole confinement does become important for device as shall be shown in the device examples below.

The calculated values given in Table 4 are generated from DFT calculation with an estimated error of about 0.1eV. Similarly, the HOMO and LUMO and triplet energies given in Table 5 are collected from various methods and again have at least an error of 0.1eV. Thus, there is a combined error of +-0.2eV in all values quoted in column #2,3,4, which in some cases might explain relative changes in the quantum yields that are indirectly observed in the last column. As described above, additionally there is the inherent energetic width of all organic energy levels, usually expressed in terms of density of states, DOS. Thus, even if a certain criterion is met in terms of peak position of the density of states function, there might still be a substantial portion, where it is in fact not met. Given that typical organic DOS are of the order of 0.1eV, it is generally preferable that a certain criterion is not just about met (with respect to peak position) but instead it is well met (to cover most of the DOS as well). Preferably, the energetic differences are >0.1eV and even more preferably >0.2eV. Examples #1 and #5 are qualitatively similar with respect to all three energetic differences. However, the triplet confinement is 250meV for E1 in H1 vs 50meV for E1 in H2. Therefore, whilst all preferred criteria are nominally fulfilled, the halved photo-efficiency of E1 in H2 vs E1 in H1 (10 vs 20) is well explained by partially insufficient triplet confinement of E1 in H2. Here, 50meV difference is in the same order as any typical organic (triplet energy) DOS. Consequently, for E1, H1 is preferred over H2.

To further illustrate this case, the area under the curve that correlates with the photo efficiencyis plotted vs the nominal electron confinement (labelled dES-EBE, column 3 in Table 6) in **Fig. 11 (c).** Here, the dashed lines are guidance to the eye. Obviously, the emission efficiency does sharply drop (note, this is a semi-logarithmical presentation) once the energy difference becomes substantial, say +0.2eV. On the other hand side its within scatter indifferent to whether it is confined by -0.2 or -1.0 eV. And in between -0.2 and +0.2eV some smooth transition occurs.

### V Electroluminescent device examples

Representative embodiments of organic electronic devices according to various embodiments will now be described, including a detailed description of the fabrication process of the organic electronic device. Yet, it will be understood that neither the specific techniques for fabrication of the device, nor the specific device layout, nor the specific compounds are intended to limit the scope of the present invention.

### Material definitions:

- ITO:: Indium tin oxide, transparent anode
- NPB:: N,N'-Di(1-naphthyl)-N,N'-diphenyl-(1,1'-biphenyl)-4,4'-diamine
- HT1:: 3-[Cyano(4-cyano-2,3,5,6-tetrafluorophenyl)methylene]-α1,α2-bis(4-cyano-2,3,5,6-tetrafluorophenyl)-1-cyclopropene-1,2-diacetonitrile
- SiTrz:: 2,4-Diphenyl-6-[3-(triphenylsilyl)phenyl]-1,3,5-triazine
- TSPO1:: Diphenyl[4-(triphenylsilyl)phenyl]phosphine oxide
- Yb:: Ytterbium
- Al:: Aluminium
- Mox: Molybdenum oxide

The organic electronic devices were prepared with the following layer sequences:
   Device 1
      ITO / NPB:HT1 7:3 nm / NPB 40 nm / H7 10 nm / **H7:E-2** 18:2 nm / H1 10 nm / H22:Yb 36:4 nm / Al 120 nm.
   Device 2
      ITO / NPB:HT1 7:3 nm / NPB 40 nm / H7 10 nm / **H7:E-1** 18:2 nm / H1 10 nm / H22:Yb 36:4 nm / Al 120 nm.
   Device 3
      ITO / Mox 2 nm / H6 60 nm / H1 10 nm **/ H1:E-1** 16:4 nm / SiTrz 10 nm / H22:Yb 36:4 nm / Al 120 nm.
   Device 4
      ITO / Mox 2 nm / H6 70 nm / **H23:E-19** 14:6 nm / H23 5 nm / H22:Yb 54:6 nm / Al 120 nm.
   Device 5
      ITO / Mox 2 nm / H6 70 nm / **H1:E-19** 14:6 nm / TSPO1 5 nm / H22:Yb 23:2 nm / Al 120 nm.

The organic electronic device was fabricated on a 1"x1" size glass substrate, pre-coated with a transparent ITO anode and a pixel definition layer (Geomatec). The substrates were loaded into an ultra-high vacuum evaporation tool operating at around 10⁻⁷ mbar pressure. Here, the organic layers were deposited onto the substrate in the sequence stated above. In the case of NPB:HT1, H7:E-2, H7:E-1, H1:E-1, H1:E-19, H23:E-19, H22:Yb, a co-evaporation process was used with both materials evaporating at the same time at different rates, corresponding to the resulting mixed layers, with quoted partial layer thickness. The device was finished by evaporating a 120 nm film of cathode Al. The Al deposition was carried out using a structured shadow mask, such that the resulting overlap of pre-structured ITO, organic layers and Al gave an active area of 3.88 mm². Subsequently, the devices were transferred to a nitrogen atmosphere glovebox and encapsulated by gluing an additional encapsulating glass substrate on top to prevent oxygen- and water-induced degradation. A liquid getter is dispensed onto the encapsulating glass substrate which absorbs moisture. The electrical and electroluminescent properties of the device were measured using an integrated OLED characterization setup M7000 (McScience inc.).

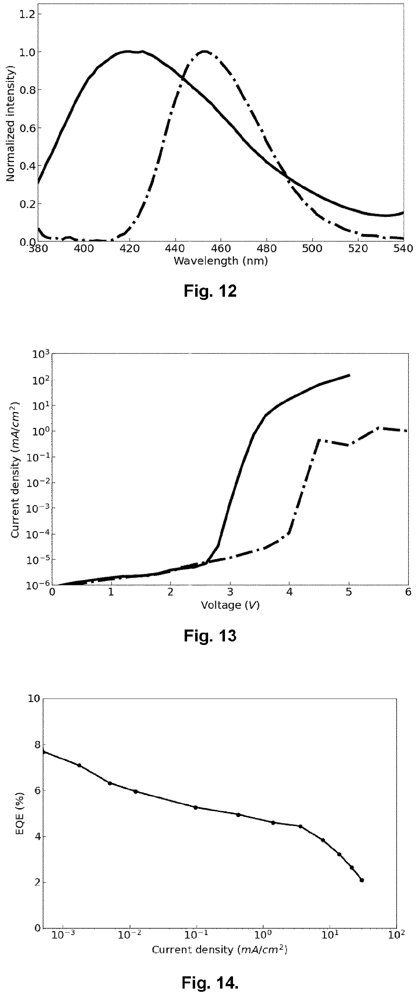

Device 1 showed maximum EQE of 17 %EQE at low brightness and emitted with deep blue peaking at 2.75 eV, resulting in an EL spectrum that is presented in **Fig. 12****.** as dashed-dotted line. Evidently, the electroluminescence spectrum of Device 1 resembles the photoluminescence spectrum of the coordination compound E-2 very well (compare solid line in Fig. 10 (c)) and as well fits the calculated emission energy, EE, of emitter E2, 2.78eV, perfectly. Device 2 on the other hand showed significantly reduced EQE values <1 %EQE and the electroluminescence spectrum (see solid line in Fig 11) does not at all resemble that of the photoluminescence (compare dotted line in Fig 10 (a)). Very likely the electroluminescence spectrum emitted by Device 2 does arise from host H1 instead of the coordination compound. The organic materials and device stacks used for Device 1 and Device 2 were the same, therefore the difference in device performance arises from the different properties of the coordination compounds used. The layer **H7:E-2** in Device 1 represents a mixture in which the EBE, ES-EBE and triplet criteria for charge carrier and energy confinement are met (#18 in Table 6: +0.26, -0.2, +0.12), resulting in effective hole trapping on the coordination compound with subsequent recombination. The layer **H7:E-1** in Device 2 represents a mixture in which the EBE criterion is not met (#16 in Table 6: -0.63, -0.96, +0.12), which leads to no hole trapping on the coordination compound, leading to emission from a neighboring material. Therefore, Device 1 is preferred according to invention, while Device 2 is less preferred. As evidenced by comparing the area under the curve, both material mixtures do offer a high photoluminescence yield in optical excitation. Thus, its really the qualitative lack of hole trapping (-0.63 vs +0.26eV), which can only explain the qualitative different device results. In **Fig. 13** the IV characteristics of the two devices are compared to further illustrate this point: Here, the solid line refers to Device 2 and shows a low turn-on of 2.5V, while the dash-dotted line indicates a turn-on for Device 1 of about 4.0 V. Here, the preferred hole trapping in Device 1 causes a significantly higher driving voltage as would be expected for a hole trapping device.

In **Fig. 14** the external quantum efficiency (EQE) of Device 3 is plotted vs current density thereby demonstrating high maximum EQE of up to 8 %. The corresponding electroluminescence spectrum of Device 3, shown in **Fig. 15****,** perfectly matches that of the photoluminescence of E-1 (dotted line, Fig. 10 (a)). In this case, Device 3 contains a mixture of H1:E-1 (#1 in Table 6), for which the EBE, ES-EBE and triplet criteria for charge carrier and energy confinement are met, which leads to recombination on the coordination compound, which is preferred.

The EBE (hole trapping) criterion is highlighted by comparing the performance of Device 2 and Device 3, in which the difference is the second organic compound used in the mixture with coordination compound E-1. In the case of Device 2, the EBE criterion (hole trapping) is not met and no electroluminescence from the coordination compound used in the device is observed. In contrast, in Device 3, the EBE criterion is met, leading to a markedly improved device performance, with the correct deep blue emission spectrum. Having an EBE of the second organic compound higher than the EBE of the coordination compound ensures that charge carrier trapping occurs on the coordination compound during device operation, leading to efficient light emission.

Device 4 and Device 5 focus on a different coordination compound E-19. The coordination compound E-19 has smaller EBE and ES-EBE values, compare table 4 while maintaining the same emission peak. In Device 5, a mixture H1:E-19 is used, which highlights the importance of sufficient hole trapping, compared to Device 3. The main difference between Devices 3 and 5 is the coordination compound used, with the EBE difference of the mixtures being larger for Device 5, corresponding to deeper hole trapping. This way, higher EQE values are achieved, reaching up to 12.5 % EQE for Device 5 as shown in **Fig. 16****,** dashed line. Device 4, on the other hand, uses the same coordination compound E-19, but in a different mixture with H23. The EBE and ES-EBE criteria are met, however, the reduced EQE values compared to Device 5 arise from a different charge balance in the light-emitting device. The EQE values of Device 4 are plotted in Fig. 16, solid line. It is assumed that H1 has a strong hole-transporting character, while H23 has a strong electron-transporting character.

## Claims

1. An organic electroluminescent device comprising:
a first electrode (104),
a second electrode (108), and
an organic layer (106) disposed between the first electrode (104) and the second electrode (108), the organic layer (106) comprising at least one charge-neutral metal-organic coordination compound (a) comprising a divalent Europium coordinated by a macrocyclic organic ligand,
wherein the macrocyclic organic ligand is formed of 12 to 48, preferably 15 to 24, and most preferably 18 to 20 macrocyclic ring atoms which are part of a single cyclic ring, the macrocycle, wherein only those carbon or heteroatoms are counted as macrocyclic atoms that do form the cyclic closed ring system around the Eu(II),
wherein the organic layer (106) comprises a second organic compound (b) that is a charge-neutral host material, wherein the triplet energy of the second charge-neutral organic compound (b) is higher than the emission energy of the coordination compound (a),
wherein the second charge-neutral organic compound (b) has an electron affinity that is lower than the electron binding energy of the coordination compound (a) in its lowest electronically excited state,
wherein emission energies of the neutral coordination compound (a) are calculated by optimizing the lowest electronically excited state of the lowest conformer from 2D with time-dependent DFT/ωB97X-D3 in the Tamm-Dancoff approximation using the def2-TZVP basis set and def2-ECPs 28-electron pseudopotential for Eu, the def2-SVP basis set, and if necessary def2-ECPs, for all other atoms, the geometrical Counter Poise correction for basis set incompleteness error, and the SMD solvation model with parameters for anisole,
wherein electron binding energies of the neutral coordination compound (a) are calculated
as the difference between the electronic energy of the fully relaxed complex with ground-state Eu(II) and the energy of the fully relaxed complex with Eu(III) which is singly positively charged with time-dependent DFT/ωB97X-D3 in the Tamm-Dancoff approximation using the def2-TZVP basis set and def2-ECPs 28-electron pseudopotential for Eu, the def2-SVP basis set, and if necessary def2-ECPs, for all other atoms, the geometrical Counter Poise correction for basis set incompleteness error, and the SMD solvation model with parameters for anisole,
wherein electron binding energy of Eu(II) in the neutral coordination compound (a) in the lowest electronically excited state is calculated as the electronic energy difference between the geometry-optimized complex with Eu(II) in its first excited state and the corresponding geometry-optimized complex with Eu(III) which is singly positively charged with time-dependent DFT/ωB97X-D3 in the Tamm-Dancoff approximation using the def2-TZVP basis set and def2-ECPs 28-electron pseudopotential for Eu, the def2-SVP basis set, and if necessary def2-ECPs, for all other atoms, the geometrical Counter Poise correction for basis set incompleteness error, and the SMD solvation model with parameters for anisole, and
wherein HOMO and LUMO energies correspond to electron binding energy and electron affinity, respectively,
wherein the triplet energy of the second charge-neutral organic compound (b) is probed by suitable quantum mechanical calculations or by detecting the onset of the phosphorescence spectrum using gated spectroscopy,or is taken from the websites of material vendors or from the scientific literature by searching for the material using its name or synonym,
and wherein HOMO and LUMO of the second charge-neutral organic compound (b) are taken from the websites of material vendors or from the scientific literature by searching for the material using its name or synonym.

2. The electroluminescent device of claim 1, wherein the second organic compound (b) has a triplet energy higher than 2.6 eV, preferably higher than 2.7 eV, and more preferably higher than 2.8 eV.

3. The electroluminescent device of claim 1 or 2,wherein the second organic compound has an electron affinity higher than 2.3 eV, preferably higher than 2.5 eV, and more preferably higher than 2.7 eV.

4. The electroluminescent device of one of claims 1 to 3, comprising additionally a third charge-neutral organic material (c), wherein
the third charge-neutral organic material (c) is in physical contact with the organic layer comprising coordination compound (a) and second organic compound (b), with the energy difference between the HOMO of the second charge-neutral organic compound (b), and the LUMO of the third charge-neutral compound (c), and/or the energy difference between the HOMO of the third charge-neutral organic compound (c) and the LUMO of the second charge-neutral compound (b) are higher compared to the emission energy of the coordination compound (a) in its lowest electronically excited state, preferably
wherein said energy difference is higher than 2.6 eV, more preferably higher than 2.7 eV, and most preferably higher than 2.8 eV.

5. The electroluminescent device of claim 4,
wherein the third charge-neutral organic material (c) is a hole transporting material, while the second charge-neutral organic material (b) is either ambipolar or electron transporting.

6. The electroluminescent device according to one of claims 1 to 5, wherein the second charge-neutral organic compound (b) has a higher electron-binding-energy than the charge-neutral metal-organic coordination compound (a), preferably wherein the second charge-neutral organic compound (b) has an electron binding energy higher than 4.5 eV, more preferably higher than 5.1 eV, and most preferably higher than 5.7 eV.

7. The electroluminescent device according to claim 1 to 6, wherein
the coordination compound (a) is, preferably substantially homogeneously, imbedded into the at least one second charge-neutral organic compound (b) at 0.1 - 99.0 vol%, preferably at 1 - 90 vol%, and most preferably at 3 - 30 vol%, based on the organic layer which is 100 vol%.

8. The electroluminescent device according to one of claims 1 to 6, wherein the volume ratio of the coordination compound (a) to the at least one second charge-neutral organic compound (b) is, preferably substantially, non-uniform throughout the organic layer, preferably non-uniform along an axis perpendicular to the layer plane, thereby preferably forming two or more sublayers within the organic layer, one sublayer being primarily or totally composed of the coordination compound (a) and one sublayer being primarily or totally composed of the second charge-neutral organic compound (b), preferably wherein the partial layer thickness of the one or more sublayers comprising, preferably substantially, the metal organic coordination compound is 0.1 - 99.0 %, more preferably 1 - 90 %, and most preferably 3 - 30 %, based on the overall thickness of the organic layer, which is 100%.

9. The electroluminescent device according to one of claims 1 to 8, wherein the coordination compound (a) comprises at least one negatively charged anion that is not covalently linked to the macrocyclic organic ligand, and/or wherein the macrocyclic organic ligand, excluding the Europium cation, is at least singly, preferably twofold, negatively charged.

10. The electroluminescent device according to claim 9, wherein the at least one negatively charged anion is selected from a1 to a4: 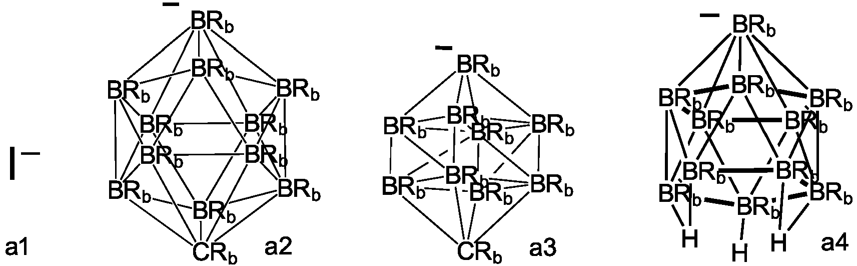 and/or wherein the ligand contains at least one, preferably two, covalently attached closocarborane fragments according to one of formulae (a5) to (a9): 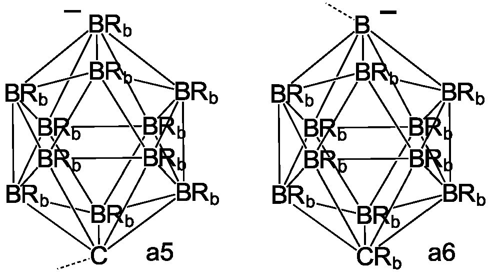 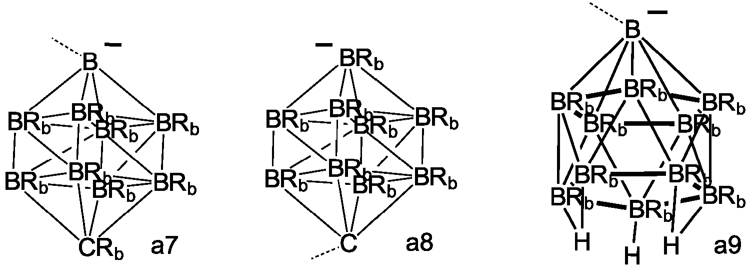 wherein
• the dashed line indicates the covalent linkage to the remainder of the organic macrocyclic ligand, and
• **R_{b}** present in a2 to a9 independently in each occurrence represents either hydrogen, deuterium, halogene, preferably chlorine, or an alkyl chain, preferably C₁₋₃⁻ alkyl, more preferably methyl.

11. The electroluminescent device according to one of claims 1 to 10, wherein the second charge-neutral compound (b) and/or third charge-neutral compound (c) comprises heteroarene fragments selected from benzene, pyridine, pyrrole, furan, carbazole, indolocarbazole, dibenzofuran, triazine, triazole, or benzofuran in its chemical structure.

12. The electroluminescent device according to one of claims 1 to 11, wherein the second charge-neutral compound (b) and/or third charge-neutral compound (c) is a host material capable of transporting electrons, holes or electrons and holes.

13. The electroluminescent device according to one of claims 1 to 12, wherein the macrocyclic organic ligand has the formula (1-1): 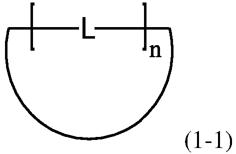 with
• **n** being 4 to 8, preferably 4 to 6; and
• **L** being independently in each occurrence a divalent organic group formed by removing two hydrogen atoms from an organic molecule having at least two hydrogens, with
• the shortest sequence of atoms in each L, linking each L with the remainder of the macrocyclic ligand, being 3 to 5, preferably 3 atoms, and with
• one of those 3 to 5, preferably 3 atoms independently for each L being selected from N, P, S, Se, or O, preferably N, S, Se, or O, wherein preferably **L** is independently in each occurrence selected from one of structures (2-1) to (2-5): 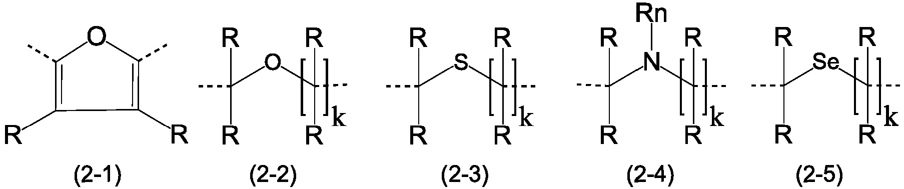 with
• **R** and **Rₙ** being H, D, halogen, or any monovalent organic group formed by removing a hydrogen atom from an organic molecule having at least one hydrogen, and
• **k** is independently in each occurrence 1 or 2 or 3, and
• two to four instances of **R** present on neighboring carbon atoms or carbon atoms separated by a heteroatom independently in each occurrence may fuse, and
• the dashed lines indicating the covalent linkage to the remainder of the macrocyclic ligand according to formula (1-1).

14. The electroluminescent device according to one of claims 1 to 13 with the macrocyclic organic ligand having one of generic formulae (3-1) to (3-3): 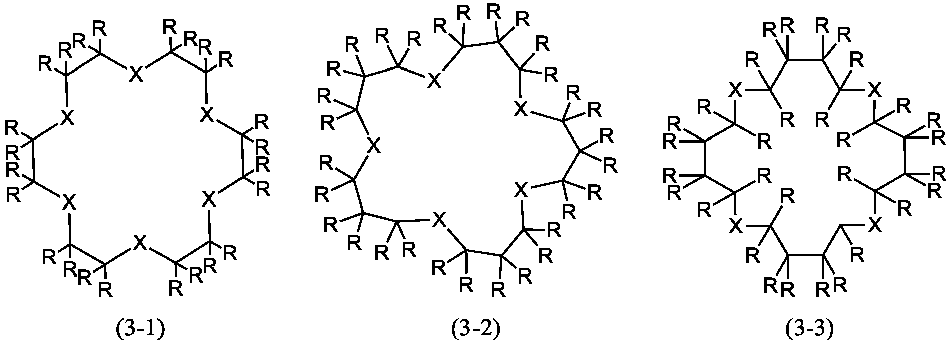 with
• **X** being selected from N-Rₙ, P, S, Se, or O, preferably N-Rₙ, S, Se, or O
• **R** and **Rₙ** being H, D, or any monovalent organic group formed by removing a hydrogen atom from an organic molecule having at least one hydrogen, being identical or different in each occurrence, and
• two or more instances of **R** present on neighboring carbon atoms and/or carbon atoms separated by one instance of **X** independently in each occurrence may fuse.

15. A method for producing the electroluminescent device according to one of claims 1 to 14, wherein the organic layer (106) or at least one of compounds (a), (b) and material (c) is deposited from a gas phase, preferably using an evaporation and/or sublimation and/or carrier gas process, or is deposited by deposition from solution, and the organic layer (106) or at least one of compounds (a), (b) and material (c) is deposited between the first electrode (104) and the second electrode (108).

## Patentansprüche

1. Organische Elektrolumineszenzvorrichtung umfassend:
eine erste Elektrode (104),
eine zweite Elektrode (108) und
eine organische Schicht (106), die zwischen der ersten Elektrode (104) und der zweiten Elektrode (108) angeordnet ist, wobei die organische Schicht (106) wenigstens eine ladungsneutrale metallorganische Koordinationsverbindung (a) umfasst, die ein zweiwertiges Europium umfasst, das von einem makrocyclischen organischen Liganden koordiniert ist,
wobei der makrocyclische organische Ligand aus 12 bis 48, vorzugsweise 15 bis 24 und höchst bevorzugt 18 bis 20 makrocyclischen Ringatomen gebildet ist, die Teil eines einzelnen cyclischen Rings, des Makrozyklus, sind, wobei nur jene Kohlenstoff- oder Heteroatome als makrocyclische Atome gezählt werden, die das cyclische geschlossene Ringsystem um das Eu(II) bilden,
wobei die organische Schicht (106) eine zweite organische Verbindung (b) umfasst, die ein ladungsneutrales Wirtsmaterial ist, wobei die Triplettenergie der zweiten ladungsneutralen organischen Verbindung (b) höher als die Emissionsenergie der Koordinationsverbindung (a) ist,
wobei die zweite ladungsneutrale organische Verbindung (b) eine Elektronenaffinität aufweist, die niedriger als die Elektronenbindungsenergie der Koordinationsverbindung (a) in ihrem niedrigsten elektronisch angeregten Zustand ist,
wobei Emissionsenergien der neutralen Koordinationsverbindung (a) berechnet werden durch Optimieren des niedrigsten elektronisch angeregten Zustands des niedrigsten Konformers aus 2D mit zeitabhängigem DFT/ωB97X-D3 in der Tamm-Dancoff-Näherung unter Verwendung des def2-TZVP-Basissatzes und des def2-ECPs 28-Elektronen-Pseudopotentials für Eu, des def2-SVP-Basissatzes und, falls erforderlich, def2-ECPs für alle anderen Atome, der geometrischen Counter-Poise-Korrektur für Basissatz-Unvollständigkeitsfehler und des SMD-Solvatisierungsmodells mit Parametern für Anisol,
wobei Elektronenbindungsenergien der neutralen Koordinationsverbindung (a) berechnet werden als die Differenz zwischen der elektronischen Energie des vollständig relaxierten Komplexes mit dem Grundzustand Eu(II) und der Energie des vollständig relaxierten Komplexes mit Eu(III), der einfach positiv geladen ist, mit zeitabhängigem DFT/ωB97X-D3 in der Tamm-Dancoff-Näherung unter Verwendung des def2-TZVP-Basissatzes und def2-ECPs 28-Elektronen-Pseudopotentials für Eu, des def2-SVP-Basissatzes und, falls erforderlich, def2-ECPs für alle anderen Atome, der geometrischen Counter-Poise-Korrektur für Basissatz-Unvollständigkeitsfehler und des SMD-Solvatisierungsmodells mit Parametern für Anisol,
wobei die Elektronenbindungsenergie von Eu(II) in der neutralen Koordinationsverbindung (a) in dem niedrigsten elektronisch angeregten Zustand berechnet wird als die Differenz der elektronischen Energie zwischen dem geometrieoptimierten Komplex mit Eu(II) in seinem ersten angeregten Zustand und dem entsprechenden geometrieoptimierten Komplex mit Eu(III), der einfach positiv geladen ist, mit zeitabhängigem DFT/ωB97X-D3 in der Tamm-Dancoff-Näherung unter Verwendung des def2-TZVP-Basissatzes und def2-ECPs 28-Elektronen-Pseudopotentials für Eu, des def2-SVP-Basissatzes und, falls erforderlich, def2-ECPs für alle anderen Atome, der geometrischen Counter-Poise-Korrektur für Basissatz-Unvollständigkeitsfehler und des SMD-Solvatisierungsmodells mit Parametern für Anisol, und
wobei HOMO- und LUMO-Energien Elektronenbindungsenergie bzw. Elektronenaffinität entsprechen,
wobei die Triplettenergie der zweiten ladungsneutralen organischen Verbindung (b) durch geeignete quantenmechanische Berechnungen oder durch Erfassen des Einsetzens des Phosphoreszenzspektrums unter Verwendung von Gating-Spektroskopie untersucht wird oder von den Websites von Materialanbietern oder aus der wissenschaftlichen Literatur durch Suchen nach dem Material unter Verwendung seines Namens oder Synonyms genommen wird,
und wobei HOMO und LUMO der zweiten ladungsneutralen organischen Verbindung (b) von den Websites von Materialhändlern oder aus der wissenschaftlichen Literatur durch Suchen nach dem Material unter Verwendung seines Namens oder Synonyms genommen werden.

2. Elektrolumineszenzvorrichtung nach Anspruch 1, wobei die zweite organische Verbindung (b) eine Triplettenergie von höher als 2,6 eV, vorzugsweise höher als 2,7 eV und bevorzugter höher als 2,8 eV aufweist.

3. Elektrolumineszenzvorrichtung nach Anspruch 1 oder 2, wobei die zweite organische Verbindung eine Elektronenaffinität von höher als 2,3 eV, vorzugsweise höher als 2,5 eV und bevorzugter höher als 2,7 eV aufweist.

4. Elektrolumineszenzvorrichtung nach einem der Ansprüche 1 bis 3, zusätzlich umfassend ein drittes ladungsneutrales organisches Material (c), wobei
das dritte ladungsneutrale organische Material (c) in physischem Kontakt mit der organischen Schicht steht, die die Koordinationsverbindung (a) und die zweite organische Verbindung (b) umfasst, wobei die Energiedifferenz zwischen dem HOMO der zweiten ladungsneutralen organischen Verbindung (b) und dem LUMO der dritten ladungsneutralen Verbindung (c) und/oder die Energiedifferenz zwischen dem HOMO der dritten ladungsneutralen organischen Verbindung (c) und dem LUMO der zweiten ladungsneutralen Verbindung (b) höher als die Emissionsenergie der Koordinationsverbindung (a) in ihrem niedrigsten elektronisch angeregten Zustand ist, vorzugsweise
wobei die Energiedifferenz höher als 2,6 eV, bevorzugter höher als 2,7 eV und höchst bevorzugt höher als 2,8 eV ist.

5. Elektrolumineszenzvorrichtung nach Anspruch 4, wobei das dritte ladungsneutrale organische Material (c) ein Lochtransportmaterial ist, während das zweite ladungsneutrale organische Material (b) entweder ambipolar oder elektronentransportierend ist.

6. Elektrolumineszenzvorrichtung nach einem der Ansprüche 1 bis 5, wobei die zweite ladungsneutrale organische Verbindung (b) eine höhere Elektronenbindungsenergie als die ladungsneutrale metallorganische Koordinationsverbindung (a) aufweist, wobei vorzugsweise die zweite ladungsneutrale organische Verbindung (b) eine Elektronenbindungsenergie von höher als 4,5 eV, bevorzugter höher als 5,1 eV und höchst bevorzugt höher als 5,7 eV aufweist.

7. Elektrolumineszenzvorrichtung nach Anspruch 1 bis 6, wobei
die Koordinationsverbindung (a) vorzugsweise im Wesentlichen homogen mit 0,1 - 99,0 Vol.-%, vorzugsweise 1 - 90 Vol.-% und höchst bevorzugt 3 - 30 Vol.-%, bezogen auf die organische Schicht, die 100 Vol.-% ist, in die wenigstens eine zweite ladungsneutrale organische Verbindung (b) eingebettet ist.

8. Elektrolumineszenzvorrichtung nach einem der Ansprüche 1 bis 6, wobei das Volumenverhältnis der Koordinationsverbindung (a) zu der wenigstens einen zweiten ladungsneutralen organischen Verbindung (b) in der gesamten organischen Schicht vorzugsweise wesentlich inhomogen ist, vorzugsweise entlang einer Achse senkrecht zu der Schichtebene inhomogen ist, wodurch vorzugsweise zwei oder mehr Teilschichten innerhalb der organischen Schicht gebildet werden, wobei eine Teilschicht hauptsächlich oder vollständig aus der Koordinationsverbindung (a) besteht und eine Teilschicht hauptsächlich oder vollständig aus der zweiten ladungsneutralen organischen Verbindung (b) besteht, wobei vorzugsweise die Teilschichtdicke der einen oder mehreren Teilschichten, die vorzugsweise im Wesentlichen die metallorganische Koordinationsverbindung enthalten, 0,1 - 99,0 %, bevorzugter 1 - 90 % und höchst bevorzugt 3 - 30 %, bezogen auf die Gesamtdicke der organischen Schicht, die 100 % ist, beträgt.

9. Elektrolumineszenzvorrichtung nach einem der Ansprüche 1 bis 8, wobei die Koordinationsverbindung (a) wenigstens ein negativ geladenes Anion umfasst, das nicht kovalent an den makrocyclischen organischen Liganden gebunden ist, und/oder wobei der makrocyclische organische Ligand, ausgenommen das Europium-Kation, wenigstens einfach, vorzugsweise zweifach, negativ geladen ist.

10. Elektrolumineszenzvorrichtung nach Anspruch 9, wobei das wenigstens eine negativ geladene Anion ausgewählt ist aus a1 bis a4: 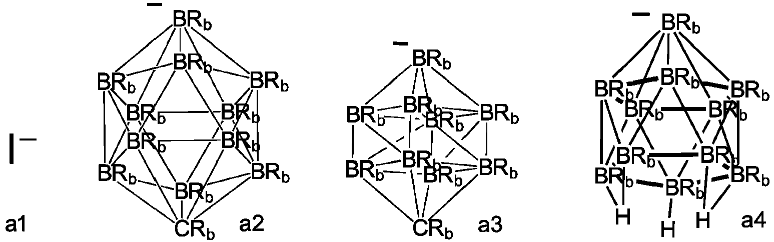 und/oder wobei der Ligand wenigstens ein, vorzugsweise zwei, kovalent gebundene Closocarboranfragmente gemäß einer der Formeln (a5) bis (a9) enthält: 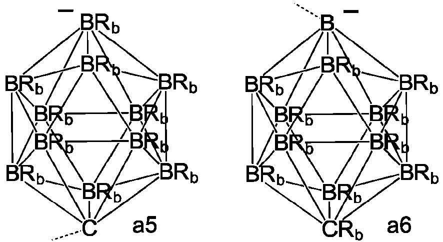 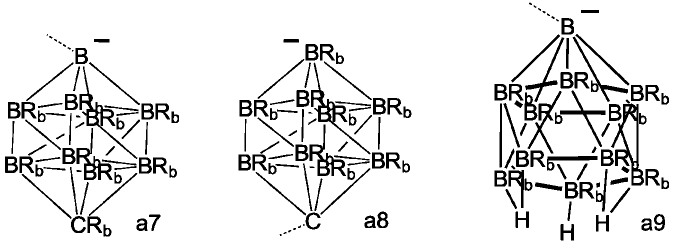 wobei
• die unterbrochene Linie die kovalente Bindung an den Rest des organischen makrocyclischen Liganden zeigt und
• R_{b}, vorhanden in a2 bis a9, unabhängig bei jedem Auftreten Wasserstoff, Deuterium, Halogen, vorzugsweise Chlor, oder eine Alkylkette, vorzugsweise C₁₋₃-Alkyl, bevorzugter Methyl, darstellt.

11. Elektrolumineszenzvorrichtung nach einem der Ansprüche 1 bis 10, wobei die zweite ladungsneutrale Verbindung (b) und/oder die dritte ladungsneutrale Verbindung (c) Heteroarenfragmente ausgewählt aus Benzol, Pyridin, Pyrrol, Furan, Carbazol, Indolocarbazol, Dibenzofuran, Triazin, Triazol oder Benzofuran in ihrer chemischen Struktur umfasst.

12. Elektrolumineszenzvorrichtung nach einem der Ansprüche 1 bis 11, wobei die zweite ladungsneutrale Verbindung (b) und/oder die dritte ladungsneutrale Verbindung (c) ein Wirtsmaterial ist, das fähig ist, Elektronen, Löcher oder Elektronen und Löcher zu transportieren.

13. Elektrolumineszenzvorrichtung nach einem der Ansprüche 1 bis 12, wobei der makrocyclische organische Ligand die Formel (1-1) aufweist: 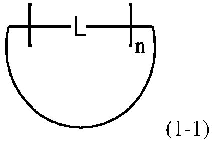 wobei
• n 4 bis 8 , vorzugsweise 4 bis 6, ist; und
• L unabhängig bei jedem Auftreten eine zweiwertige organische Gruppe ist, die durch Entfernen von zwei Wasserstoffatomen von einem organischen Molekül mit wenigstens zwei Wasserstoffatome gebildet ist, wobei
• die kürzeste Abfolge von Atomen in jedem L, die jedes L mit dem Rest des makrocyclischen Liganden verbindet, 3 bis 5, vorzugsweise 3, Atome ist, und wobei
• eines dieser 3 bis 5, vorzugsweise 3, Atome unabhängig für jedes L ausgewählt ist aus N, P, S, Se oder O, vorzugsweise N, S, Se oder O, wobei vorzugsweise L unabhängig bei jedem Auftreten ausgewählt ist aus einer der Strukturen (2-1) bis (2-5): 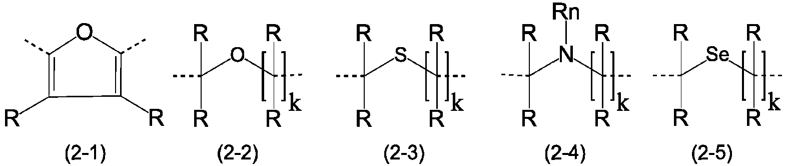 wobei
• R und Rₙ H, D, Halogen oder eine beliebige einwertige organische Gruppe sind, die durch Entfernen eines Wasserstoffatoms von einem organischen Molekül mit wenigstens einem Wasserstoff gebildet ist, und
• k unabhängig bei jedem Auftreten 1 oder 2 oder 3 ist, und
• zwei bis vier Fälle von R, die an benachbarten Kohlenstoffatomen oder Kohlenstoffatomen, die durch ein Heteroatom getrennt sind, vorliegen, unabhängig bei jedem Auftreten verschmolzen sein können, und
• die unterbrochenen Linien die kovalente Bindung an den Rest des makrocyclischen Liganden gemäß Formel (1-1) zeigen.

14. Elektrolumineszenzvorrichtung nach einem der Ansprüche 1 bis 13, wobei der makrocyclische organische Ligand eine der generischen Formeln (3-1) bis (3-3) aufweist: 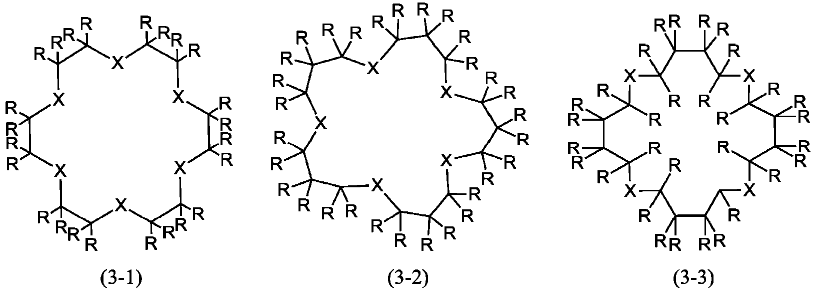 wobei
• X ausgewählt ist aus N-Rₙ, P, S, Se oder O, vorzugsweise N-Rₙ, S, Se oder O
• R und Rₙ bei jedem Auftreten gleich oder verschieden H, D oder eine beliebige einwertige organische Gruppe, die durch Entfernen eines Wasserstoffatoms von einem organischen Molekül mit wenigstens ein Wasserstoffatom gebildet ist, sind, und
• zwei oder mehr Fälle von R, die an benachbarten Kohlenstoffatomen und/oder Kohlenstoffatomen, die durch ein Auftreten von X getrennt sind, vorhanden sind, unabhängig bei jedem Auftreten verschmolzen sein können.

15. Verfahren zur Herstellung der Elektrolumineszenzvorrichtung nach einem der Ansprüche 1 bis 14, wobei die organische Schicht (106) oder wenigstens eine der Verbindungen (a), (b) und Material (c) aus einer Gasphase abgeschieden wird, vorzugsweise unter Verwendung eines Verdampfungs- und/oder Sublimations- und/oder Trägergasverfahrens, oder durch Abscheidung aus Lösung abgeschieden wird, und die organische Schicht (106) oder wenigstens eine der Verbindungen (a), (b) und Material (c) zwischen der ersten Elektrode (104) und der zweiten Elektrode (108) abgeschieden wird.

## Revendications

1. Dispositif électroluminescent organique comprenant :
une première électrode (104),
une deuxième électrode (108), et
une couche organique (106) disposée entre la première électrode (104) et la deuxième électrode (108), la couche organique (106) comprenant au moins un composé de coordination métal-organique à charge neutre (a) comprenant un Europium divalent coordonné par un ligand organique macrocyclique,
dans lequel le ligand organique macrocyclique est formé de 12 à 48, de préférence de 15 à 24, et le plus préférablement de 18 à 20 atomes de cycle macrocyclique qui font partie d'un cycle cyclique unique, le macrocycle, dans lequel seuls ces atomes de carbone ou hétéroatomes sont comptés comme atomes macrocycliques qui forment le système cyclique à cycle fermé autour de Eu(II),
dans lequel la couche organique (106) comprend un deuxième composé organique (b) qui est un matériau hôte à charge neutre, l'énergie triplet du deuxième composé organique à charge neutre (b) étant supérieure à l'énergie d'émission du composé de coordination (a),
dans lequel le deuxième composé organique à charge neutre (b) a une affinité électronique inférieure à l'énergie de liaison des électrons du composé de coordination (a) dans son état électroniquement excité le plus bas,
dans lequel les énergies d'émission du composé de coordination neutre (a) sont calculées en optimisant l'état électroniquement excité le plus bas du conformère le plus bas de 2D avec DFT/ωB97X-D3 dépendant du temps dans l'approximation de Tamm-Dancoff en utilisant l'ensemble de base def2-TZVP et le pseudopotentiel de 28 électrons def2-ECPs pour Eu, l'ensemble de base def2-SVP, et si nécessaire def2-ECPs, pour tous les autres atomes, la correction géométrique Counter Poise pour l'erreur d'incomplétude d'ensemble de base, et le modèle de solvatation SMD avec des paramètres pour l'anisole,
dans lequel les énergies de liaison des électrons du composé de coordination neutre (a) sont calculées comme la différence entre l'énergie électronique du complexe complètement détendu avec Eu(II) à l'état fondamental et l'énergie du complexe complètement détendu avec Eu(III) qui est chargé positivement de DFT/ωB97X-D3 dépendant du temps dans l'approximation de Tamm-Dancoff en utilisant l'ensemble de base def2-TZVP et le pseudopotentiel de 28 électrons def2-ECPs pour Eu, l'ensemble de base def2-SVP, et si nécessaire def2-ECPs, pour tous les autres atomes, la correction géométrique Counter Poise pour l'erreur d'incomplétude de l'ensemble de base, et le modèle de solvatation SMD avec des paramètres pour l'anisole,
dans lequel l'énergie de liaison des électrons de Eu(II) dans le composé de coordination neutre (a) dans l'état électroniquement excité le plus bas est calculée comme la différence d'énergie électronique entre le complexe optimisé pour la géométrie avec Eu(II) dans son premier état excité et le complexe optimisé pour la géométrie correspondant avec Eu(III) qui est chargé positivement de DFT/ωB97X-D3 dépendant du temps dans l'approximation de Tamm-Dancoff en utilisant l'ensemble de base def2-TZVP et le pseudopotentiel de 28 électrons def2-ECPs pour Eu, l'ensemble de base def2-SVP. et si nécessaire def2-ECPs, pour tous les autres atomes, la correction géométrique Counter Poise pour l'erreur d'incomplétude de l'ensemble de base, et le modèle de solvatation SMD avec des paramètres pour l'anisole, et
dans lequel les énergies HOMO et LUMO correspondent respectivement à l'énergie de liaison des électrons et à l'affinité électronique,
dans lequel l'énergie triplet du deuxième composé organique à charge neutre (b) est sondée par des calculs de mécanique quantique appropriés ou par détection de l'apparition du spectre de phosphorescence par spectroscopie à sélection, ou est extraite des sites Web de vendeurs de matériaux ou de la littérature scientifique en recherchant le matériau à l'aide de son nom ou synonyme,
et dans lequel HOMO et LUMO du deuxième composé organique à charge neutre (b) sont extraits des sites Web de vendeurs de matériaux ou de la littérature scientifique en recherchant le matériau à l'aide de son nom ou synonyme.

2. Dispositif électroluminescent selon la revendication 1, le deuxième composé organique (b) ayant une énergie triplet supérieure à 2,6 eV, de préférence supérieure à 2,7 eV, et plus préférablement supérieure à 2,8 eV.

3. Dispositif électroluminescent selon la revendication 1 ou 2, dans lequel le deuxième composé organique a une affinité électronique supérieure à 2,3 eV, de préférence supérieure à 2,5 eV, et plus préférablement supérieure à 2,7 eV.

4. Dispositif électroluminescent selon l'une des revendications 1 à 3, comprenant en outre un troisième matériau organique à charge neutre (c), dans lequel
le troisième matériau organique à charge neutre (c) est en contact physique avec la couche organique comprenant le composé de coordination (a) et le deuxième composé organique (b), la différence d'énergie entre l'HOMO du deuxième composé organique à charge neutre (b) et la LUMO du troisième composé à charge neutre (c), et/ou la différence d'énergie entre l'HOMO du troisième composé organique à charge neutre (c) et la LUMO du deuxième composé à charge neutre (b) est supérieure à l'énergie d'émission du composé de coordination (a) dans son état électroniquement excité le plus bas, de préférence
dans lequel ladite différence d'énergie est supérieure à 2,6 eV, plus préférablement supérieure à 2,7 eV, et le plus préférablement supérieure à 2,8 eV.

5. Dispositif électroluminescent selon la revendication 4,
dans lequel le troisième matériau organique à charge neutre (c) est un matériau de transport de trous, tandis que le deuxième matériau organique à charge neutre (b) est soit ambipolaire, soit transporte des électrons.

6. Dispositif électroluminescent selon l'une des revendications 1 à 5, dans lequel le deuxième composé organique à charge neutre (b) a une énergie de liaison d'électrons supérieure à celle du composé de coordination métal-organique à charge neutre (a), de préférence dans lequel le deuxième composé organique à charge neutre (b) a une énergie de liaison d'électrons supérieure à 4,5 eV, plus préférablement supérieure à 5,1 eV, et le plus préférablement supérieure à 5,7 eV.

7. Dispositif électroluminescent selon les revendications 1 à 6, dans lequel
le composé de coordination (a) est, de préférence de manière sensiblement homogène, incorporé dans l'au moins un deuxième composé organique à charge neutre (b) à raison de 0,1 à 99,0 % en volume, de préférence à raison de 1 à 90 % en volume, et le plus préférablement à raison de 3 à 30 % en volume, sur la base de la couche organique qui est de 100 % en volume.

8. Dispositif électroluminescent selon l'une des revendications 1 à 6, dans lequel le rapport volumique du composé de coordination (a) sur l'au moins un deuxième composé organique à charge neutre (b) est, de préférence sensiblement, non uniforme dans toute la couche organique, de préférence non uniforme le long d'un axe perpendiculaire au plan de la couche, formant ainsi de préférence deux sous-couches ou plus dans la couche organique, une sous-couche étant composée principalement ou totalement du composé de coordination (a) et une sous-couche étant composée principalement ou totalement du deuxième composé organique à charge neutre (b), de préférence dans lequel l'épaisseur de couche partielle de la ou des sous-couches comprenant, de préférence sensiblement, le composé de coordination métal-organique est de 0,1 à 99,0 %, plus préférablement de 1 à 90 %, et le plus préférablement de 3 à 30 %, sur la base de l'épaisseur totale de la couche organique, qui est de 100 %.

9. Dispositif électroluminescent selon l'une des revendications 1 à 8, dans lequel le composé de coordination (a) comprend au moins un anion chargé négativement qui n'est pas lié de manière covalente au ligand organique macrocyclique, et/ou dans lequel le ligand organique macrocyclique, à l'exclusion du cation Europium, est chargé négativement au moins une fois, de préférence deux fois.

10. Dispositif électroluminescent selon la revendication 9, dans lequel l'au moins un anion chargé négativement est choisi parmi a1 à a4 : 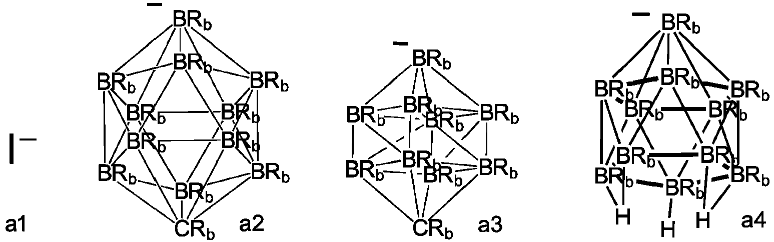 et/ou dans lequel le ligand contient au moins un, de préférence deux, fragments de closocarborane liés de manière covalente selon l'une des formules (a5) à (a9) : 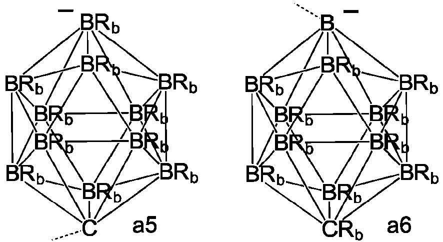 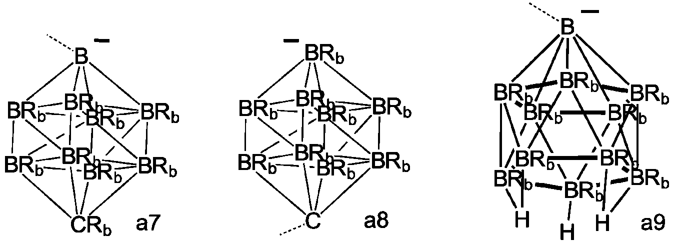 dans lesquelles
• la ligne en pointillé indique la liaison covalente avec le reste du ligand macrocyclique organique, et
• R_{b} présent dans a2 à a9 indépendamment en chaque occurrence représente soit hydrogène, deutérium, halogène, de préférence chlore, soit une chaîne alkyle, de préférence alkyle en C₁₋₃, plus préférablement méthyle.

11. Dispositif électroluminescent selon l'une des revendications 1 à 10, dans lequel le deuxième composé à charge neutre (b) et/ou le troisième composé à charge neutre (c) comprend des fragments hétéroarène choisis parmi benzène, pyridine, pyrrole, furane, carbazole, indolocarbazole, dibenzofurane, triazine, triazole, ou benzofurane dans sa structure chimique.

12. Dispositif électroluminescent selon l'une des revendications 1 à 11, dans lequel le deuxième composé à charge neutre (b) et/ou le troisième composé à charge neutre (c) est un matériau hôte capable de transporter des électrons, des trous ou des électrons et des trous.

13. Dispositif électroluminescent selon l'une des revendications 1 à 12, dans lequel le ligand organique macrocyclique a la formule (1-1) : 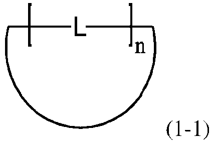
• n étant 4 à 8 ; de préférence 4 à 6 ; et
• L étant indépendamment en chaque occurrence un groupe organique divalent formé par élimination de deux atomes d'hydrogène d'une molécule organique ayant au moins deux atomes d'hydrogène,
• la séquence d'atomes la plus courte dans chaque L, liant chaque L au reste du ligand macrocyclique, étant de 3 à 5, de préférence 3 atomes, et
• un de ces 3 à 5, de préférence 3 atomes indépendamment pour chaque L étant choisi parmi N, P, S, Se ou O, de préférence N, S, Se, ou O, dans lequel de préférence L est indépendamment en chaque occurrence choisi parmi l'une des structures (2-1) à (2-5) : 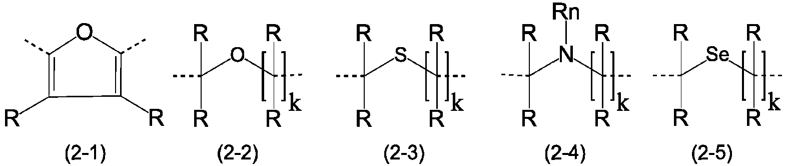
• R et Rₙ étant H, D, halogène, ou un quelconque groupe organique monovalent formé par élimination d'un atome d'hydrogène d'une molécule organique ayant au moins un hydrogène, et
• k étant indépendamment en chaque occurrence 1 ou 2 ou 3, et
• deux à quatre instances de R présents sur des atomes de carbone voisins ou des atomes de carbone séparés par un hétéroatome indépendamment en chaque occurrence pouvant fusionner, et
• les lignes pointillées indiquant la liaison covalente au reste du ligand macrocyclique selon la formule (1-1).

14. Dispositif électroluminescent selon l'une des revendications 1 à 13, dans lequel le ligand organique macrocyclique a l'une des formules génériques (3-1) à (3-3) : 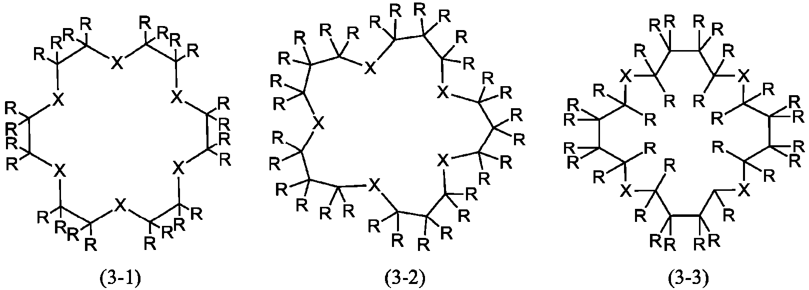
• X étant choisi parmi N-Rₙ, P, S, Se ou O, de préférence N-Rₙ, S, Se ou O
• R et Rₙ étant H, D, ou un quelconque groupe organique monovalent formé par élimination d'un atome d'hydrogène d'une molécule organique ayant au moins un hydrogène, qui est identique ou différent en chaque occurrence, et
• deux instances ou plus de R présents sur des atomes de carbone voisins et/ou des atomes de carbone séparés par une instance de X indépendamment en chaque occurrence pouvant fusionner.

15. Procédé pour la production du dispositif électroluminescent selon l'une des revendications 1 à 14, dans lequel la couche organique (106) ou au moins l'un des composés (a), (b) et du matériau (c) est déposée à partir d'une phase gazeuse, de préférence en utilisant un procédé d'évaporation et/ou de sublimation et/ou de gaz porteur, ou est déposée par dépôt à partir d'une solution, et la couche organique (106) ou au moins l'un des composés (a), (b) et du matériau (c) est déposée entre la première électrode (104) et la deuxième électrode (108).
